(19) Europäisches Patentamt / European Patent Office / Office européen des brevets

(11) **EP 2 323 170 A1**

(12) **EUROPEAN PATENT APPLICATION**
published in accordance with Art. 153(4) EPC

(43) Date of publication:
**18.05.2011 Bulletin 2011/20**

(51) Int Cl.:
***H01L 31/04*** *(2006.01)*

(21) Application number: **08874414.9**

(22) Date of filing: **20.05.2008**

(86) International application number:
**PCT/RU2008/000314**

(87) International publication number:
**WO 2009/142529 (26.11.2009 Gazette 2009/48)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Tsoi, Bronya**
**Moscow, 117342 (RU)**

(72) Inventors:
• **BUDISHEVSKY, Jury Dmitrievich**
**Bryansk 241047 (RU)**

• **TSOI, Valeryan Eduardovich**
**Moskovskaya obl. 142000 (RU)**
• **TSOI, Tatyana Sergeevna**
**Moscow 117418 (RU)**

(74) Representative: **Nübold, Henrik**
**Lemcke, Brommer & Partner**
**Patentanwälte**
**Bismarckstrasse 16**
**76133 Karlsruhe (DE)**

(54) **ELECTROMAGNETIC RADIATION CONVERTER AND A BATTERY**

(57) The invention relates to semiconductor electronics and can be used for producing high-efficient broadband electromagnetic radiation converters for directly converting incident radiation into electromotive force in both, the optically visible and optically invisible ranges. The inventive electromagnetic radiation converter comprises a semiconductor substrate with N = 1 discrete local domains of a first conductivity type formed thereon, and since said substrate is of a second conductivity type, the above-mentioned domains of a first conductivity type form together with the substrate N = 1 p-n junctions combined into a current node. Furthermore, isotype junctions generating repulsive isotype barriers to the minority charge carriers are formed on the face side of the substrate beyond the domains of a first conductivity type. The inventive design of the converter enables it to operate in a broader electromagnetic radiation frequency range, thereby promoting the increase in the performance factor and power thereof in comparison with converters known in the prior art, and to achieve the high accuracy and stability on the output characteristics thereof. Batteries formed of the converters of said type are also disclosed,

EP 2 323 170 A1

**Description**

TECHNICAL FIELD

The invention relates to broad-band electromagnetic radiation (EMR) converters, as well as batteries and modules on the basis thereof, for directly converting incident radiation into electromotive force (EMF) both within optically visible and invisible, IR, UV, X-ray and upper frequency band.

DESCRIPTION OF THE PRIOR ART

The currently known semiconductor-based photoelectric converters (PEC) (see, for example, Alferov Zh.I., Andreev V.M., Rumyantsev V.D. development Trends and Prospects of Solar Power Engineering. // Semiconductor Physics and Technology, 2004, Vol. 38, Issue 8, PP 937-948; Meitin M. / Photovoltaics: Materials, Technologies, Prospects // Electronics: Science, Technology, Business, 2000, No.6, PP 40-46; Konstantinov P.B., Kontsevoy Yu.A., Maksimov Yu.A., Silicon Solar Cells, Moscow, MIREA Publishers, 2005, 70 PP) are able to convert a narrow spectral band of the solar EMR. It comprises the visible frequency band ($10^{14}$-$10^{15}$ Hz) including a limited share of the IR frequency band (slightly below $10^{14}$ Hz) and of the UV frequency band (slightly above $10^{15}$ Hz), which reach the earth surface during the daylight time under good meteorological conditions (Alferov Zh.I., Andreev V.M., Rumyantsev V.D. development Trends and Prospects of Solar Power Engineering. //Semiconductor Physics and Technology, 2004, Vol. 38, Issue 8, PP 937-948). Therefore, a considerable share of the EMR reaching the earth surface is left out of the conversion range.

At the same time, the long-wavelength, i.e., IR part of the solar EMR spectrum (below $10^{14}$ Hz) constitutes a considerable share reaching 43.5%. Therefore, the EMR IR part is of particular interest to the world solar power engineering because a considerable share of the IR spectrum with the wavelengths of up to 4 $\mu$m in the form of radiant energy freely reaches the earth surface without losses. Converters based on the thermoelectric effects discovered by Seebeck in 1821 have been used in the prior art to convert the IR spectrum.

The short-wavelength part of the EMR spectrum, in particular the UV radiation, despite its small share in the solar spectrum (about 5 %), is of not less interest due to a high value of the energy of photons. While the energy of photons within the visible-light spectrum reaches 3.3 eV, it is of 3.3 to 120 eV in the UV domain, and photons with the energy of 3.3 to 5.5 eV (to which the earth's ozone layer being no hindrance) easily reach the earth surface. Therefore, the short-wavelength part, in particular for such semiconductors as silicon having one of its spectral absorption maximums within the shortwave domain, is of a considerable interest both to the space-based and terrestrial SC structures.

The limitation of all current converters both based on photovoltaic effects and on thermoelectric effects consists in their low efficiency. The currently available conversion efficiency for PEC made from amorphous silicon is 5-6%, 12-15% for PEC made from single-crystalline silicon, 20-24% for PEC made from gallium arsenide, and 36% for multistage converters. In addition, the cost of the latter ones differs more than by an order of magnitude. The efficiency of the converters based on thermoelectric effects is also low being of 3-5%. The main reasons limiting the efficiency of the semiconductor solar cell are the following (Alferov Zh.I., Andreev V.M., Rumyantsev V.D. development Trends and Prospects of Solar Power Engineering. //Semiconductor Physics and Technology, 2004, Vol. 38, Issue 8, PP 937-948; Meitin M, / Phatovoltaics; Materials, Technologies, Prospects // Electronics: Science, Technology, Business, 2000, No. 6, PP 40-46; Konstantinov P.B., Kontsevoy Yu.A., Maksimov Yu.A., Silicon Solar Cells, Moscow, MIREA Publishers, 2005, 70 PP):

1) EMR reflection from the converter surface;
2) transmission of a part of EMR through the converter without being absorbed therein;
3) scattering of the excess energy of EMR photons due to lattice-thermal vibration;
4) surface and bulk recombination of the generated EHP in the converter;
5) internal resistance of the converter.

A solar cell or PEC is formed on a wafer (substrate) made from a semiconductor material, for example, silicon.

In a wafer with a particular conductivity type (i.e., p- or n-type), an electron-hole junction is created by means of doping with a dopant to ensure formation of a surface layer with an opposite conductivity type. The concentration of the dopant in this layer has to be far in excess of its concentration in the basic (initial) material in order that the main free charge carriers available therein are neutralized and an opposite conductivity type is created.

Thereafter, lower and upper electrical contacts are manufactured with the lower contact to the shaded surface being typically continuous, whereas the upper contact to the exposed surface being formed as a comb structure (strips with a width of 100-250 $\mu$m spaced at 2000-3000 $\mu$m from each other on the basis of 5-10% shading of the converter exposed surface and connected by a relatively wider bus). The contact of p- and n-type semiconductors results in generation of the contact electric field between the same, being of primary importance to the operation of the solar cell.

In order to create the repulsive field and to improve the ohmic contact, the wafer surface is further subdoped on the shaded surface.

When combined into a single monocrystal, p- and n-type semiconductors cause a diffusion flow of electrons from the n-type semiconductor to the p-type semiconductor and, on the contrary, a flow of holes from the p-type semiconductor to the n-type semiconductor. As a result of such process, the p-type semiconductor part adjacent to the p-n junction will have a negative charge and, on the contrary, the n-type semiconductor part adjacent to the p-n junction will have a positive charge. Therefore, in the vicinity of the p-n junction, a double charged layer is formed which counteracts the process of diffusion of electrons and holes. In fact, diffusion tends to create a flow of electrons from the n-domain to the p-domain while the charged layer field, on the contrary, tends to bring electrons back to the n-domain. In the same manner, the field in p-n junction counteracts diffusion of holes from the p-domain to the n-domain. As a result, an equilibrium state is established: a potential barrier is formed in the domain of the p-n junction, to overcome which the electrons from the n-semiconductor and the holes from the p-semiconductor have to consume some energy.

As noted above, conventional continuous single-junction converters are formed on the p- or n-conductivity type semiconductor. Due to the prevailing diffuse component of current and differences in the mobility of electrons $e^-$ and that of holes $h^+$, preference is given to the p-type silicon substrates wherein the mobility of the minority charge carriers (MCC), i.e. electrons is three times higher than that of the holes. Further discussions will be true for any p- or n-conductivity type semiconductor (Ge, Si, GaAs, etc.), however, p-conductivity type silicon is usually preferred in the disclosed design due to the differences in the mobility of $h^+$ and $e^-$. For simplicity of discussion of the inventive converter embodiments, n-conductivity type is conventionally referred to as a first conductivity type, and p-conductivity type as a second conductivity type (accordingly, a first conductivity type domain and a second conductivity type domain).

In a conventional single junction $n^+p^-p^+$-type structure under thermodynamic equilibrium, a PEC or SC comprises a common p-n junction with its intrinsic properties. Due to diffusion of the majority charge carriers from the $n^+$ and $p^+$ domains, a space-charge domain (SCR) is left at the their interface and an electric field with intensity E is generated, whose force F=qE prevents the diffusion migration of the holes $h^+$ from $p^-$ to n-domain and of the electrons $e^-$ from n- to p-domain. These competing processes result in the contact potential difference $\varphi_c$ being the more, the more differ the doping levels of p- and n-domains. For most of silicon-based p-n junctions, $\varphi_c$ is 0.5 to 0.9 V, which is quiet sufficient for making high-performance SC. However, the higher the contact potential difference, the more it obstructs the diffusion current through the p-n junction, since the non-equilibrium minority charge carriers (NeCC) have to overcome a higher potential barrier (PB), i.e., the NeCC whose energy is less than that of the PB will be unable to overcome the same and will uselessly recombine within the semiconductor bulk.

The lifetime of the $h^+$ NeCC in the $n^+$ layer is negligibly small, highly dependent on the diffusion conditions and decreases due to dislocations being formed and discharge of excessive phosphorous in the form of SiP-precipitates. The $n^+$ layer in the vicinity of the surface with a high content of SiP-precipitates is usually referred to as a dead layer since this domain is electrically inactive, i.e., no phosphorous is present in the points of silicon lattice. However, this layer is not exactly electrically inactive: on the one hand, this is due to a small lifetime of the $h^+$; besides, due to scattering on the precipitates, the diffusion rate of the $h^+$ slows down such that the NeCC, in this case $n^+$ formed at the expense of absorption of the most active "blue" spectrum band are not involved in the photoelectric current, i.e., the $n^+$ layer serves to cut off the high-frequency component of the electromagnetic radiation spectrum (Reivi K., Defects and Dopants in Semiconducting Silicon, Moscow, Mir Publishers, 1984, 470 PP). A high content of the free majority charge carriers, i.e., electrons in the $n^+$ layer substantially alters the reflectivity of silicon: the higher the doping level, the higher the reflection index (Zaveryuikhin B.N., Zaveryuikhina N.N., Tursunkulov O.M. / Changes in the Reflection Factor of Radiation from the Semiconductor Surface within the Spectral Range of $\lambda = 0.2$-20 $\mu$m under the Influence of Ultrasonic Waves //Letters to the Journal of Applied Physics, 2002, Vol. 28, Issue 18, PP 1-12).

That is, a high content of electrons in the $n^+$ layer is a reason for cutting off a considerable part of the EMR short-wave spectrum. Therefore, this layer is made as thin as possible to improve the PEC efficiency, which in turn may increase the PEC internal resistance. In other words, competing processes which in principle limit the efficiency of the prior art PEC are inherently designed in the very structure thereof.

Various techniques are known in the patent literature for eliminating these factors limiting the efficiency.

By means of rather sophisticated and complicated techniques the efficiency of the silicon solar cells of up to 25% was achieved (Green M.A et al., 25% Efficient Low-Resistivity Si Concentrator Solar Cells. IEE Electron Device Letters. 1986, PP. 583-585.).

When designing and manufacturing the homogeneous SC, special emphasis is placed on optimizing the collecting $n^+$ layer.

A method is known for optimizing the $n^+$ layer parameters [Konstantinov P.B., Kontsevoy Yu.A., Maksimov Yu.A., Silicon Solar Cells, Moscow, MIREA Publishers, 2005, 70 PP]. This layer is made thin and with a low doping level as it is rather difficult to avoid SiP precipitates by diffusion and to ensure an optimum doping level. Incorporation of phosphorous by means of ion-implantation doping makes it possible to overcome said obstacle, however, the disturbances occurring in silicon as this happens notably decrease the lifetime of the $e^-$ NeCC in the $p^-$ layer thereby limiting the long-wave red spectral region. However, the occurrence depth and the doping level of the n+ layer cannot be reduced to ultrasmall values since otherwise the so called "sheet" resistance (spreading resistance) and, hence, the SC series resistance would increase.

JP 3206350 B2, 26.01.1995 discloses a method for increasing the contact voltage drop $\varphi_c$ by means of forming a p+ layer under the n-layer, wherein a SC is provided having the p+ layer formed under the n-layer for increasing the voltage drop, i.e, the open-circuit voltage. Although according to the calculations such structural design may contribute to improving the efficiency, this improvement is insignificant. The calculated values of $\varphi_c$ for the doping concentrations of acceptable in terms of the reflective properties of Si are: $\varphi_c = 0.73$ V for $N_{Si}\text{-}n^+ = 10^{19}$ and $N_{Si-p}+ = 10^{18}$; $\varphi_c = 0.53$ V for $N_{Si}\text{-}n^+ = 10^{19}$ and $N_{Si-p}+ = 10^{15}$ corresponding to p-Si conductivity p = 10 Ohm cm.

In fact, this difference will turn to be less due to generation-recombination processes at the interface of the highly doped domains.

A method is known for reducing recombination (RU 2139601 C1, 04.12.1998) by means of increasing the MCC lifetime in thermal processes, wherein boron and phosphorous are caused to simultaneously diffuse from the applied sources (gettering); front surface is textured; a shallow n+ collecting domain is created; the efficiency is achieved of up to 16.6%.

A method is known for improving efficiency at the expense of reducing the converter series resistance by means of providing an embedded n++ layer under the collecting layer (Goodrich J., Chaple-Sokol., Allendore G., Frank R., The etched multiple vertical junction silicon photovoltaic cell //Solar Cells. 1982. Vol. 6, N 1. P. 87-101]; the inventors succeeded in achieving the efficiency of 18.5%.

A technique is known for reducing the surface recombination losses by implementing a "point contact" type metallization pattern (Aberie A.G., Altermatt P.P., Heizer G, Robinson S.J., Limiting loss mechanisms in 23% efficient silicon solar cells /J. Appl. Phys. 1995. Vol. 77, N 7. P/ 3491), achieving the efficiency of 23%.

A method is known for improving efficiency (DE 10127382 AI, 06.06.2001) by reducing the optical losses using the method of photolithographic surface texturing, wherein band silicon with a high MCC lifetime and high quality thermal oxide is used; the efficiency of up to 23-25% is achieved.

Also, a method is known for reducing the optical losses by coating the exposed surface with antireflective or antireflection coatings based on $Si_3N_4$, $TiO_2$ or other films with the refraction index exceeding 1.8 (Alferov Zh.I, Andreev V.M., Rumyantsev V.D. development Trends and Prospects of Solar Power Engineering. // Semiconductor Physics and Technology, 2004, Vol. 38, Issue 8, PP 937-948; Meitin M. / Photovoltaics: Materials, Technologies, Prospects // Electronics: Science, Technology, Business, 2000, No. 6, PP 40-46) or using a transparent current-conducting TCO or ITO layer (being at the same time an antireflective coating) and using a wire grid system under the laminate layer (Untila G.G., Kost T.N., Zaks M.B., et al. /A New Type of High-Performance Double-Sided Silicon Solar Cells with Front-Side buses and a Wire Grid // Semiconductor Physics and Technology, 2005, Vol. 39, Issue 11, PP. 1393-1398), achieving the efficiency of 17.7%.

Reducing the optical losses at the expense of antireflection coatings is a well proved technique. It succeeds to eliminate practically in full the reflection of incident light. However, this does not lead to a substantial improvement in conversion of the EMR having penetrated inside, and the efficiency improves a few percent at best.

A converter with vertical grooves is known, said converter having a continuous n+ domain, requiting a high MCC lifetime to ensure good performance within the "blue" domain since the non-equilibrium electrons have to travel over a long distance to reach the n+ layer and having as its main drawbacks a complicated manufacturing technique and a high cost [Goodrich J., Chaple-Sokol., Allendore G., Frank R., The etched multiple vertical junction silicon photovoltaic cell //Solar Cells. 1982. Vol, 6, N 1. P. 87-101]; the achieved efficiency amounts to 18.5%.

A converter is known (US 6,998,288 B1, 14.02.2006) provided with a front side reflective repulsive layer and rear side (shaded) comb contact system, whose efficiency reaches 20%. In this case, no doped front side layer is involved in the current collection by the NeCC, i.e. in the cell internal resistance so that it may be provided thin and moderately doped. Such systems are easy to implement technically, however this is associated with a number of conditions: an expensive basic material, i.e. zone-melted silicon which should meet a number of strict requirements (high lifetime and high homogeneity). That is, all techniques should be applied in order to preserve the NeCC lifetime otherwise the efficiency within the short-wave spectral region would be lost since, given small diffusion lengths, bulk recombination of the NeCC having been formed would occur before reaching by the same the current-collecting electrodes so that the basic semiconductor thickness will have to be reduced which, in turn will result in a loss within the long-wave spectral region.

Finally, multistage converters are known (Alferov Zh.I, Andreev V.M., Rumyantsev V.D. development Trends and Prospects of Solar Power Engineering. // Semiconductor Physics and Technology, 2004, Vol. 38, Issue 8, PP 937-948; Meitin M. / Photovoltaics: Materials, Technologies, Prospects // Electronics: Science, Technology, Business, 2000, No. 6, PP 40-46), whose efficiency reaches 36%. As noted above, most of SCs are based on single-junction devices. In a single-junction cell, free charge carriers are generated only by the photons the energy of which exceeds or equal to the forbidden band width (FBW). The photoelectric response of such SC is limited by the solar spectrum band whose energy is exceeds the FBW, whereas lower energy photons are not used. This limitation can be overcome using multilayer structures consisting of two and more SC with different FBW. Such cells are referred to as multistage or multijunction cells. Their main drawbacks consist in a complicated manufacturing technique and high cost given the current state of the art. However, researchers (Alferov Zh.I, Andreev V.M., Rumyantsev V.D. /Development Trends and Prospects of Solar Power Engineering. //Semiconductor Physics and Technology, 2004, Vol. 38, Issue 8, PP 937-948; Meitin M, / Photovoltaics: Materials, Technologies, Prospects // Electronics: Science, Technology, Business, 2000, No. 6, PP 40-46) predict a great future for multistage converters.

It should be noted that all prior art converter configurations have a feature in common: a relatively large-area continuous (integral solid) collecting $n^+$ layer limiting their efficiency due to a high sheet resistance. In addition, the current which all converter generate comprises the diffuse component of the total current.

A low efficiency results in a high cost of the electric energy produced using such converters. In theory, their efficiency level, except for multistage converters, cannot exceed 25% of the absorbed energy. At the same time, the highest-energy UV and upper spectral region, as well as the long-wavelength IR spectral region of the EMR are left out of conversion. Meanwhile, conversion of the UF and upper solar spectral region, in particular as applied to hard UV and roentgen radiation constitutes the main solution to the power scarcity of spacecrafts; and conversion of the low frequencies (LF) of the long-wave EMR range might provide the solution to the world energy demand, and in general, broadening of the convertible frequency spectrum would lead to a cardinal cost reduction of the "alternative" electric energy.

Today, the world market cost of one watt of the "alternative" electric energy (i.e. produced by conversion of the EMR) is 6-7 USD. However, about a half of this cost is accounted for the cost of silicon. At present, only a few countries such as Germany, Japan, USA, can afford large-scale development of the alternative solar power engineering. It is believed that if one watt of the produced "alternative" electric energy costs becomes less than 3 USD, and the efficiency exceeds 25%, a worldwide breakthrough will be achieved in the solar power engineering. Therefore, the efficiency of the prior art PEC is limited, on the one hand by the narrow range of the incident EMR conversion spectrum and, on the other hand, by the low-efficiency technique for conversion of the EMR penetrating inside the converter, i.e., low internal conversion factor associated mainly with recombination processes and a high internal resistance of the cell.

## SUMMARY OF THE INVENTION

In view of the above mentioned drawbacks associated with the prior art solutions, it is an object of the invention to provide high-performance broad-band converters having a high internal conversion factor of the EMR, able to operate in a wide range of frequencies (from IR to UV and upper) and intensities of the incident EMR.

Such converters should also have a higher efficiency and power than those known in the prior art, should provide a high accuracy and stability of the output electrical performance, and should be able to operate under conditions of considerable changes in temperature and radiation. Moreover, these converters should be both technically and cost efficient, relatively inexpensive and adaptable to the current state of the semiconductor production. At the same time, as little as possible semiconducting material should be consumed for making these converters.

According to a first aspect of the invention, said object is achieved by providing an electromagnetic radiation converter comprising a semiconductor substrate having N > 1 discrete local first conductivity type domains arranged on the front side thereof, said substrate having a second conductivity type so that said first conductivity type domains form, together with the substrate, N > 1 p-n junctions combined into a current node, with the isotype junctions serving as repulsive isotype barriers to the minority charge carriers being formed on the substrate front side outside said first conductivity type domains.

In a particular case, the substrate front side may be at least partially textured.

In a particular case, an antireflection coating may be applied onto the substrate front side. In a particular case, local centers for absorbing the electromagnetic radiation and injecting the non-equilibrium charge carriers are embedded into the substrate in order to create concentration gradients of the non-equilibrium charge carriers.

In a particular case, doped depressed isotype deflecting domains are formed on the substrate front side outside the first conductivity type domains for creating a concentration gradient of the non-equilibrium charge carriers relative to the second conductivity type domain or domains.

The first conductivity type domains are preferably spaced apart at intervals commensurable to the diffusion length of the non-equilibrium charge carriers.

In a particular case, the rear side of the substrate may comprise doped depressed discrete second conductivity type collecting domains which, together with the substrate material, form local isotype junctions combined into a rear opposite current node through local contacts and a rear conducting electrode.

In a particular case, the substrate may comprise on the rear side thereof N > 1 discrete local first conductivity type collecting domains and N discrete p-n junctions combined into a second rear current node by a second current collecting electrode.

In a particular case, on the substrate front side a dielectric layer is provided with windows arranged at least in the areas of N discrete local first conductivity type domains to ensure the contact of the first electrode with said domains.

In a particular case, N > 1 and said N first conductivity type domains on the substrate front side are configured as separate and single-type to form N separate and single-type p-n junctions. In a particular case, N=1 and the first conductivity type domain on the substrate front side may comprise K ≥1, where is an integer number, of the first conductivity type portions connected to each other through M ≥ 1 first conductivity type connection elements. In a particular case, M =1, i.e., said first conductivity type domain comprises a singe doped first conductivity type connection element in the form of a single continuous rectangular strip.

In another particular case, said first conductivity type domain may comprise M > 1 doped first conductivity type connection portions in the form of separate single-type thin rectangular strips. Said first conductivity type domain may comprise M > 1 doped first conductivity type connection portions arranged into a grid.

In a particular case, the p-n junctions with the collecting domains adjacent thereto are provided on the lateral and front surfaces of the front side.

In a particular case, a second conductivity type doped layer is provided under each ofN first conductivity type domains on the substrate front side,

In a particular case, a stack of G > 1 successively alternating second conductivity type and first conductivity type layers are provided under each of said first conductivity type domains on the substrate front side. At the same time, the first and second conductivity type domains in said stack may be switched (connected) in series or in parallel, in particular by means of the doped connection elements of the same conductivity type. At the same time, a part or all of said connection elements may form closed circuits.

In a particular case, X ≥1 additional doped deflecting domains separate from said N first conductivity type collecting domains are provided on the substrate front side. Each of said X doped deflecting domains may have the second conductivity type, X deflecting domains may include domains both of first and second conductivity types, or each of said X doped deflecting domains has the first conductivity type. Said doped deflecting domains are preferably configured as discrete, however, at least a part of the doped deflecting domains of the same conductivity type may be combined into circuits by connection portions of the same conductivity type. At least one ofN first conductivity type collecting domains on the substrate front side may be arranged in the circuit formed by the deflecting domains.

In particular, said X doped deflecting domains may be configured as a continuous closed circuit (ring or belt) and at least one of N collecting may be arranged inside said continuous closed circuit.

In a particular case, N collecting doped first conductivity type domains on the substrate front side and doped deflecting domains are arranged into alternating discrete quantum trapping depressions spaced from each other at F ≤ 2f, where f is a diffusion length of the non-equilibrium charge carriers, said traps being formed on the substrate front side of the first conductivity type collecting domains disposed in some depressions and the deflecting domains - in other depressions along the depressions of the first conductivity type at a distance ofF from the nearest depression.

In a particular case, the converter further comprises an additional third (or a second front-side) current collecting electrode connected to each or at least one of said X doped second conductivity type deflecting domains.

In a particular case, at least one deflecting field electrode is placed on top of the dielectric layer. At the same time, X ≥1 additional doped deflecting domains separate from said N first conductivity type collecting domains are provided on the substrate front side, and at least one deflecting field electrode may be arranged on top of the dielectric layer in the area of at least one of said X doped deflecting domains.

A first collecting electrode connected to each of N first conductivity type domains may be extended and may overlap in plan view each individually taken said first conductivity type domain to which it is connected, and said first electrode may be connected to the deflecting field electrode to form thereby a single extended collecting-deflecting electrode.

Said extended collecting-deflecting electrode is preferably but not necessarily made from optically transparent (or semitransparent) conducting material (for example, Si*, TCO, ITO).

Said extended collecting-deflecting field electrode may also be made from an optically transparent (or semitransparent) conducting material (for example, Si*, TCO, ITO) to extend continuously throughout the front side.

In a particular case, the first electrode may be arranged along the perimeter of each of N current collection domains on the front side and the deflecting domains may be arranged along the perimeter of the first electrode.

In still another particular case, a third electrode (or a first drift electrode on the front side) is formed outside the collecting-deflecting electrode along its perimeter for generating a drift field on application of a bias potential. First conductivity type deflecting domains may be arranged under the drift electrode. Also, a field drift electrode (a second drift electrode on the front side) is formed between the first and drift electrodes above the second conductivity type deflecting domains. At the same time, the second drift electrode on the front side is preferably electrically connected to substrate.

In a particular case, Y ≥1 thin electrodes are arranged on the front side and combined into a current node current node, and the electrode spacing is commensurable to the diffusion length of the non-equilibrium charge carriers.

In a particular case, the first conductivity type domains on the front side and the second conductivity type domains on the front side may be coated with microlenses or microprisms.

In a particular case, the reverse side of the second conductivity type substrate comprises $W \geq 1$ separate second conductivity type doped deflecting-collecting domains combined into a current node by means of the continuous second electrode. Said separate $W \geq 1$ doped deflecting-collecting domains are preferably configured as single-type,

The reverse side may also comprise $V \geq 1$ first conductivity type doped deflecting-collecting domains each connected into a current node by a fourth electrode. Furthermore, the reverse side may comprise additional discrete first conductivity type deflecting domains arranged around the periphery of the second and first conductivity type deflecting-collecting domains or, alternatively, the reverse side comprises additional discrete second conductivity type deflecting domains arranged between said discrete first conductivity type deflecting domains.

The converter is preferably formed on the semiconductor substrate of a thickness commensurable to or less than the diffusion length of the non-equilibrium charge carriers.

On the front or rear side of the semiconductor substrate, Z domains with a source of the additional electromagnetic radiation, for example, strontium-90 may be arranged.

According to a second aspect of the invention, a battery is provided comprising $J > 1$, where J is an integer number, of converters according to any of the above-described embodiments, having a rectangular shaped outer edge and connected to each other into a series and parallel electric circuit. In particular, the converters may have the outer edge with a hexagonal configuration.

According to a third aspect of the invention, a battery is provided comprising $J > 1$, where J is an integer number, of converters according to any of the above-described embodiments, having a pseudohexagonal outer edge and connected to each other into a series and parallel electric circuit.

According to a further aspect of the invention, a battery is provided comprising $J > 1$, where J is an integer number, of thin transmission type converters according to any of the above-described embodiments, arranged in a stack and connected to each other into a series and parallel electric circuit, said converters being stacked such that the upper layer or stage converts the short wave spectrum of the incident radiation and each subsequent lower multistage or layer in the stack converts a longer wave spectrum.

For the sake of unambiguous understanding of the present disclosure, the following interpretation of the semiconductor conductivity types is used herein: the first conductivity type should be understood as p-conductivity or n-conductivity while the second conductivity type should be understood as n-conductivity or p-conductivity, respectively, opposite to the first conductivity type. In terms of methodological aspects, the object of the invention is achieved by using principally new physical phenomena, regularities and properties discovered and found by the inventors, advanced designs, as well as approved techniques in these designs.

In particular, the invention is based on controlling the recombination processes and concentration gradient of the NeCC and on the natural material properties associated with their natural discrete and heterogeneous structure and with phenomena based on the goal-oriented use of these properties and phenomena: bunch or current node effect, effect of the γ-shaped charged particle path in discrete converters, and other phenomena and properties.

The cost effectiveness is achieved not only at the expense of improving efficiency, but also in that the invention uses an optimum minimized structure requiring a minimum amount of the substrate material, and an optimum configuration of cells and their arrangement within the battery.

The techniques used herein for improving efficiency of the electromagnetic radiation converters will be discussed below.

According to the invention, the PEC efficiency is improved both by extension of the EMR spectral range being converted and by a considerable improvement in the conversion technique at the expense of reducing recombination losses, as well as reducing losses due to radiation without absorption, reducing losses due to thermal scattering and reducing losses due to the converter internal resistance.

Methods for reducing reflection of the incident radiation at the expense of antireflection coatings are thoroughly studied worldwide. However, the ultimate reflection reduction to 1 % and less provides only a 3-4% improvement in efficiency. Conventional silicon-based converters with a continuous p-n junction are able to provide efficiency not exceeding 25%. The main reasons for this are recombination losses and losses due to internal resistance, which result in a PEC being saturated both in terms of current and voltage. According to the measurements performed by the inventors on conventional prior art SC, their current-voltage characteristics become rectified due to a high internal resistance both at high intensities of the incident radiation and temperatures, and at low illumination levels.

A state-of-the-art single-junction continuous structure of SC is unable to cope with a large energy flow penetrating the converter. Therefore, such PECs have a low internal conversion factor (a ratio of the output power to the power penetrating the converter) which is in line with its efficiency (a ratio of the output power to the incident power). According to the measurements performer by the inventors, the internal conversion factor (ICF) of the existing high-performance silicon-based converters is at most 25%. It follows therefrom that the efficiency of continuous single-junction solar cells cannot exceed 25%! Therefore, all inventors' efforts have been aimed at increasing first of all the internal conversion factor, To do this, it is necessary before everything else to eliminate the MCC recombination and to reduce the PEC internal resistance.

Improving efficiency by extending the spectral range towards short-wave UV EMR spectrum

This method is based on breaking off the continuous layer of a single-junction SC and a decisive change-over from continuous (solid) single-junction converters to discrete multijunction converters according to the present invention.

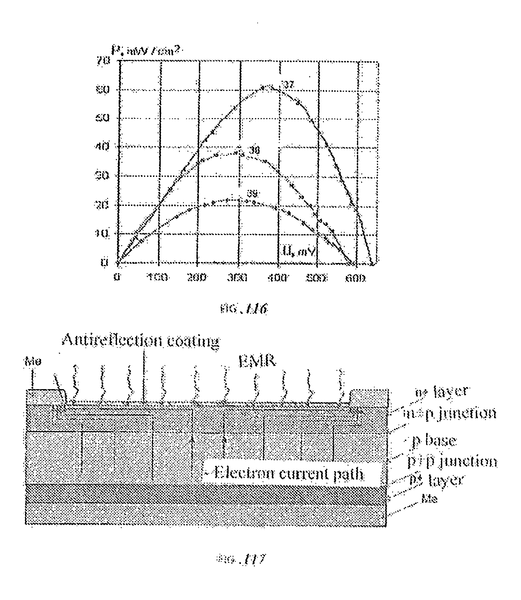

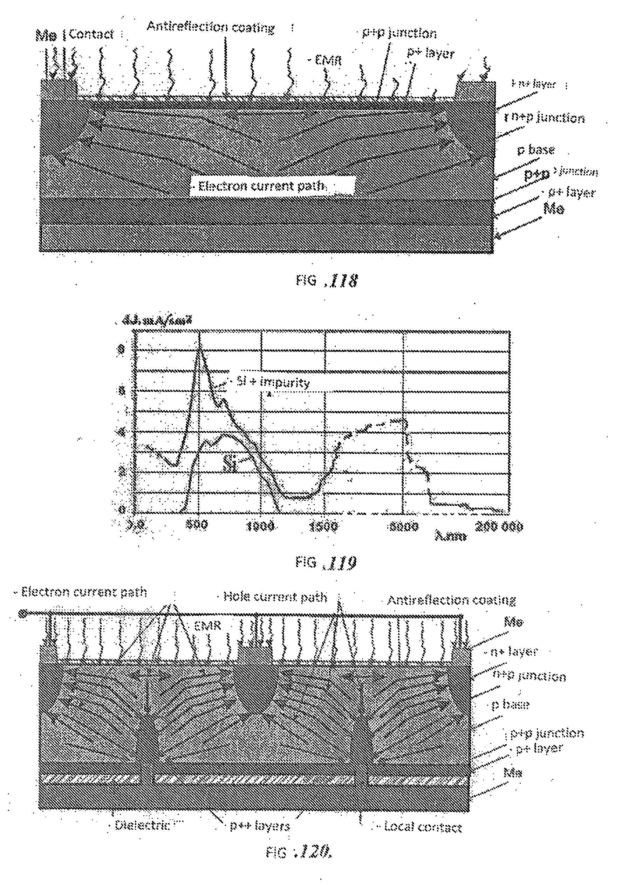

As shown above, the main reason for cutting-off the EMR UV spectrum is a high content of electrons in the $n^+$ layer provided all over the front surface of a continuous single-junction solar cell (Reivi K., Defects and Dopants in Semiconducting Silicon, Moscow, Mir Publishers, 1984, 470 PP). Therefore, in order that UV quanta penetrate the semiconductor and become absorbed, windows have to be exposed so that the quanta may pass into the SC, i.e., the continuous n-layer has to be broken off or the converter front side should be provided with windows without the $n^+$ layer. Such requirement is met by the inventive converter configuration comprising local discrete p-n junctions and a broken-off collecting layer, with optical windows provided in the continuity break-offs. Local discrete junctions simultaneously and substantially reduce the converter internal resistance. It is associated both with manifestation of statistical effects in the discrete converters referred to as bunched converters, and with a reduction in the path of NeCC travel. High internal resistances in the state-of-the-art continuous converters are due both to the semiconductor bulk and a high sheet resistance, associated with a long T-shaped NeCC travel path of (Fig. 117). On the contrary, discrete converters have a low bulk resistance, but also a low sheet resistance at the expense of the γ-shaped travel path of charged particles (Fig. 118). Therefore, discrete converters have a far lower total internal resistance than the continuous converters.

However, the above-mentioned method for extending the absorption range of the EMR cold spectrum prevents from extending the same towards the long-wave spectral range. To enable extension both towards the short-wave and the long-wave domains of the EMR, the inventors have proposed to locally embed discrete multijunction (heterojunction) structures in the semiconductor.

Improving efficiency by extending the spectral range towards short-wave UV and long-wave IR EMR spectrum

A multijunction discrete structure is formed in the semiconductor when dopant centers (or clusters or zones or nanoparticles or absolutely black bodies or any other heterogeneities) are locally embedded therein for absorbing and injecting photons of different length varying from the short-wave UV to the long-wave IR. At the same time, this local embedding also forms the domains of charge concentration gradient, required for diffusion and travel of the generated charges to the current collecting cells and Further to the converter external circuit.

Non-equilibrium minority charge carriers (NeCC) or EHP, i.e., holes in the n-semiconductor and electrons in the p-semiconductor, are formed in the semiconductor as the EMR is absorbed. Given a charge concentration gradient, they diffuse towards the p-n junction, are taken up by the p-n junction field and released into the opposite conductivity-type semiconductor to become majority charge carriers therein. As this takes place, electrons will be localized in the n-type semiconductor while holes - in the p-type semiconductor. As a result, the p-type semiconductor is given an excessive positive charge and the n-type semiconductor a negative one. Between the converter p- and n-domains, a difference of potentials occurs, i.e. a photo-EMF or an open-circuit voltage.

Since the processes of generation and separation of the non-equilibrium minority charge carriers (NeCC) or electron-hole pairs (EHP) in the converters compete with the processes of their surface and bulk recombination in the semiconductor, said surface recombination being in excess of the bulk recombination, in order to reduce the same all prior art converters without exception have the front side comprising a continuous (solid without broken-off areas) doped or diffusion similar domain or portion.

In order that the EMR is absorbed by the semiconductor and EHP may form, the following conditions should be met: the incident wave energy at least in case of its own absorption $E = hv$ (where h is Planck's constant and v is an incident wave frequency) should be equal to or exceed the energy of the semiconductor forbidden band width (FBW) $\Delta E$ width: $hv \geq \Delta E$.

For example, particles of silicon carbide, gallium arsenide, indium compounds with cuprum, germanium or oxygen forming a (-Si-O-Si-)-type bond with silicon, and a number of other compounds may be locally (not homogeneously!) embedded as heterogeneous absorption-injection dopant zones. These compounds give a maximum spectral absorption at certain EMR wavelengths. Wide-band gap materials give a maximum absorption in the short-wave region and narrow-band gap materials - in the long-wave region of the EMR spectrum. As shown, for example, by experimental measurements, two maximums of spectral absorption are manifested in conventional single-crystalline silicon: one in the region of 0.5 $\mu$m and the other in the region of 0.7 $\mu$m. The former maximum relates to the dopant maximums and the latter - to the intrinsic silicon absorption maximum. The presence of oxygen in silicon gives a maximum spectral absorption at the EMR wavelength of 5-6 $\mu$m, etc. Oxygen is typically removed in the process of silicon purification, however it is required , according to the present invention for absorbing the long-wave IR EMR spectrum.

Locally doping the PEC substrate with discrete dopants having different FBW causes maximums of spectral absorption to form in different regions of the EMR wavelengths, On the other hand, locally embedding various dopants results in the centers of longitudinal-transverse charge concentration gradients within the substrate bulk, which are required for diffusion of charges and further advancing the same to the PEC external circuit.

Therefore, breaking off a continuous single-junction layer of the SC and locally embedding one or another discrete band dopant in a physical manner into the semiconductor substrate results in an increased spectral response thereof, extended range of the EMR spectrum being converted and in forming a NeCC concentration gradient. At the same time, absolutely black bodies which comprise not also good EMR absorption and injection sources but also domains of the NeCC concentration gradient may be used for establishing the EMR absorption-injection centers.

The FBW for various semiconductor materials amounts to: silicon carbide (SiC) - $\Delta E$ = 2.5 eV-3,5 eV; cadmium telluride (CdTe) - $\Delta E$ = 1.44 eV; gallium arsenide (GaAs) - $\Delta E$ = 1.43 eV; cuprand and indium diselenide (Cu-InSeOB$_2$) - $\Delta E$ = 1 eV; silicon - $\Delta E$ = 1.1 eV; germanium (Ge) - $\Delta E$ = 0.66 eV; InGaAsSb - $\Delta E$ = 0.5-0.6 eV; InAsPSb - $\Delta E$ = 0.36-0.6 V, etc.

As an alternative, in order to obtain a broad-band PEC it is proposed to use silicon as a base material (any other semiconductor may be used). To obtain a broad-band PEC, a sufficiently large number of local discrete p-n junctions (preferably their number should be N > 1 and N $\rightarrow \infty$) and exposed discrete p-conductivity domains are formed in the p-conductivity (alternatively, n-conductivity) silicon substrate for penetration of the short-wave quanta, and then the particles of material of different FBW and sizes of up to nanoparticles are embedded by any known method. In particular, gallium arsenide, germanium or oxygen or silicon carbide may be embedded. However, materials with a large FBW are embedded into the upper substrate layers and those with a smaller FBW - into the lower layers.

Discrete particles of gallium arsenide having a larger FBW than that of silicon are embedded into the upper surface layer on the substrate front side to the depth of 3-5 $\mu$m, i.e. at the penetration depth of UV quanta, and germanium or oxygen are embedded into the substrate lower layers,

Gallium arsenide or another wide-band gap semiconductor is required for obtaining a photoresponse to the short-wave but high-energy UV region of the EMR spectrum.

The near-surface silicon layer filled with gallium arsenide dopants to the depth of 3-5 $\mu$m or another material with a larger FBW than that of gallium arsenide is a kind of a trap for absorbing the UV quanta. The local discrete impurity filling of the PEC substrate with narrow-band gap materials (for example, germanium, oxygen or a cadmium-mercury-tellurium (CMT) alloy, etc, serves as a trap for the long-wave IR radiation.

As the EMR is incident on the surface of such multijunction silicon mass with exposed windows for penetration of the short-wave quanta, the heterogeneous "band" filling will absorb a wide EMR spectrum from the far IR to UV and upper. The EMR penetration depth in such mass varies depending on the incident radiation wavelength. As the EMR is incident on the PEC photoreceiving portions, the UV photons will be absorbed first. Then, the photons having less energy but penetrating deeper will by absorbed; these are violet photons. The violet photons are followed by blue, yellow, orange, red, etc., and basic silicon will be already transparent to the IR region of the EMR spectrum but it will be absorbed by narrow-band gap germanium or a silicon compound with oxygen or other narrow-band gap material which is doped below the gallium arsenide layer. Embedding CMT alloys with an extra narrow FBW will extend still more the EMR conversion range up to the intermediate and far IR radiation. The proposed semiconductor substrate filled with additional absorption centers will absorb the EMR and generate the electron-hole pairs (EHP) within a wide range of the incident radiation from IR to UV and upper.

Fig. 119 shows an experimental spectral-response characteristic of a SC made from pure silicon and from "dirty" technical-grade silicon admixed with oxygen. As can be seen, pure silicon has a rather narrow conversion range as compared to "dirty" silicon. Thereby, the cost of the PEC substrate material may be reduced by an order of magnitude only by using "ditty" silicon.

Therefore, extending the convertible EMR wavelengths is achieved according to the invention by a radically new process of physical modification of the semiconductor structure, i.e., formation of discrete local junctions by embedding dopants which create a multijunction structure in the basic semiconductor and a NeCC concentration gradient required for a diffusion advance of the NeCC and formation of current in the converter.

Further improvement in PEC efficiency according to the present invention is achieved by embedding built-in fields into the structure of the substrate surface and bulk and optimizing the distances between the current current-collecting buses.

All particular embodiments of the invention are radically new and distinctive from the prior art solutions in that breaking off the front side continuity is used in the converter configuration, i.e., along with the first conductivity type (p- or n-type) doped collecting layer (doped collecting domains), the opposite, second conductivity type portions are brought out onto the substrate front side exposed to the EMR (n- or p-type, respectively, the so called "broken-off layer" design). In the simplest case, said second conductivity type portions may comprise the substrate portions disposed between the first conductivity type doped collecting domains on the front-side; the first and second conductivity type doped domains may also alternate on the front side.

It is novel feature of the inventive converter that the p-n junction resistance is abruptly reduced practically to zero at the expense of the γ-shaped travel path of charged particles (Fig. 118) and N > 1 small-sized first conductivity type discrete local domains are formed so that a rather large number ofN discrete p-n junctions is formed and said N separate domains are combined into a bunch (parallel circuit) or into a first current node via a first current collecting conducting electrode and into a second current node by connecting in parallel the local contacts and the second conductivity type highly doped point depressions using a conductor on the PEC rear side to form the $p^+p$ isotype junctions.

In the prior art silicon-based SC, an isotype $n^+n$ $p^+p$ rear barrier is used to reduce the surface recombination rate of minority NeCC at the ohmic contact. This barrier is typically formed by causing a short-term diffusion of an additional amount of the doping impurity from the rear surface. In distinction from the prior art, isotype junctions are formed in the converter according to the invention on the side or in the plane of discrete local p-n junctions rather than on the opposite side.

The isotype $n^+n$ $p^+p$ barrier may be formed by various methods: diffusion, ion implantation doping and a combination of these methods. Besides, an near-surface layer with an elevated concentration may be induced with the charge built into the passivation dielectric and/or antireflection coating, and/or by the electrode field as in the present invention. Therefore, in the continuity break-offs between the alternating first conductivity type discrete domains, highly-doped second conductivity type layers are formed which create $p^+p$ junctions of the second conductivity type domains. These isotype junctions create repulsive isotype barriers to the minority charge carriers.

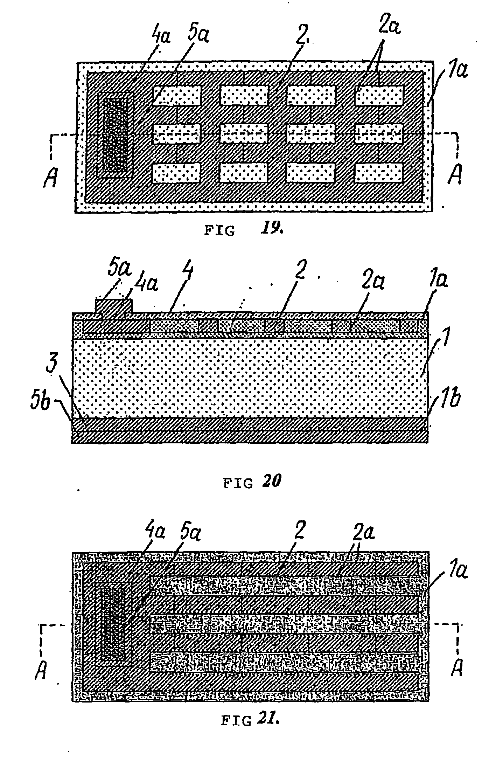

Fig. 20 shows an illustrative embodiment of the discrete bunched converter according to the invention with two opposite current nodes: N discrete p-n junctions form a first current node to the current paths of the non-equilibrium charge carriers and the domains of the second conductivity type highly-doped discrete depressions together with the isotype junctions and discrete rear side local contacts form a second current node to the current paths of the majority non-equilibrium charge carriers. An abrupt resistance drop occurs due to statistical dispersion (which will be further discussed herein) and current node effect (or bunch effect), as well as a reduction in the travel path of charged particles given the γ-shaped NeCC travel path (Figs. 118 and 120),

As an alternative, not only two opposite current nodes but also a configuration with four opposite current nodes is proposed in the invention: two current nodes on the front side and two on the rear side, formed by a parallel connection of the current collecting-deflecting domains (cells). Exemplary embodiments of such converters are further discussed below.

As an alternative, solar cell designs are proposed with opposite current nodes by providing first type conductivity collecting domains and N discrete junctions not only on the front side but also on the rear side of the second conductivity type basic domains,

It is essential for the invention that the geometrical dimensions of the p-n junctions are reduced. The junctions should have small linear dimensions ($d \rightarrow \delta$, where $\delta$ is an infinitesimally small value, and their number of up to N >> 1 (ideally, $N \rightarrow \infty$, where $\infty$ is an infinitesimally large value) and should be formed discretely (not coupled to each other) and in a single-type manner i.e., substantially uniform in size, configuration and other process conditions.

In various embodiments of the invention, the converter is also characterized by the following novel aspects distinguishing the same from the prior art:

1) In the continuity break-offs between the alternating first conductivity type discrete local domains of the discrete "broken-off layer" converter, second conductivity type highly-doped domains are created to form together with the second conductivity type basic domain the isotype $p^+ p$ junctions which comprise optical windows for the EMR to access inside the converter and at the same time are isotype deflecting domains;

2) The EMR conversion process is localized and a system of local surface-bulk heterogeneities (SSBH) is created, which comprise local heterogeneities discretely alternating at the surface of and within the PEC bulk, including opposed $n^+$ and $p^+$ domains, to shift the converter sensitivity towards the IR region and in the opposite direction towards the UV and X-ray radiation;

3) SSBH is formed by embedding locally any heterogeneities, including dopants of various FBW in the form of absorption centers and by injecting the EMR to influence the MCC concentration gradient, In the simplest case, an increase in the formation of the NeCC gradient is caused by local microlenses which concentrate the EMR (into a bunch) in the local domains of the semiconductor surface and bulk to thereby substantially increase the intensity of the incident radiation and create in the absorbing domain an MCC concentration differential (gradient) responsible for intensifying the diffuse component (dn/dx) of current being fundamental for the PEC operation. The use of a system of microlenses or microprisms increases the intensity of the incident EMR flow by an order of magnitude and more, and substantially increases the power and efficiency of the converter operation. The SSBH is formed using any alternating local discrete surface-bulk heterogeneities, including opposite $n^+$ and $p^+$ domains in the surface and bulk structure of the basic semiconductor material (p-Si in this case) and is applicable to any (semiconductor or other) materials using diffusion-drift mechanisms for separation of the non-equilibrium NeCC.

4) Along with the diffusion fields (quadrature-axis and direct-axis components), the converter configuration makes use of the drift deflecting field sources which comprise domains in the form of the first conductivity type belts (as an alternative, second conductivity type) or different-type (first and second conductivity type) belts around N first conductivity type domains on the converter front and rear sides for accelerating the NeCC motion and increasing the charge collection rate at the current collectors; along with diffusion fields, the converter configuration makes use of additional drift deflecting converter fields (and a collecting field on the NeCC electrodes) by embedding (doping) belts of local N second conductivity type layers around N first conductivity type domains on the converter front and rear sides so that both bulk and surface recombination of charges is practically eliminated (both on the front and rear sides);

5) The "broken-off layer" converter configuration makes use of control field electrodes on the substrate front and rear sides;

6) The "broken-off layer" converter configuration makes use of a method for increasing the contact potential difference by embedding a second conductivity type diffusion sublayer under the first conductivity type domain, since after localizing the p-n junction dimensions, diffusion sublayers no longer prevent the radiation from penetrating the active semiconductor bulk; a still greater effect of increase in potential is observed if, in addition to N second conductivity type diffusion subdomains, a stack of $G > 1$ successively alternating layers of two (first and second) conductivity types is arranged so that under each $n^+$ layer a $p^+$ layer is provided adjacent thereto and under the latter another $n^+$ layer is provided, etc., said diffusion subdomains with the stack of alternating p-n junctions may be switched in parallel or in series. In case of progressive switching, N potential multipliers are formed in the converter structure, and in case of parallel switching, N current multipliers;

7) The "broken-off layer" converter configuration makes use of deep diffusion $n^+p^+$ junctions with surface etching followed by diffusion (mesaplanar PEC configurations) resulting in a substantial reduction in the p-n junction resistance, increase in the converter absorption surface and absorption rate and MCC bulk concentration;

8) The "broken-off layer" converters configuration makes use of deep quanta traps ensuring a substantial reduction in the p-n junction resistance, as well as a substantial absorption and conversion of the high-energy short-wave EMR spectrum and long-wave EMR spectrum;

9) As an alternative, in order to reduce the internal bulk resistance of the p-n junctions, the "broken-off layer" converter configuration makes use of thin semiconductor substrates less in thickness than the NeCC diffusion length, which enhance the effect of reducing p-n junction bulk resistance (as compared to conventional wafers of 300 μm and more in thickness) and make it possible to reduce 5-6 times the material consumption and improve the economical and technical effect; strip and grid configuration electrodes are used in the front and rear side structures of the converter (for further reducing the resistance) to create the current node (or bunch) effect;

10) Alternating $n^+p^+$ domains are arranged on the two sides (front side and rear side) of the semiconductor substrate so that the diffusion and drift current components may be used to the full extent and both MCC surface and bulk recombination may be completely eliminated in the converter;

11) The "broken-off layer" converter configuration makes use of additional built-in and permanent (operating at any time of day) EMR sources, i.e., weak radioactive radiating substances, for example, strontium-90 and other chemical compounds and elements;

12) An optimum hexagonal and pseudohexagonal configuration is used when arranging and assembling converters into solar battery systems so that the substrate material may be saved; batteries are stacked into a stack of transmission type SC on ultrathin films with a different depth of the diffusion layer and parallel or progressive switching of the same.

The invention is applicable to any of the converter types or photovoltaic cells known in the art, including those of the heterojunction type and on any material, which are able to convert the EMR into the EMF, as well as to all methods of forming converters. It should be noted that for simplicity, the disclosure of the invention and particular exemplary embodiments thereof will be further described in the context of the p-conductivity silicon-based substrate and N front-side collecting doped domains of n-conductivity ($n^+$-conductivity), although it will be obvious to a person skilled in the art that the n-conductivity substrate and p-conductivity ($p^+$-conductivity) front-side collecting domains may be equally well used for implementation of the present invention.

The present inventors use techniques intended for localizing the process of EHP conversion and creating SSBH in order to improve efficiency of the diffuse component of the PEC current. At the same time, apart from the diffuse component of the converter current, the invention uses an additional built-in field in the form of a drift field so that the converter efficiency substantially improves.

In all cases, the implementation of the invention is achieved by breaking-off the continuity of the collecting $n^+$ layer, including but not limited to creating local discrete domains of an arbitrary shape and configuration ohmically coupled or not coupled to each other and to the collecting electrode. The collecting n+ layer may be configured as a grid of discrete N ≥1 (as an alternative, N>>1) dimensionally minimized cells of an arbitrary shape and configuration (as described above with reference to the method for localizing the EMR conversion process) or a surface-distributed comb structure or any discrete cells. In general, any discrete element or cell comprises a localized domain with an arbitrary configuration combined into a single current node by electrodes,

Shaded zones provided on the converter front side, on the one hand, reduce the photosensitive absorption area (thereby impairing the converter efficiency), but, on the other hand, enhance the NeCC concentration gradient thereby improving the amount and efficiency of the diffuse component of current. The shaded areas should be preferably of a minimum size (for example, the widthwise dimension d of the current-conducting circuit or contacts should tend to a sufficiently small value of δ, i.e., to the dimension of n+ domains). In case of small linear dimensions, no shading will be virtually present due to the EMR edge diffraction.

Shaded zones may be represented by n+ domains due to an increase they cause in the reflection index dependent on the concentration of free carriers in the reflecting layer, and also by deflecting p+ layers, metal buses of the collecting n+ domain, as well as any domains of the converter front surface.

Since shading is accomplished over the n+ domain or p+ layers (with a high reflectivity), the contribution of shading to impairing efficiency is reduced. Therefore, a prevailing factor for improving the converter efficiency is to create heterogeneities at the expense of the shaded areas to ultimately form a charge carrier density gradient (CCDG) required for the charge diffusion process and passage of the converter photo-electric current. Shaded domains may have any arbitrary configuration. The heterogeneity zones should be preferably of a single type, discrete and of minimum dimensions and combined into a single current node by a conductor, with an arbitrary configuration and a number preferably of N >> 1.

As already noted above, localization of the EHP conversion process and the associated reduction in the internal resistance of the p-n junctions is achieved according to the invention by reducing the travel path of charges along the γ-shaped NeCC travel path and combining a multitude of N first conductivity type domains (where N > 1) into the first current node by the first electrode adjacent to each of said N domains and into the second current node by combining the rear side of the second conductivity type highly-doped depressed domains into a parallel circuit by the conducting second electrode. The second current node on the rear side may be formed in the double-sided discrete converters by combining the junctions arranged on the rear side into the parallel circuit. As a result of such parallel connection and combination of the p-n junctions of the first conductivity type diffusion n-domains (as an alternative, p-domains) adjacent thereto into one first current node or bunch and the second current node on the rear side, the total circuit resistance of the p-n junctions is reduced practically to zero. At the same time, in order that the effect of the γ-shaped NeCC path travel is profound, it is required, on the one hand, to reduce the distance between discrete junctions and, on the other hand, to reduce the thickness of the converter basic substrate. In an optimum case, the distance and the length are either commensurable to or less than the NeCC diffusion length.

Reducing the internal resistance to a value close to zero leads to an amplification of the circuital current, reduction in the bulk and surface recombination of charges and in the bulk thermal losses in the converter so that its power and efficiency is ultimately improved. At the same time, each of the first conductivity type domains under the first electrode and the electrodes themselves may have any shape and configuration, in particular may be rectangular, square, hexagonal (with different aspect ratios), octagonal (with different aspect ratios), etc.

For further reducing the value of the converter total internal resistance, it is desirable to increase the number ofN first conductivity type domains to N >> 1, namely to: (a) at least 10, (b) at least 50, (c) at least 80, (d) at least 100, (e) at least 1000, (f) at least 10,000, (g) at least 100,000, (h) at least 10,000,000, etc. In doing so, the junction size should tend to an infinitesimally small value, in a particular case, a point-contact junction should be provided.

Thus, reducing the converter internal resistance is based on applying new physical methods for material modification, leading to a reduction in the internal resistance value Rp and increase in the converter surface sensitivity to the EMR. This simple but in principle new physical method is based on using the bunch or current node effect. The bunch or current node effect is achieved with N > 1 being a sufficiently large number (where N is an integer, ideally N → ∞) of cells in the bunch and with such cells being separate and single-type. In addition, in order to achieve the amplification or reduction effect, the bunch cells (in this case, p-n junctions with the adjacent diffusion domains) should preferably be sufficiently small in terms of the dimension d, i.e., the p-n junction geometrical dimension should tend to an infinitesimally small value of d → δ. Moreover, in an alternative embodiment of the invention, for reducing the p-n junction total internal resistance it is proposed to reduce the thickness of the semiconductor material, in particular a conventional thickness of the silicon wafers preferably from 300-400 μm to a thickness commensurable to the NeCC diffusion length, for example, to 70 μm and less.

As shown by the experiments performed by the inventors, the semiconductor material with a thickness of less than 70 μm passes into a special physical state with high values of physical characteristics. It is a manifestation of the general natural phenomenon: scale effect of physical characteristics.

Thin substrate wafers, especially with a thickness of less than 70 $\mu$m, demonstrate an abrupt improvement in the substrate physical characteristics: mechanical, electrical, thermal, etc.

Therefore, as an alternative, in order to achieve the technical and economic effect, the silicon wafer thickness has to be reduced. The consumption of semiconductor silicon may be in general lowered from 16 g/W for a conventional weight of the 100-mm conventional SC wafer to 3-5 g/W. In this case, the cost of one watt of energy may be lowered from 6$/W to 3-4 $/W only at the expense of cost savings in the material.

In addition, silicon consumption is further reduced when the SCs are arranged and assembled into a hexagonal configuration (see below the description of how the inventive converters is configured into a solar cell).

According to the experimental statistical data obtained by the inventor, the larger the spread in the p-n junction internal resistance values, the less their geometrical dimension and of the diffusion domains adjacent thereto. Thus, the greater the spread and the number N of p-n junctions, the higher the probability of the presence of the p-n junctions with internal resistance values of zero or close to zero in such statistical sampling (or such statistical bunch). In such statistical sampling, if the cells comprising resistances of the p-junctions with the adjacent diffusion domains are connected into a parallel electrical circuit and combined into a single current node or bunch by means of a bus or current electrodes, the total resistance will be according to the shunt law lower than the least value of an individual circuit cell (i.e., detected least resistance value defining one or more of the p-n junctions in the circuit). In addition, the spread in the resistance values in such statistical samplings goes down in inverse proportion to the number of p-n junctions, i.e., the larger the number N of p-n junctions in such samplings, the less the spread in the resistance values and the more stable the electrical parameters of semiconductor device.

Therefore, in the manufacture of the semiconductor structures according to the invention, a sufficiently large number of p-n junctions with sufficiently small geometrical dimensions are appropriately used. Furthermore, for achieving a maximum effect of reducing the resistance and its spread value, the p-n junctions should be discrete and single-type, and have a minimum size in diameter, i.e., should be point-contact.

Therefore, in order to enhance the effect of reducing the total resistance in the internal circuit of a semiconductor diode arrangement, the p-n junctions should be preferably discrete and spaced at distances commensurable to or less than the NeCC diffusion length so that their number tends to an infinitesimally large value, i.e., $N \rightarrow \infty$, these junctions should be single-type, separate, and the linear dimensions (for example, diameter in case of the circular configuration of the diffusion n-domains, i.e., the p-n junctions) of each of N p-n junctions should be sufficiently small and ideally should tend to an infinitesimally small value of $\delta$ - d $\rightarrow \delta$.

Instead of continuous rear-side electrode, in order to substantially reduce the converter resistance, discrete point contacts may be also used or contacts in the form of thin strips forming the second current node with the transverse bus, or a grid configuration or a strip-grid configuration, or another configuration to form the second current node on the converters rear side.

As shown below, subject to meeting said requirements in the converter according to the invention having a diode arrangement, the total internal resistance of the p-n junctions will tend to a minimum (zero) value. It results from reducing the active R (R $\rightarrow$ 0), capacitive C (C $\rightarrow$ 0) and inductive (L $\rightarrow$ 0) components of the total internal resistance Rp of the p-n junctions, The quality factor Q in such converter tends to a rather large value as the number N (N $\rightarrow \infty$) of p-n junctions increases. As a result, the boundary operating frequency, as well as the thermal stability of the converter electrical parameters will substantially increase as the values R, C, L decrease. The thermal stability will increase until a temperature close to the temperature at which a p-n junction is formed in the semiconductor. At the same time, since the total resistance decreases, the internal conversion factor and the converter output power will increase. The internal conversion factor achieved in the inventors' experiments was in excess of 70-80%. Therefore, by increasing the number N and reducing the geometrical dimensions of separate p-n junctions it is possible to obtain a rather high-performance converter.

Under conditions of localization of the EHP formation process and reduction in the converter internal resistance, the drift of the generated NeCC is accelerated, and all that remains is to direct a small potential difference to this drift from the field of the same p-n junctions which will eventually lead to an abrupt amplification of current and power and improvement in efficiency of the converter according to the invention.

In order to increase the converter drift current component, it is first of all necessary to efficiently separate the charge carriers having been generated. As the radiation quantum is absorbed, MCC are formed in a varying degree within the entire p - Si bulk thereby preventing each other in a diffusive manner from reaching the collecting $n^+$ junction: if these were formed in a certain local domain as in the case of monochromatic irradiation, a directed diffusion flow would be established at the expense of a concentration difference; given a wide solar radiation spectrum, MCC are formed within the entire active semiconductor bulk so that the drift is more in the nature of Brownian motion rather than drift. Hence, a targeted ordering of this motion by means of applying a potential to the control electrode suggests itself, which exactly is done in a number of particular inventive embodiments (designs). Therefore, a third electrode and a fourth electrode are added to the converter structure, which comprise control field electrodes.

Thus, it is proposed according to the invention to reduce the EHP recombination by creating additional deflecting fields and additional drift accelerating electrical fields in the converter configuration to deflect charges and thereby eliminate the electron-hole surface and bulk recombination in the converter. In conventional continuous single-junction converters, the MCC formed while absorbing the radiation quantum are separated by diffusion to thereby create a diffuse component of current. Converters according to the invention may be formed of a system of current collecting (currents) receiving and deflecting (and guiding) field electrodes which, making use of the p-n junction self-potential (0.3-0.5 V), generate an accelerating field for the MCC, i.e., a drift component of current is added to the diffuse component so that the MCC collection rate is increased at the current electrodes. In the converters according to the invention, around the $H^+$ domains (as an alternative, $P^+$ domains) there may be provided a belt with a highly-doped $p^+$ layer (or as an alternative, $n^+$ layer), comprising a deflecting and guiding system for the MCC. On top of the highly-doped belt, a contact-electrode system may be provided made from a transparent or other conducting material, to which a potential is applied from the converter itself not only of 0.3-0.5 V but also higher by means of connecting in series a number of separate elemental converters. Therefore, the deflecting system or cell, if a potential difference is applied thereto, is in fact a control field electrode (similar to control electrodes in MOS capacitors or transistors) by means of which it is possible to adjust the value of the drift and total current at the converter output, i.e., added to everything else, the converter according to the invention may operate as a photocurrent amplifier.

As an interim option for reducing recombination according to the invention, a deflecting belt of the $p^+$ layer (or a combination of $p^+n^+$ layers) is formed around $n^+$. As an alternative, in order to reduce optical losses due to shading on the front side it is proposed in the inventive converters to use a contact-electrode system made from a non-doped transparent conducting material, for example, polysilicon $Si^*$ or TCO or ITO (Untila G.G., Kost T.N., Zaks M.B., et al. /A New Type of High-Performance Double-Sided Silicon Solar Cells with Front-Side buses and a Wire Grid // Semiconductor Physics and Technology, 2005, Vol. 39, Issue 11, PP. 1393-1398) connected to the collecting metal electrode.

As noted above, another at least equally efficient method for eliminating the NeCC recombination is to optimize the distance between the current collecting domains and cells, as well as the basic semiconductor thickness. To this end, these distances and the substrate thickness should be commensurable to the NeCC diffusion length. Under such conditions, no recombination of charges will occur, and the charges will reach their respective current collectors. Another method for eliminating the recombination is to create, both on the rear and front side of the converter, isotype junctions which in fact serve as deflecting-collecting cells of the converter.

Furthermore, extending the convertible frequencies towards the high-energy short-wave EMR frequencies, as well as reducing the surface and bulk recombination of the NeCC may be accomplished according to the present invention not only be means of the above described methods and effects but also by means of creating deep quantum traps to ensure capturing and absorption of the short-wave frequencies not only over the surface but also in terms of the PEC bulk.

The quantum traps comprise pyramidal (truncate at the pyramid vertex) depressions arranged top end down. Depressions of any other geometry are possible. A first conductivity type collecting layer is doped on the lateral inner surface of the pyramid. Adjacent to the first conductivity type domains, the current collecting electrodes are arranged depthwise the trap to thereby ensure collection of charges from the depth of the converter substrate and eliminate the surface and bulk recombination. Between the pyramidal depressions of the first conductivity type domains, the pyramidal depressions of the second conductivity type domains are provided in increments of F. On the front side of the second conductivity type substrate, depressions are arranged in such a manner that the first conductivity type domains and the second conductivity type domains alternate at intervals or in increments preferably of F ≤2f (where f is an MCC diffusion length). Due to such configuration, the depth and area of penetration of the high-energy short-wave part of the EMR spectrum into the semiconductor substrate is increased. At the same time, the deeper the quantum traps, the more efficient the capture of the short-wave quanta in terms of the converter bulk. Hence, the deeper the quantum traps, the more short-wave high-energy quanta are captured by the converter bulk and the more the number of the generated NeCC and the PEC efficiency.

In practice, when the EHP conversion process is localized by reducing the dimensions (to d → infinitesimally small value) of diffusion n-domains and increasing their number (to N → infinitesimally large value), the converters according to the invention made from traditional silicon-type semiconductors and filled with band gap dopants will operate in a wide range of the EMR frequencies, from the IR to UV domain, X-ray and upper.

Therefore, in an embodiment, an additional EMR source is integrated into the converters according to the invention, i.e., a layer comprising one of radioactive chemical elements with a sufficiently long half-life period, which are currently used for biological purposes. To this end, onto the converter front side (or alternatively onto the rear side), for example, under the current conducting circuits or electrode a thin layer is applied, for example, of radioactive strontium-90 emitting β-radiation with a half-life period of 27,7 years. Other isotopes of the periodic system elements may be used, for example, cesium isotope - cesium-137. The additional built-in source is technically interesting in that the converter based thereon will operate practically "perpetually".

Terms, notation conventions and definitions used in the present disclosure

EMR - electromagnetic radiation able to generate non-equilibrium charge carriers in the converter;

Substrate (base) - a wafer of any semiconductor material for forming the converter cells therein. As an example, a p-conductivity type substrate is referred to in the disclosure.

Front face, front side, front surface - a substrate side being exposed to or irradiated by the EMR;

Reverse side (or shaded side or rear side) - a substrate side being opposite to the EMR exposure;

Photoelectric converter (PEC), converter - a semiconductor device for converting the EMR into electric current and photo-EMF;

Converter cell - a converter component, area (domain) exhibiting common functional properties;

Collecting cells - doped areas (or domains) of the converter forming, together with the substrate, p-n junctions which provide NeCC current collection and have a contact with the external electrical circuits;

Deflecting cells - doped areas (or domains) of the converter forming and not forming, together with the substrate, p-n junctions which provide NeCC deflection;

Isotype junctions - junctions formed by domains or layers with similar (single-type) conductivity but with different impurity doping concentrations;

Field electrodes - electrodes to which an electric displacement potential is applied;

Diffusion converter - a converter based on diffusion current;

Diffusion-drift converters - a converter based on diffusion and drift current;

Synonyms used: photovoltaic cell, solar cell (SC), photocell, photogalvanic cell, photoelectric converter (PEC), electromagnetic radiation converter.

Two main conductivity types- n-conductivity and p-conductivity, are traditionally discussed with reference to semiconductor devices. Therefore, first conductivity type domains should be conventionally understood herein as n-conductivity and second conductivity type domains - as p-conductivity. Accordingly, the converter domains should be unambiguously understood as domains each being defined by p-conductivity (respectively, p-domain) or as an alternative by n-conductivity (respectively, n-domain).

According to the prior art (Kartashov E.M., Tsoi B., Shevelev V.V., The Structural and Statistical Kinetics of Polymer Destruction, Moscow, Khimia Publishers, 2002, 736 p.; Tsoi B., Kartashov E.M. and Shevelev V.V., THE STATISTICAL NATURE AND LIFETIME IN POLYMERS AND FIBERS. Utrecht-Boston, Brill Academic Publishers/VSP. 2004. 522 p.; Tsoi B., Lavrentiev V.V.,

/ Dielectric Material for Articles Operating in the Microwave Range. // RU 2,273,969) Tsoi B., Lavrentiev V.V., Kartashov E.M., Shevelev V.V., Electric Insulating Material. // RU 2,284,593, 26.10.2004 τ.), as used herein, a statistical bunch (or stack or cable) or simply a cable should be understood as a multi-cell statistical structure formed by N > 1 (where N is an integer) separate single-type individual constituent resistor cells (in this case, resistors of the p-n junctions with the p- and n-domains adjacent thereto) aggregated into a parallel electrical circuit and combined using a conductor (common electrode) into a single current node, i.e., a bunch. Accordingly, the converter comprising a large number of junctions combined into a current node or bunch is referred to as a bunched converter.

Furthermore, the term "single-type" should be understood as p-n junctions made in the same manner (under the same conditions) of the same materials (using the same dopants in the same concentrations) and having substantially the same geometrical dimensions, configuration and shape, as well as the same structure-sensitive physical (mechanical, electric, electromagnetic and other) characteristics and properties. The uniformity of p-n junctions is a necessary criterion (i.e. equivalent) of the uniformity of the same conductivity type domains (p- or n-domains). Similarly, the term "single-type portions" of the first electrode should be understood as the cells of this electrode made in the same manner of the same material (of which the first electrode itself is in fact made) and having substantially the same dimensions and shape, as well as substantially the same structure-sensitive physical (mechanical, electric, electromagnetic and other) characteristics and properties. The term "single-type" is used herein because due to tolerances for individual parameters of the final product present in any process, it is highly improbable in practice that all p-n junctions or all said cells of the first electrode are absolutely identical although it is preferable.

Furthermore, the feature "separate" means that the junctions are not coupled to each other. Moreover, "separate" p-n junctions should be understood as p-n junctions with no intersecting or overlapping portions, i.e. each of the p-n junctions is provided apart (separately) from the other p-n junctions in the converter. It is in fact equivalent to the apartness (severalty) of said domains having the same conductivity. Similarly, "separate" cells of the first electrode mentioned above should be understood as cells with no intersecting or overlapping portions, which is achieved by providing either an oxide gap (in particular, an oxidized area of the electrode) between these cells or through holes (partial depressions in the first electrode between said cells).

The invention will be further described with reference to the attached drawings illustrating various embodiments of the inventive converters with a planar or mesaplanar configuration. The converters of the invention are discrete bunched converters with a broken-off continuous layer, which depending on the type of current they generate are conventionally presented by way of a few examples: bunched diffusion converters, bunched diffusion-drift converters, bunched microlens-type diffusion-drift converters, double-sided bunched diffusion-drift converters, bunched diffusion-drift converters with built-in radiation sources, bunched converters based on the quadrature-axis and direct-axis components of diffusion current. In turn, these may be subdivided into different groups or subgroups depending on their design.

A feature that all embodiments of the discrete bunched converters have in common is that the discrete local junctions with the adjacent collecting domains (cells) are combined into a single bunch or current node through a parallel circuit and based on this feature are referred to as bunched converters, as well as that all designs comprise a "broken-off continuity" with the SSBH system on the front side. Conventional semiconductor materials and processes, in particular conventional single-crystalline silicon and diffusion with photolithography are used to manufacture the inventive SC. Any semiconductor may be used. Furthermore, conventional massive silicon wafers of a conventional thickness of 300 $\mu$m (or less) or as an alternative of a thickness of less than 70 $\mu$m with a diameter of 100 mm, 150 mm or 300 mm or pseudosquares are suitable for manufacturing the converters.

BRIEF DESCRIPTION OF THE DRAWINGS

Fig. 1 shows a partial top view of a planar bunched discrete diffusion converter with N > 1 p-n junctions configured as a cross-shaped bus on the front side. Note: for simplicity, no current conducting buses and circuits 5ac are further shown in Figs. 7-100b.
Fig. 1a shows a partial top view of a planar bunched discrete diffusion converter with N > 1 p-n junctions configured as a comb bus on the front side.
Fig. 2 shows section A-A in Fig. 1.
Fig. 3 shows a partial top view of the cross-shaped configuration of the collecting cells on the front side.
Fig. 4 shows a partial top view of the discrete configuration of the collecting cells on the front side.
Fig. 5 shows a partial top view of the discrete strip configuration of the collecting cells on the front side.
Fig. 6 shows a partial top view of the discrete grid configuration of the collecting cells on the front side.
Fig. 7 shows a partial top view of the planar discrete diffusion converter on the front side,
Fig. 8 shows section A-A in Fig. 7.
Fig. 9 shows a partial top view of a connection element 2c of the planar diffusion converter on the front side.
Fig. 10 shows section A-A in Fig. 9.
Fig. 11 shows a partial top view of the connection element 2c of the mesaplanar diffusion converter on the front side.

Fig. 12 shows section A-A in Fig. 11.
Fig. 13 shows a partial top view of the strip connection element 2c of the diffusion converter on the front side.
Fig, 14 shows a partial top view of the grid connection element 2c of the diffusion converter on the front side.
Fig. 15 shows a partial top front side view of the mesaplanar discrete diffusion converter with the collecting domains 2 and p-n junctions 2a brought out onto the front side front surface and side surface within the EMR direct impact area,
Fig. 16 shows section A-A in Fig, 15.
Fig. 17 shows a partial top front side view of the combined discrete diffusion converter with the collecting domains 2 and p-n junctions 2a brought out onto the front side front surface.
Fig. 18 shows section A-A in Fig. 17.
Fig. 19 shows a partial top front side view of the grid planar monolayer converter with closed circuits,
Fig. 20 shows section A-A in Fig. 19.
Fig. 21 shows a partial top front side view of the strip (comb) planar monolayer converter.
Fig. 22 shows a partial top front side view of the combined planar monolayer converter.
Fig. 23 shows a partial top front side view of the grid planar double-layer converter with closed circuits.
Fig. 24 shows section A-A in Fig. 24.
Fig. 25 shows a partial top front side view grid mesaplanar monolayer converter with closed circuits.
Fig. 26 shows section A-A in Fig. 25.
Fig. 27 shows a partial top front side view of the grid mesaplanar double-layer converter with closed circuits.
Fig. 28 shows section A-A in Fig.27.
Fig. 29 shows a partial top front side view of the combined grid double-layer converter with closed circuits.
Fig. 30 shows section A-A in Fig. 29.
Fig, 31 shows a partial top front side view of the planar double-layer (layer 2 and layer 6) diffusion converter.
Fig. 32 shows section A-A in Fig. 31.
Fig. 33 shows a partial top front side view of the mesaplanar double-layer diffusion converter.
Fig. 34 shows section A-A in Fig. 33.
Fig. 35 shows a partial top front side view of the mesaplanar multilayer diffusion converter.
Fig. 36 shows section A-A in Fig. 35.
Fig. 37 shows a partial top front side view of the planar multilayer diffusion converter with switching of the subsurface junctions.
Fig. 38 shows section A-A in Fig. 37.
Fig. 39 shows a partial top front side view of the monolayer discrete planar converter of the first conductivity type deflecting cells.
Fig. 40 shows section A-A in Fig. 39.
Fig. 41 shows a top view of the front side of the converter of the second conductivity type deflecting cells.

Fig. 42 shows section A-A in Fig. 41.

Fig. 43 shows a partial top front side view of the monolayer discrete planar converter with the extended second conductivity type deflecting domains.

Fig. 44 shows section A-A in Fig. 43.

Fig. 45 shows a partial top front side view of the discrete planar converter of the second conductivity type deflecting domains forming a closed circuit.

Fig. 46 shows section A-A in Fig. 45.

Fig. 47 shows a partial top front side view of the planar discrete converter with the combined (first and second conductivity type) deflecting domains.

Fig. 48 shows section A-A in Fig. 47.

Fig. 49 shows a partial top front side view of the combination converter with double etching.

Fig. 50 shows section A-A in Fig. 49.

Fig. 51 shows a partial top front side view of the combined converter with double etching and second conductivity type deflecting p+ domains (13).

Fig. 52 shows section A-A in Fig. 51.

Fig. 53 shows a partial top front side view of the combined converter with the etched collecting electrode.

Fig. 54 shows section A-A in Fig. 53.

Fig. 55 shows a partial top front side view of the combined converter with the etched collecting electrode и and second conductivity type deflecting p+ domains.

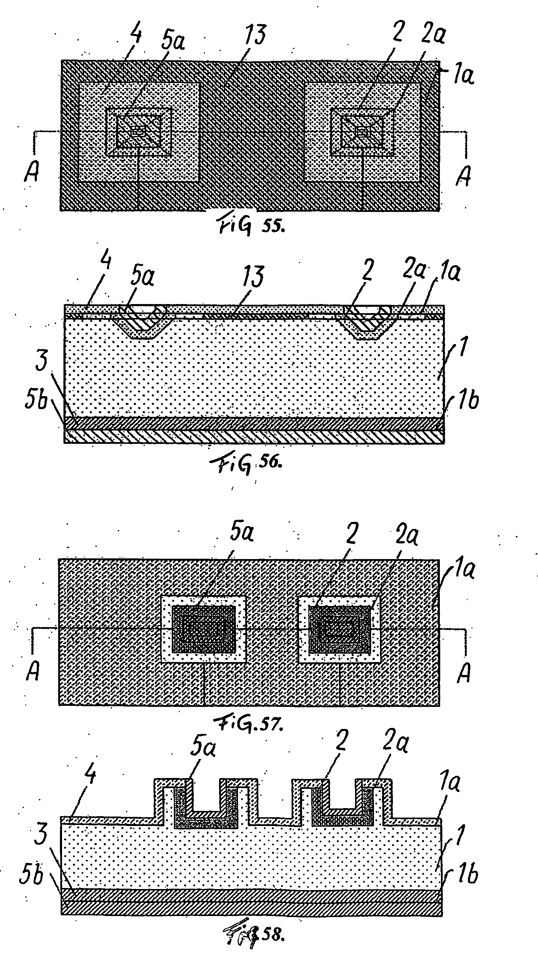

Fig, 56 shows section A-A in Fig. 55.

Fig. 57 shows a partial top front side view of the combined converter with double etching.

Fig. 58 shows section A-A in Fig. 57.

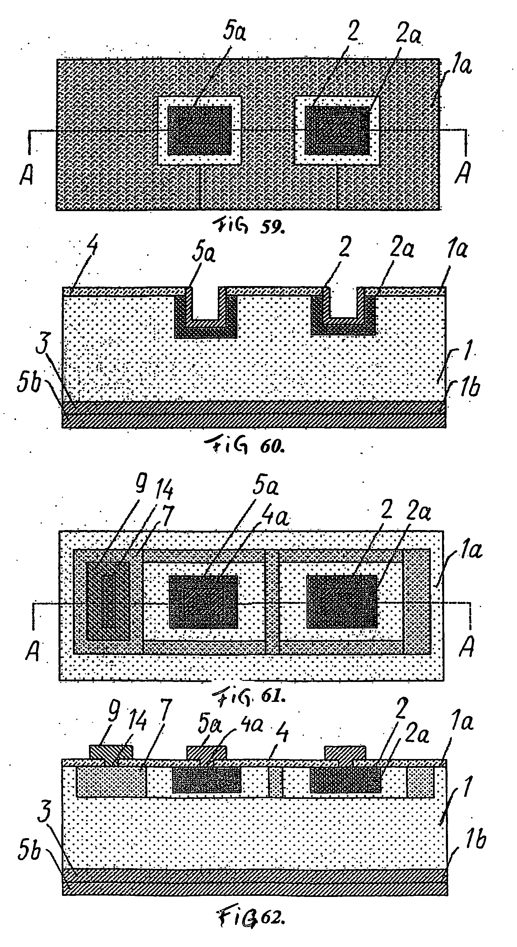

Fig. 59 shows a partial top front side view of the combined converter with the etched collecting electrode.

Fig. 60 shows section A-A in Fig. 59.

Fig. 61 shows a partial top front side view of an additional third (or second front side) collecting electrode of the monolayer discrete planar converter of the second conductivity type extended deflecting domains in the form of a closed circuit.

Fig. 62 shows section A-A in Fig. 61.

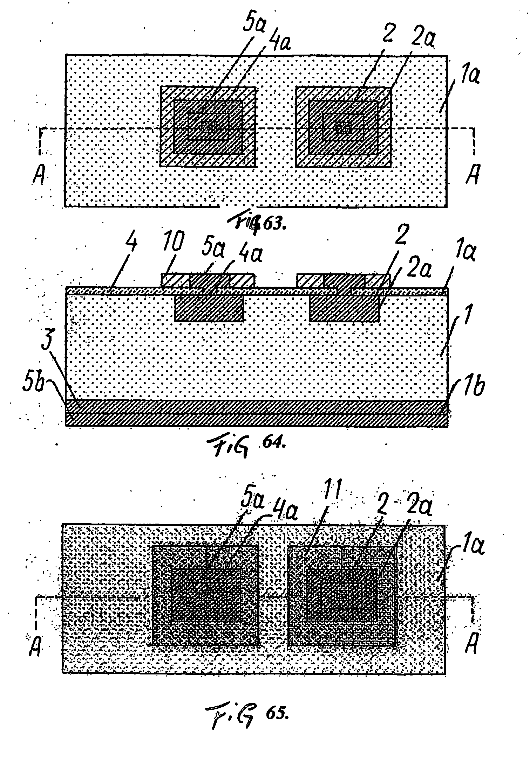

Fig. 63 shows a partial top front side view of the non-transparent extended collecting-deflecting field electrode 10 of the planar diffusion converter.

Fig. 64 shows section A-A in Fig. 63.

Fig. 65 shows a partial top front side view of the extended deflecting field electrode 11 made from optically transparent conducting material of the planar diffusion converter.

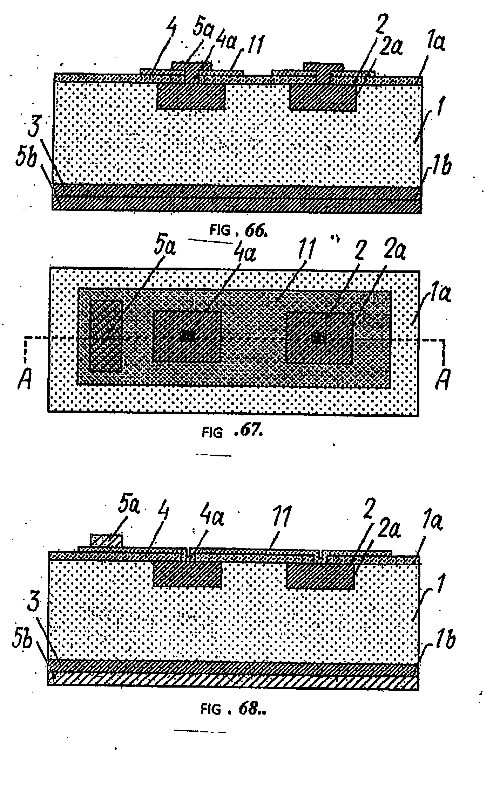

Fig. 66 shows section A-A in Fig. 65.

Fig. 67 shows a partial top front side view of the continuous transparent deflecting electrode 11 of the planar diffusion converter.

Fig. 68 shows section A-A in Fig. 67.

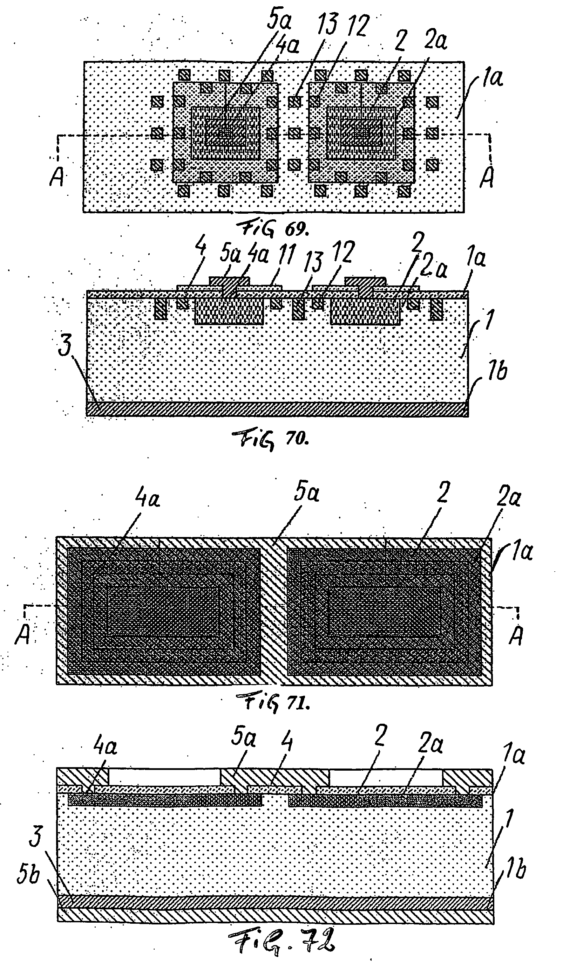

Fig. 69 shows a partial top front side view of the transparent deflecting field electrode 11 above the first and second conductivity type deflecting domains 12 and 13.

Fig. 70 shows section A-A in Fig. 69.

Fig. 71 shows a partial top front side view of the deflecting field electrode 5a along the perimeter of collecting domains of the planar diffusion converter.

Fig. 72 shows section A-A in Fig. 71.

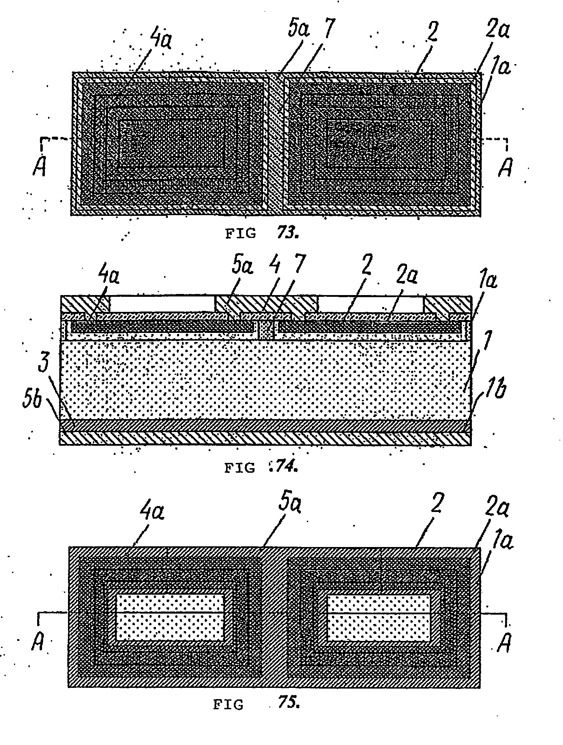

Fig. 73 shows a partial top front side view of the deflecting field electrode 5a along the perimeter of collecting domains of the planar diffusion converter with the first and second conductivity type extended deflecting domains in the form of a closed circuit.

Fig. 74 shows section A-A in Fig. 73.

Fig. 75 shows a partial top front side view of the exposed continuous collecting cell.

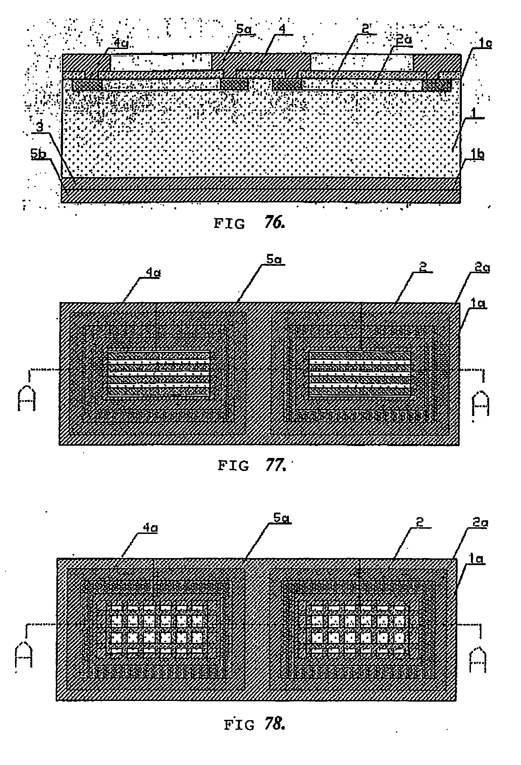

Fig. 76 shows section A-A in Fig. 75.

Fig. 77 shows a partial top front side view of the strip collecting cell.

Fig. 78 shows a partial top front side view of the grid collecting cell.

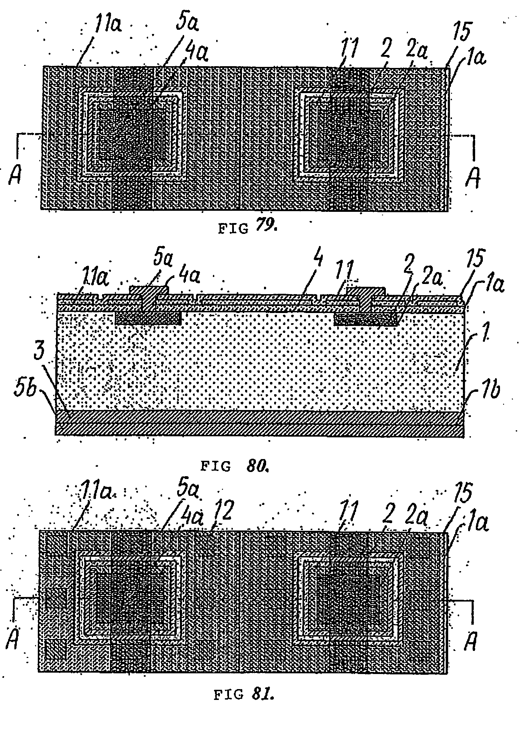

Fig. 79 shows a partial top front side view of the diffusion-drift converter with the extended collecting-deflecting electrode 11 and the third electrode 11a (or first drift field electrode on the front side).

Fig. 80 shows section A-A in Fig. 79.

Fig. 81 shows a partial top front side view of the diffusion-drift converter with the deflecting field electrode 11 and the drift field electrode 11a arranged above the first conductivity type deflecting domains 12.

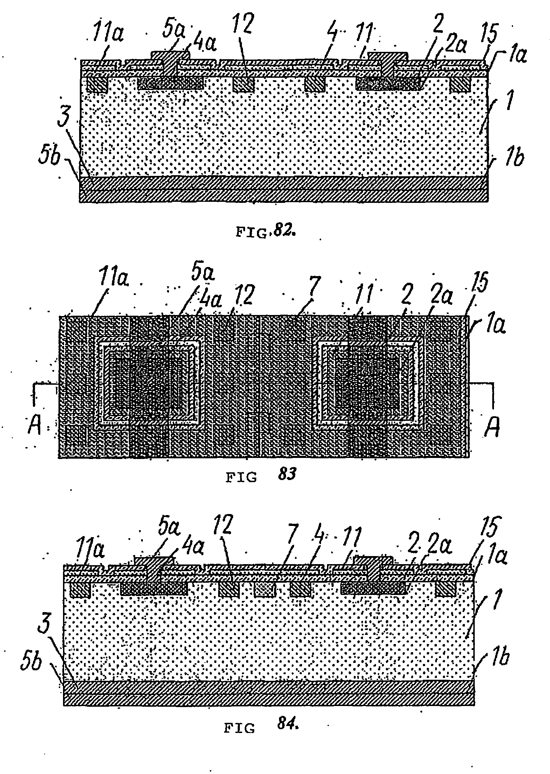

Fig. 82 shows section A-A in Fig. 81.

Fig. 83 shows a partial top front side view of the diffusion-drift converter with the deflecting field electrode 11 and drift electrode 11a arranged above the first conductivity type deflecting domains 12 and the second conductivity type deflecting domains 7.

Fig. 84 shows section A-A in Fig. 83.

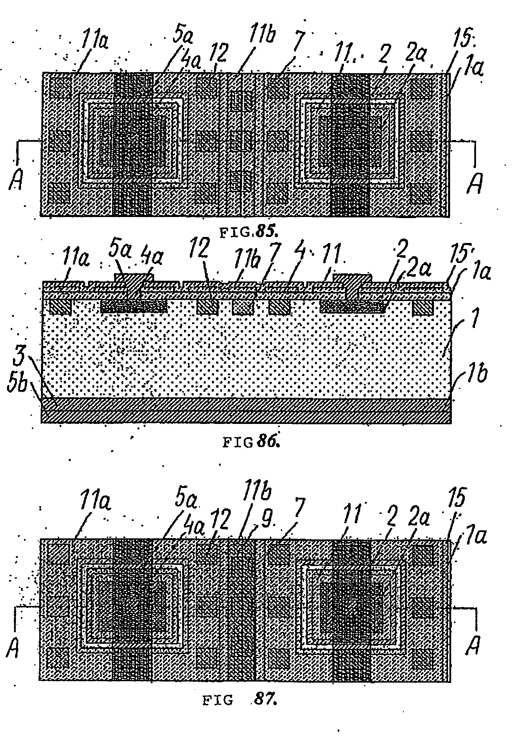

Fig. 85 shows a partial top front side view of the diffusion-drift converter with the deflecting field electrode 11 and two drift electrodes 11a and 11b arranged above the deflecting domains 7 и 12.

Fig. 86 shows section A-A in Fig. 85.

Fig. 87 shows a partial top front side view of the diffusion-drift converter with the deflecting field electrode 11 and two drift electrodes 11a and 9 , arranged above the deflecting domains 7 and 12, wherein the third collecting electrode 9 is used.

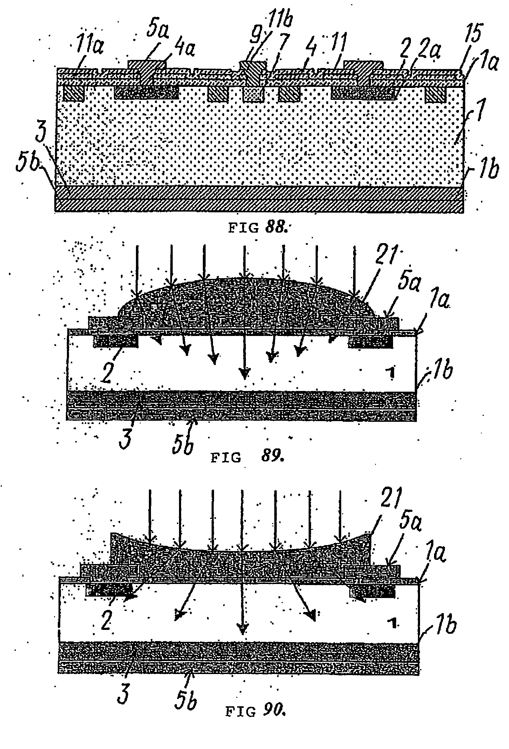

Fig. 88 shows section A-A in Fig. 87.

Fig. 89 shows a partial sectional front side view of a focusing microlens of the discrete diffusion converter.

Fig. 90 shows a partial sectional front side view of a scattering microlens of the discrete diffusion converter.

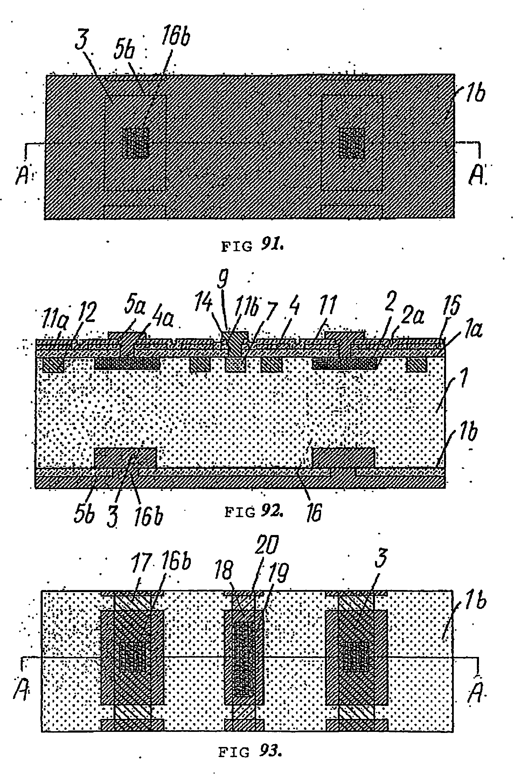

Fig. 91 shows a partial bottom back side (rear) view of the converter with the discrete deflecting collecting domains 3 combined unto a current node by the continuous electrode 5b.

Fig. 92 shows section A-A in Fig. 91.

Fig. 93 shows a partial bottom reverse side view of the converter with the second electrode 17 and the fourth electrode 20.

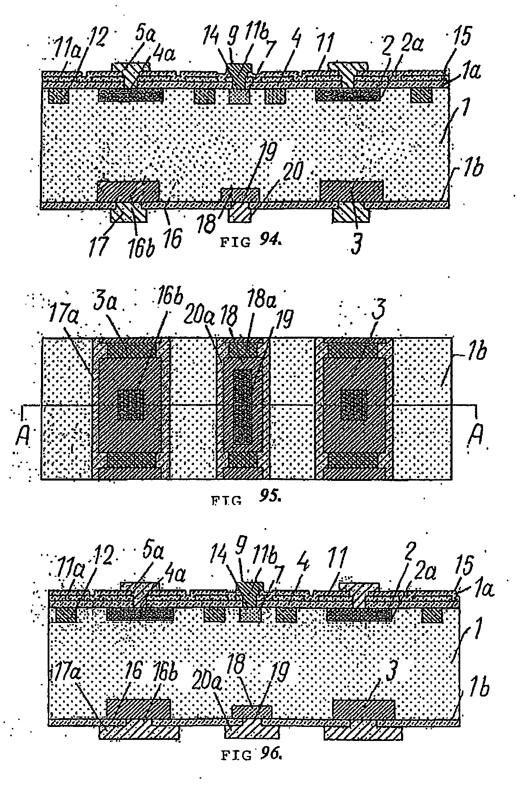

Fig. 94 shows section A-A in Fig. 93.

Fig. 95 shows a partial bottom back side (rear) view of the converter with the extended second electrode 17a and extended fourth electrode 20a and connection domains 3a and 18a.

Fig. 96 shows section A-A in Fig. 95.

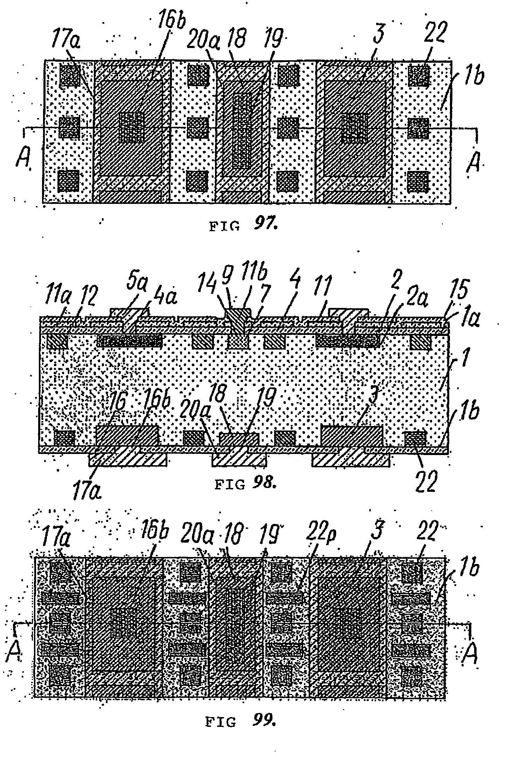

Fig. 97 shows a partial bottom back side (rear) view of the converter with the n$^+$ first conductivity type deflecting domains and extended second electrode 17a with extended fourth electrode 20a.

Fig. 98 shows section A-A in Fig. 97.

Fig. 99 shows a partial back side (rear) view of the converter with the p$^+$ second conductivity type deflecting domains (3, 22p) and n$^+$ first conductivity type domains (22) and reverse side extended electrodes 17a and 20a.

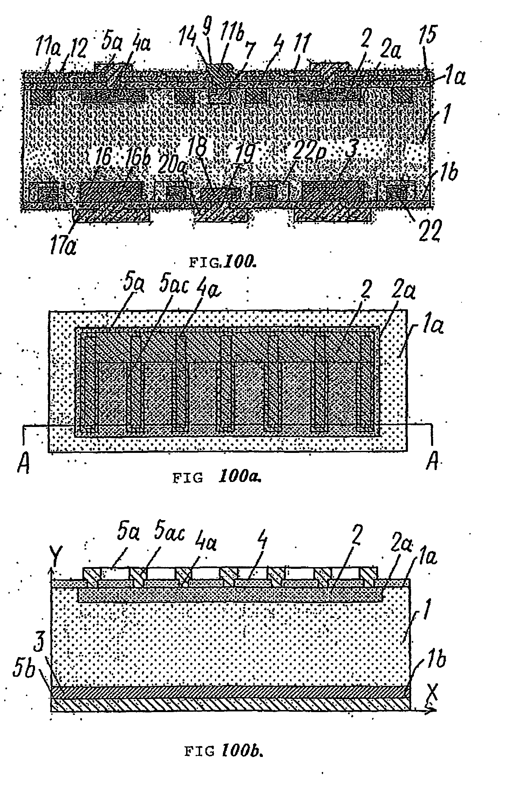

Fig. 100 shows section A-A in Fig, 99.

Fig. 100a shows a partial front side view of the bunched converter using the quadrature-axis and direct-axis components of diffusion current.

Fig. 100b shows section A-A in Fig. 100a.

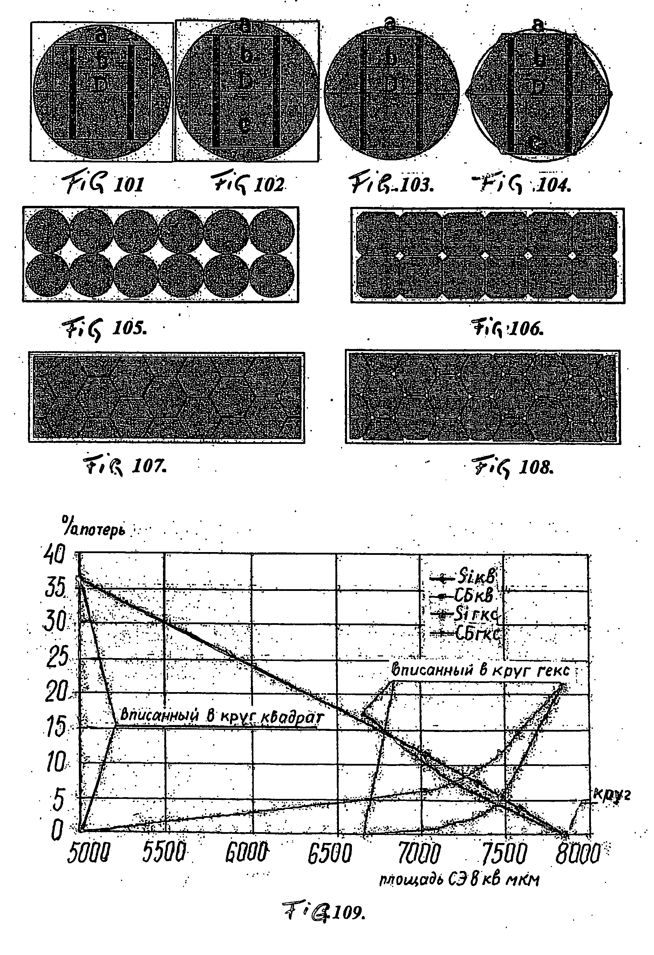

Fig. 101 shows a square.

Fig. 102 shows a pseudosquare.

Fig. 103 shows a hexagon.

Fig. 104 shows a pseudohexagon.

Fig. 105 shows a circular configuration of SC.

Fig. 106 shows a pseudosquare configuration of SC.

Fig. 107 shows a hexagonal configuration of SC.

Fig. 108 shows a pseudohexagonal configuration of SC.

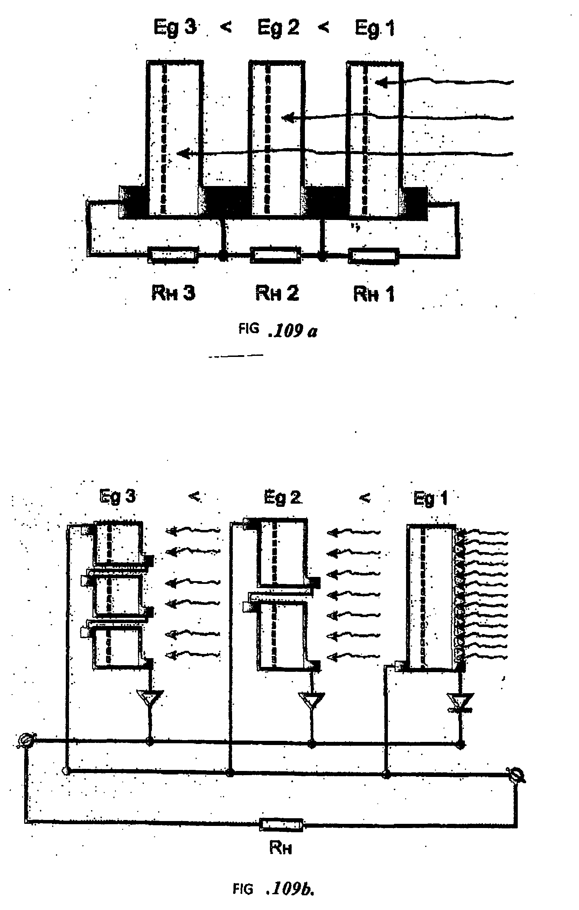

Fig. 109 shows the geometrical losses as a function of the solar cell area; losses in the wafer surface area due to cutting-out of a pseudosquare - Si sq, pseudohexagon - Si hex; losses in the wafer surface area due to pseudosquare configuration - SCsq, pseudohexagonal configuration - SChex.

109a shows a multistage battery diagram with a series connection of the transmission-type converters into an electrical circuit.

109b shows a multiple-stage battery diagram with a parallel-series connection of the transmission-type converters into an electrical circuit.

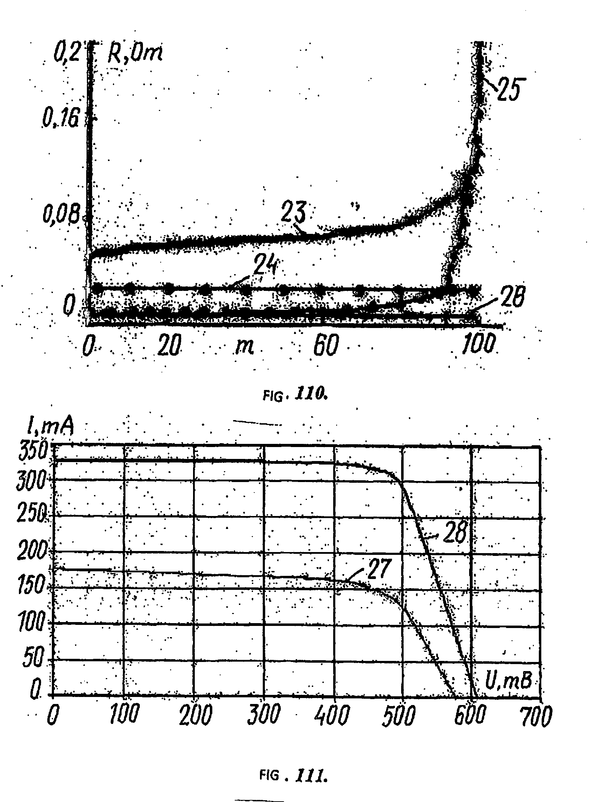

Fig. 110 shows statistical resistance distribution curves for the p-n junctions of the diode arrangements.

Fig. 111 shows a typical current-voltage characteristic of the control and inventive converters exposed to red radiation.

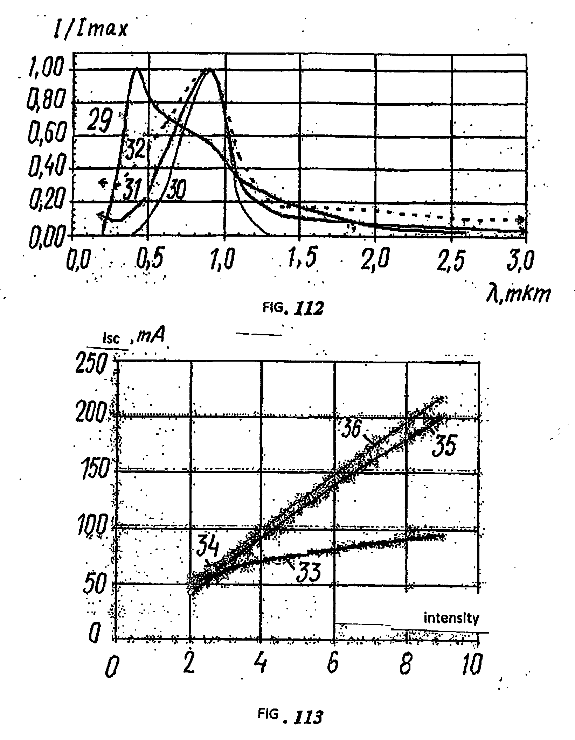

Fig. 112 shows the solar radiation spectrum AMO 0 (curve 29) and reduced spectral characteristics of the manufactured converters: 30 - for the control PEC with a continuous front side; 31 - for bunched diffusion converters according to the invention; 32 - for bunched diffusion-drift converters according to the invention.

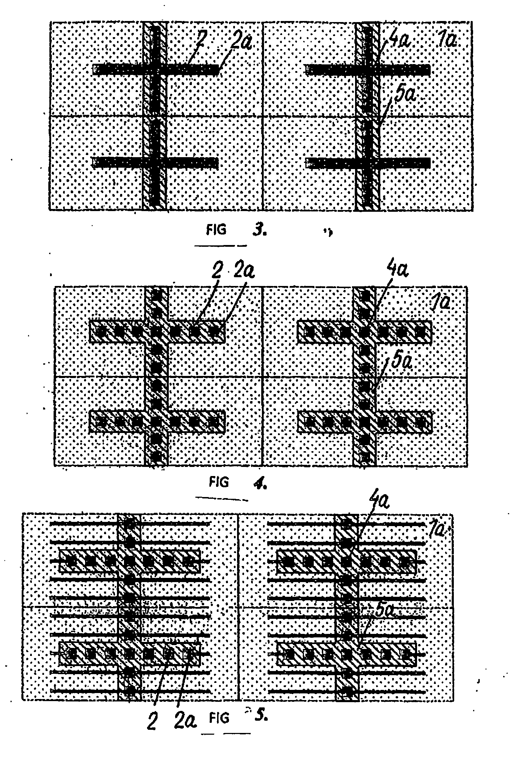

Fig. 113 shows the functions of the short-circuit current Isc for control (curve 33) and experimental specimens (curves 34-36): 33 - exemplary conventional control specimen with a continuous p-n junction, a current collecting bus of 200 $\mu$m in width, a distance between current-collecting buses of 2000 $\mu$m and metallization shading coefficient of 8.4%; 34 - specimen with a continuous current collecting layer according to the embodiment of Fig. 100a and 100b with current collecting buses of 18 $\mu$m in width, a distance between current-collecting buses of 200 $\mu$m and metallization shading coefficient of 8.2%; 35 - specimen with cross-shaped current collecting layers 2 according to the embodiment of Fig. 3 completely covered by metallization as shown in Fig. 4 with current collecting buses of 18 $\mu$m in width, a distance between current-collecting buses of 200 $\mu$m and metallization shading coefficient of 18.0%; 36 - embodiment of Fig. 3 with partially exposed discrete cross-shaped cells. The shading coefficient amounts to 8.2%.

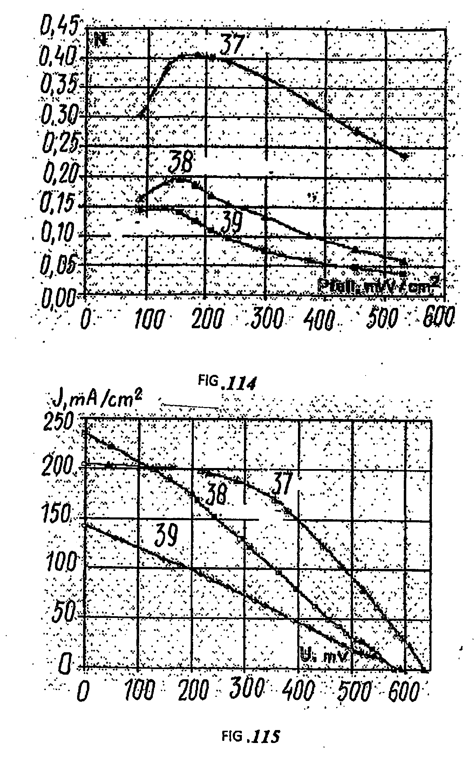

Fig. 114 shows the internal conversion coefficient as a function of the incident power for a discrete bunched converter.

Fig. 115 shows current-voltage characteristics under exposure to white radiation. The incident power amounts to 3000 W/m$^2$. The measured temperature is 70-80°C.

Fig. 116 shows the power curves in the white spectrum. The incident power amounts to 3000 W/m$^2$. The measured temperature is 70-80°C.

Fig. 117 schematically shows a T-shaped NeCC travel path in continuous single-junction PEC.

Fig. 118 schematically shows a $\gamma$-shaped NeCC travel path in bunched discrete PEC.

Fig. 119 shows a spectral response of the silicon solar cells based on pure silicon and "dirty'" technical silicon admixed with oxygen and other dopants.

Fig. 120 shows an example of the discrete bunched converter with two opposed current nodes: N discrete p-n junctions form a first current node for the current paths of the non-equilibrium charge carriers; second conductivity type discrete highly-doped depressed domains together with the isotype p$^+$-p junctions and discrete local contacts on the rear side form a second current node for the current paths of the majority non-equilibrium charge carriers.

Table 1: Optimum dimensions of the SC cut from a conventional wafer of 100 mm in diameter

Table 2: Values of resistance R, capacitance C, inductance L and quality factor Q of the bunched diode arrangements

Table 3: Characteristics of the SC according to the invention

In the drawing, the following elements are denoted by the respective reference numerals:

1 - substrate; a wafer made from any semiconductor material;

1a - front side (FS) (or front face);

1b - reverse (or shaded) side (RS);

2 - collecting n$^+$ cells;

2a - p-n junction;

2a - planar p-n junction emerging on the FS planar surface;

2b - mesaplanar p-n junction brought out onto the front side lateral surface formed by etching the Si substrate through the mask;

2c - FS n$^+$ connection element to the domains 2, a doped area for integrating the cells 2 without forming a p-n junction therewith;

3-1 - deflecting highly-doped domain with the same conductivity as that of the substrate;

p$^+$p - isotype junction with a basic domain;

3 - deflecting and collecting p$^+$ cell on the shaded side; a domain with the same conductivity as that of the substrate but with a higher doping level for providing current collection by the non-equilibrium majority charge carriers substrate reverse side;

3a - local deflecting p$^+$ domain with the same conductivity as that of the substrate, configured as discrete cells;

4 - dielectric; a dielectric layer transparent to the EMR;

4a - contact to the collecting n$^+$ cell 2; a window in the dielectric 4;

5a - first (first front or front side) electrode, Me (metal) to the FS n$^+$ layer 2; metal electrode to the cell 2 for providing contact with external electric circuits;

5ac - current conducting cell, current conducting circuit or bus;

5b - second (first shaded or provided on the shaded side) electrode, Me (metal) to the RS p$^+$ domain 3; metal electrode to the cell 3 for providing contact with external electric circuits; the shaded electrode may be continuous, or grid, or strip, or strip and grid;

5ab - switching (or connection) element of junctions in a multilayer converter;

6 - n$^+$ p$^+$ doping subdomains, an additional p$^+$ layer for increasing the contact potential difference of the p-n junction; additionally doped domains with a dopant concentration increased relative to the substrate;

7 - front side deflecting areas (p$^+$ layers); a second deflecting cell; converter areas with a high dopant concentration relative to the substrate, not forming p-n junctions with the substrate and not providing current collection of the non-equilibrium charge carriers;

8 - FS p$^+$ connection element to the areas 7, forming therewith a domain of the same conductivity type as that of the substrate; a doped area for integrating the cells 7 (13) without forming a p-n junction therewith;

9 - third Me electrode; a metal electrode to the cell 7 for providing current collection from the front side and a contact with the external electrical circuits;

10 - extended first Me electrode to the FS n$^+$ 2 for creating a deflecting field in the p-n junction domain 2a;

11 - deflecting field electrode above the collecting cell; extended first polysilicon Si* electrode above the collecting n$^+$ cell, having an electric contact with the electrode 5a for creating a deflecting field in p-n junction domain 2a and optionally made continuous; current conducting areas going beyond the collecting element 2 and p-n junction 2a and electrically coupled with the first electrode 5a;

11a - field electrode to n$^+$, optionally having an applied bias;

11b - field electrode to p$^+$, optionally having an applied bias;

12 - deflecting n$^+$ areas in the form of discrete heterogeneities;

13 - deflecting p$^+$ areas in the form of discrete heterogeneities;

14 - contact to the front side deflecting p$^+$ areas 7, a third electrode;

15 - dielectric above Si*;

16 - isolating dielectric;

16b - contact to p$^+$ 3 in the dielectric 16 in the for of local domains; a point contact to κ p$^+$ 3 in the dielectric 16 for reducing the recombination losses;

17 - second Me electrode to the RS p$^+$ 3 in the form of local domains; a second Me electrode to p$^+$ 3 optionally in the form of strips;

17a - extended second electrode for creating a deflecting field,

18 - collecting n$^+$ areas with a conductivity opposite to that of the substrate, forming a p-n junction therewith;

18a - RS connection n$^+$ cell to the areas 18, forming therewith a domain with a conductivity opposite to that of the substrate;

19 - contact to n$^+$ 18 in the dielectric 16;

20 - fourth Me electrode to n$^+$ 18 for providing current collection from the RS;

20a - extended fourth electrode for creating a deflecting field;

21 - FS microlens, a system of bulk-surface heterogeneities systems (SBSH);

22 - RS deflecting n$^+$ cells in the form of discrete heterogeneities;

22p - RS deflecting p$^+$ cells in the form of discrete heterogeneities;

23 - silicon converters with one p-n junction N = 1, each having an area S of 300 sq. μm;

24 - silicon converters with 100 p-n junctions N = 100, each having an area S of 300 sq. μm;

25 - silicon converters with one p-n junction N = 1, each having an area S of 30 sq. μm;

26 - silicon converters with 100 p-n junctions N = 100, each having an area S of 30 sq. $\mu$m.

PREFERRED EMBODIMENTS OF THE INVENTION

Manufacturing method

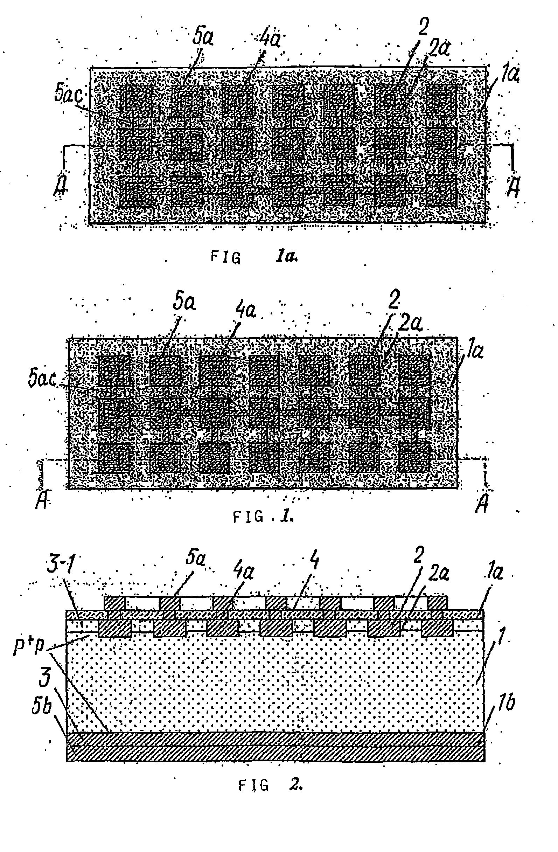

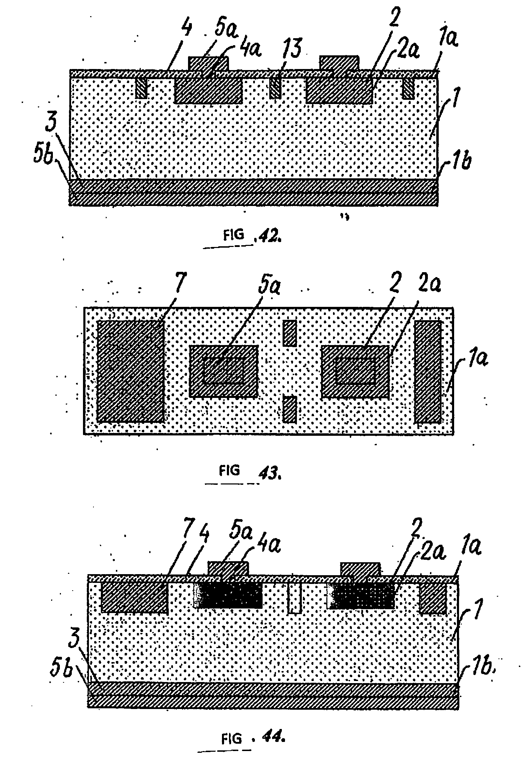

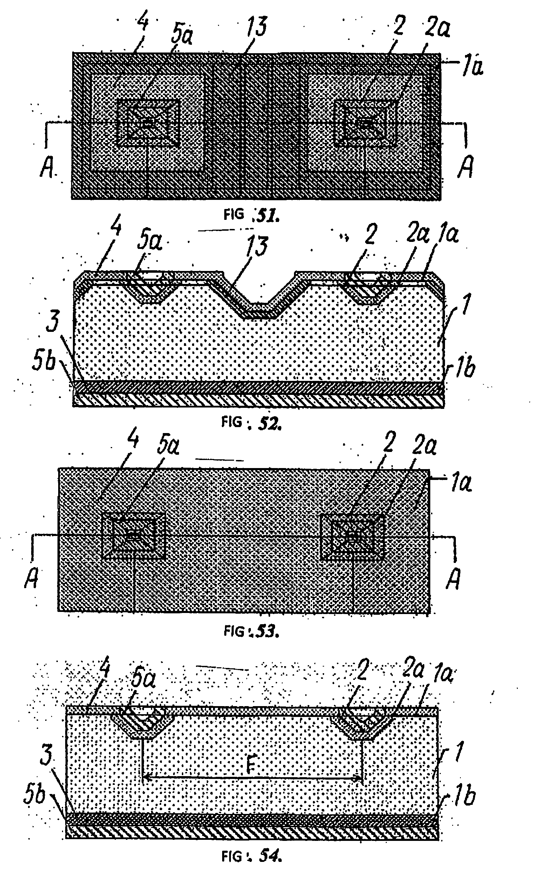

The converters may be manufactured using a conventional semiconductor technology and conventional semiconductor substrate materials according to the embodiments shown in Figs. 1-100b. For example. Figs. 1a, 1-2 schematically show a converter according to an embodiment of the invention. On the front side 1a of the planar substrate 1 for detecting the EMR flow (in particular, made from single-crystalline silicon with a conventional diameter of 100 mm and thickness of 270- 460 $\mu$m) and having p-conductivity due to embedding dopants (in particular embedding dopants of trivalent boron or other trivalent diffusant) or n-conductivity (due to embedding, in particular pentavalent phosphorous, arsenic, stibium or other pentavalent diffusant), by screen printing or other methods including but not limited to photolithographic methods (using photomasks) traditional for the semiconductor engineering, windows are exposed in the masking dielectric, for example $SiO_2$, for introducing therein a dopant creating a conductivity opposite to that of the substrate (first conductivity type) so that N first conductivity type collecting domains 2 are formed which are single-type in composition, size and other characteristics. These N separate single-type first conductivity type collecting domains 2 form N p-n junctions 2a. Depending on the design solution, the domains 2 may have different configurations: square, circular, hexagonal or any other. In Figs. 1a and 1, a discrete square configuration of the domains 2 with vanishingly small sizes is illustrated. The domains 2 are separated from each other by an oxide or other dielectric isolating layer 4, with traditional antireflection coatings being suitable for use as the same.

Furthermore, on the substrate front side above the domains 2, contacts 4a are exposed, for example, by a photolithographic method and the first electrodes 5a are formed with the current-conducting buses 5ac for providing contact with the external electrical circuit. Therefore, the first electrode 5a with the bus 5ac combines the p-n junctions 2a with N first conductivity type n-domains adjacent thereto into a single current node N.

On the reverse substrate side, the second conductivity type deflecting and collecting $p^+$ cell 3 is produced in the same manner, i.e., this is the domain with the same conductivity as that of the substrate but with a higher doping degree for providing current collection of the non-equilibrium majority charge carriers on the reverse substrate side; adjacent to the collecting cell 3 the second electrode 5b is arranged, which is produced by sputtering, chemical deposition or silk-screening techniques and is optionally made continuous, strip, grid or strip and grid.

Diffusion-drift converters comprise semiconductor devices for converting the EMR into the EMF, which differ fundamentally from the prior art in that a "break-off layer" is provided on the front side thereof and, furthermore, their front side, bulk and reverse side represent a system of surface-bulk heterogeneities (SSBH) combined into current nodes. As noted above, all prior art PECs are based on the effects of the current diffuse component, whereas the inventive PECs are based on the two components - diffuse and drift so that the power conversion efficiency of the SC is substantially improved.

As already noted above before, all arguments being produced apply to any p- or n-conductivity type semiconductor (Ge, Si, GaAs, and the like), however, due to a difference in the mobility of $h^+$holes and $e^-$ electrons, p-conductivity type silicon-based PEC are discussed herein. The bunched converters according to the invention discussed below are divided into the diffusion and diffusion-drift ones, which in turn are divided into subgroups with different designs and configurations of the cells on the converter front and rear sides.

Example 1. Bunched diffusion converters, front side.

1.1. Discrete diffusion converters

The electromagnetic radiation converter (Figs. 1a and 1) has, on its illuminated (face, front) side 1a of the second conductivity type p-semiconductor substrate 1 (base), second conductivity type local (discrete, small in linear size) collecting $n^+$ domains 2 separated from each other by a dielectric layer and together with the substrate forming the p-n junctions 2a, the so called conversion zones wherein separation of charges takes place so that a contact potential difference is formed. The first collecting conducting electrode 5a is connected to the first conductivity type collecting domains in abutting relation thereto. The first (front side) current collecting conducting electrode 5a integrates the first conductivity type collecting domains 2 into a parallel electrical circuit and a bunch, i.e., a single current node (all inventive converters are bunched converters based on such feature). The electrode 5a conducting buses are isolated from the substrate by the dielectric layer 4.

On the reverse (rear) side, the doped deflecting $p^+$ domain 3 is formed with the second (rear side) current collecting conducting contact, i.e., electrode 56 (Fig. 2) adjacent thereto, which is optionally shaped as a comb or grid with a single current node for further reducing the resistance.

Therefore, the first conductivity type collecting $n^+$ layer in such converter is not continuous but is configured as continuity break-offs, i.e., alternating $n^+$ and $p^+$ discrete small-sized domains, with the exposed optical windows remaining on the front side 1a, i.e., second (basic) conductivity type $p^+$ domains (shown in the drawings as 3-1) forming the EMR transmission zones and providing access to the converter bulk for the incident radiation including the short-wave part. The formation of the shading zones under the n$^+$ domains 2 and the first electrode 5a is insignificant since, due to insignificant shading size, electromagnetic wave edge diffraction occurs and, on the other hand, small shading zones result in the concentration gradient increasing and being directed towards the collecting domains 2 so that charge separation, i.e., the diffuse component of current is activated.

Each first conductivity type collecting cell 2 may be transformed into a separate current node by means of differentiation. Node derivatives may also be differentiated up to the resolution limits of the state-of-the-art lithography. The higher the differentiation level, the higher the PEC efficiency.

The collecting cells 2 and their combinations into the current nodes may have various configurations. Fig. 3 illustrates the collecting cell 2 wherein the n$^+$ domain partly goes beyond the metallization 5a and forms no shading zones, particularly for the short- and long-wave radiation.

Fig. 4 shows a discrete configuration of the collecting cells 2 combined into the current nodes through metallization 5a. Insignificant shading zones are compensated for both by the EMR diffraction given the small dimensions of the metal bus and by a high MCC concentration gradient and reduction in the internal resistance at the expense of small discrete values of the p-n junctions combined into a single current node of the first conductivity type domains adjacent thereto, standardization in sizes and configuration, as well as an increase in the number N $\rightarrow\infty$ of collecting domains.

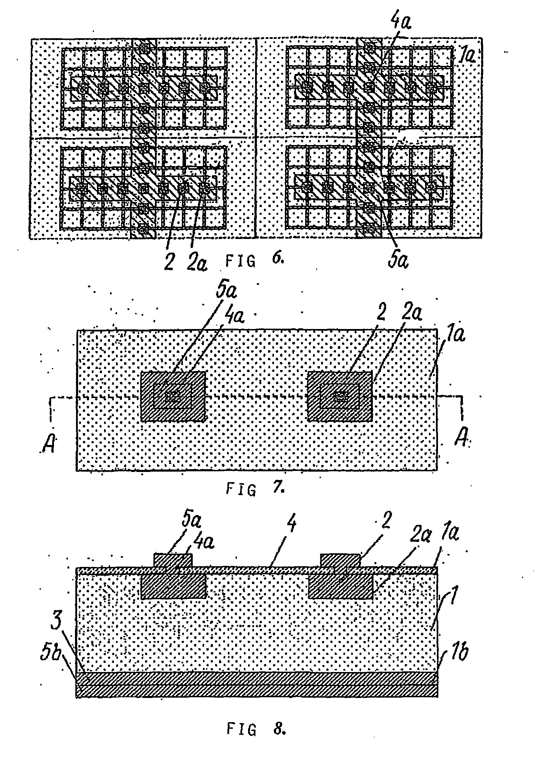

The current collecting domains and the electrodes connected thereto may have different configurations. Fig. 5 illustrates a discrete strip configuration of the collecting cell. Fig. 6 illustrates a discrete grid configuration of the collecting cell wherein the p-domains on the front side of the semiconductor substrate also become local.

Such cells may be combined not only through metallization but also by any known methods including but not limited to using transparent current conducting materials, for example, polysilicon or TCO, or ITO.

In the general case, the bunched discrete converters comprise a system of the surface-bulk heterogeneities (SSBH) having various different purpose cells.

In the following, only parts of the PEC cells with two elemental p-n junctions are shown for simplicity. However, the semiconductor substrate may in general comprise a sufficiently large number of these junctions: N $\geq$ 1 (preferably N >> 1 and N $\rightarrow \infty$) combined by means of the connection buses or cells 5ac into a current node with the adjacent current collecting domains. For simplicity, Figs. 7-100b do not show their combination into current nodes through the connection buses 5ac or the planes of the front side electrodes 5a.

Furthermore, it is understood in the following that in the structures according to the invention the distances between the current collection cells are commensurable to the diffusion length of the non-equilibrium charge carriers.

The converters may be formed both on the thin wafers of less than 70 $\mu$m in thickness with a smooth or rough surface and on the massive smooth or textured wafers of more than 70 $\mu$m in thickness, for example, conventional wafers of 300-450 $\mu$m in thickness. For simplicity, the surface texture is not shown in the drawings. The wafer thickness is dependent on the converter structure.

Massive wafers of more than 70 $\mu$m in thickness are suitable for use in the diffusion-drift double-sided converters.

1.1.1. Discrete diffusion monolayer converters

1.1.1.1. Surface (planar) PEC

The converters of this type have a collecting cell in the form of a single layer formed in the semiconductor substrate. The converters of this type are simple to manufacture and highly efficient as compared to the existing conventional converters with a large continuous front side. The cells of a planar discrete diffusion converter are shown in Fig. 7 (top view) and Fig. 8 (section A-A). On the front side 1a of the semiconductor wafer, first conductivity type domains 2 are created by mask doping and bringing the p-n junction 2a out onto the front side of the second conductivity type semiconductor substrate. For simplicity, the collecting cells will be hereinafter shown schematically and may have various shapes and configurations.

1.1.1.2. Connection elements in PEC

Given a high packing density of the collecting cells, the extent of shading of the converter surface increases so that it may result in an impaired efficiency thereof. It is proposed to prevent the same with a combination of domains serving as collecting domains but at the same time not preventing the radiation from penetrating the converter bulk.

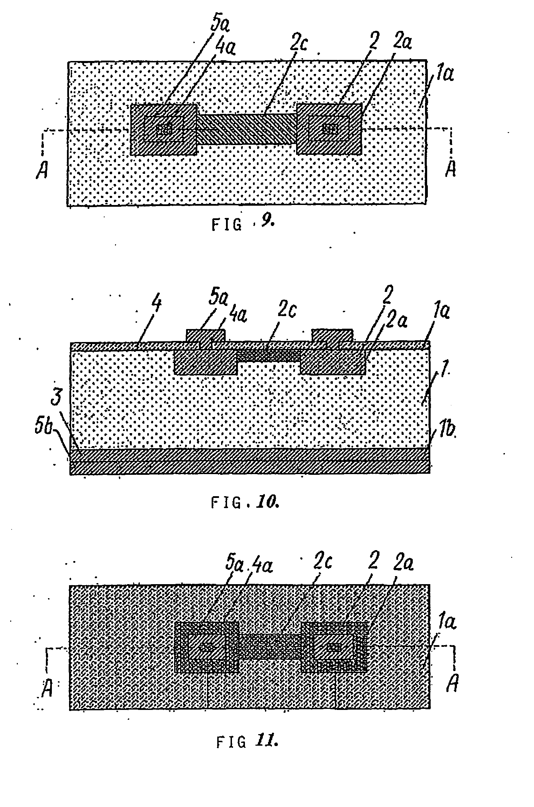

As shown in Figs. 9-10 (planar embodiment) and 11-12 (mesaplanar embodiment), the collecting cells 2 are connected to each other with a continuous shallow lightly-doped domain 2c with the same conductivity, representing a connection element, not coated with metallization, i.e., transparent to the external radiation.

Such domain creates an insignificant extent of shading so that, on the one hand, the luminous flux through the PEC increases and, on the other hand, the internal resistance defined by the depth and doping extent of the cell 2 remains low. The connection elements may have an arbitrary configuration, for example, strip or grid or hexagonal or other configuration. In the latter case, its depth and doping extent is of no fundamental importance since it does not influence the converter's absorption and converting capacity.

The connection elements may have various configurations and extension.

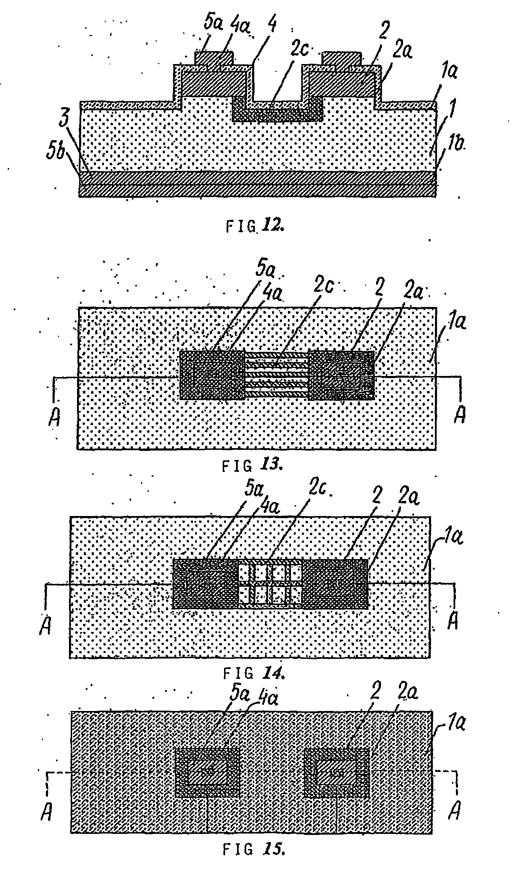

Figs. 13-14 show the strip and grid configurations of the connection elements. In the latter cases, as in the examples of the discrete collecting cells, their depth and doping extent is of no fundamental importance.

These elements may be supplemented with the deflecting cells.

The converters of such type are not structurally limited to the planar configuration and may be implemented as mesaplanar and combination converters.

### 1.1.1.3. Bulk (mesaplanar) PEC

Figs. 15-16 show bulk (mesaplanar) converters wherein the p-n junctions 2a with the adjacent current collecting domains are brought out from the semiconductor substrate bulk to the outside into the EMR direct impact zone onto the front and lateral surfaces of the converter front side. To this end, after continuously or locally doping the front side 1a, a mask is created for etching through the same the semiconductor from the front side in such a way that the p-n junctions form an angle with the lateral surface of the front side. As a result, the EMR impact area substantially increases. Therefore, in the bulk mesaplanar embodiments of PEC, the EMR-sensitive effective area substantially increases so that the total quantum absorption and the EMR conversion efficiency increase. Changing from planar to bulk converters makes it possible not only to increase the absorption surface by creating a regular structure but also to optimize the domain thicknesses and the MCC diffusion lengths by guiding and improving their collectability.

### 1.1.1.4. Combination PEC

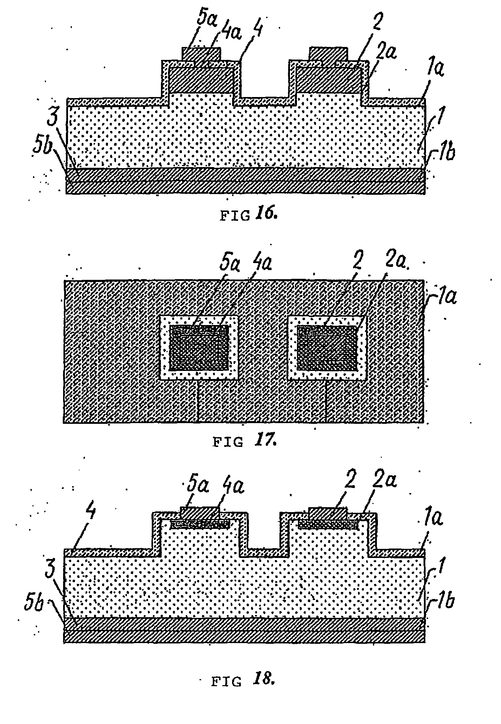

Figs. 17-18 show a combined converter wherein the p-n junctions 2a are brought out from the semiconductor substrate bulk to the outside onto the front surface of the converter front side: after locally doping the front side 1a, a mask is created for etching through the same the semiconductor surface beyond the doped domains. In such converters, the EMR-sensitive effective area (as in the previous PEC embodiment) increases at the expense of vertical depressions. These depressions may have any configuration, for example, pyramidal.

### 1.1.1.4.5. PEC with strip-grid collecting cells

In the previous embodiments, the first conductivity type collecting cells 2 were configured as the doped domains with small discrete values, combined into current nodes through the external elements in the form of metallization or internal elements in the form of connection domains. These embodiments are technologically complicated and suitable for superefficient special-purpose converters.

More technologically simple converter designs are discussed below. Their external elements have various configurations so that a high efficiency is ensured at the expense of the current node and extension of the absorbed EMR spectrum both towards the red shift and violet and x-ray regions.

Figs. 19-30 show a planar converter with a grid collecting cell.

Figs. 19-20 show a planar grid converter.

Fig. 21 shows a planar strip converter.

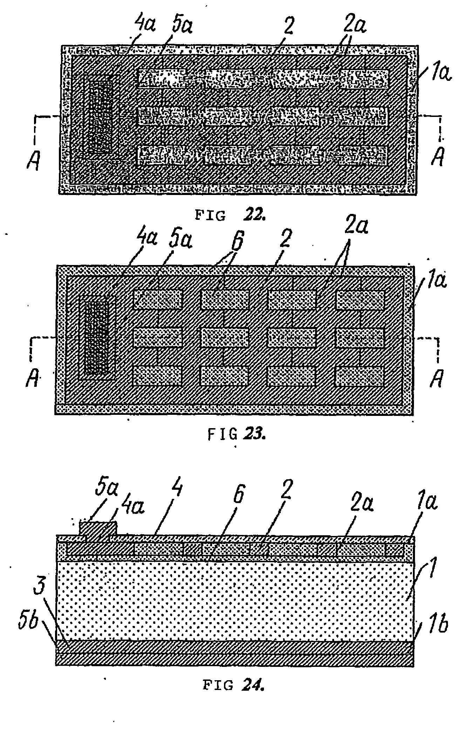

Fig. 22 shows a combination planar strip-grid converter.

The strip-grid converters may have not only a monolayer but also a multilayer structure (as further discussed below with reference to multilayer converters).

Figs. 23-24 show an embodiment of the planar grid double-layer converter.

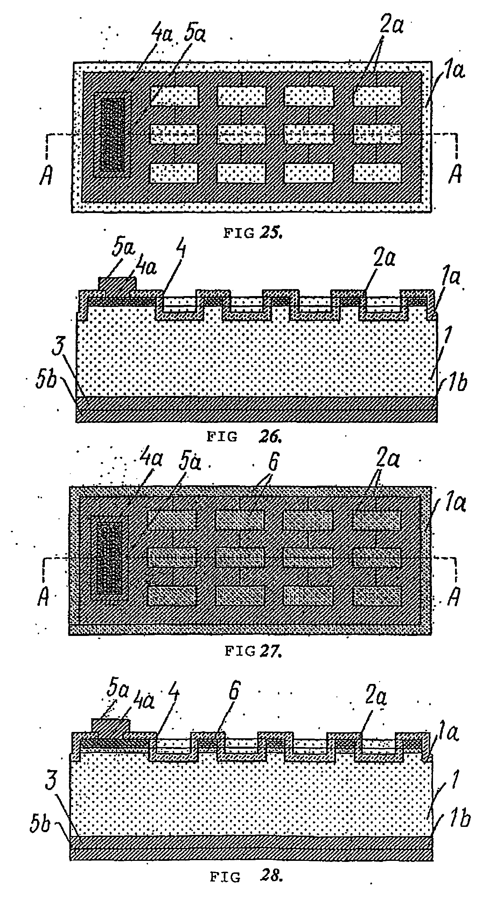

Figs. 25-26 show an embodiment of the mesaplanar grid monolayer converter.

Figs. 27-28 show an embodiment of the mesaplanar grid double-layer converter.

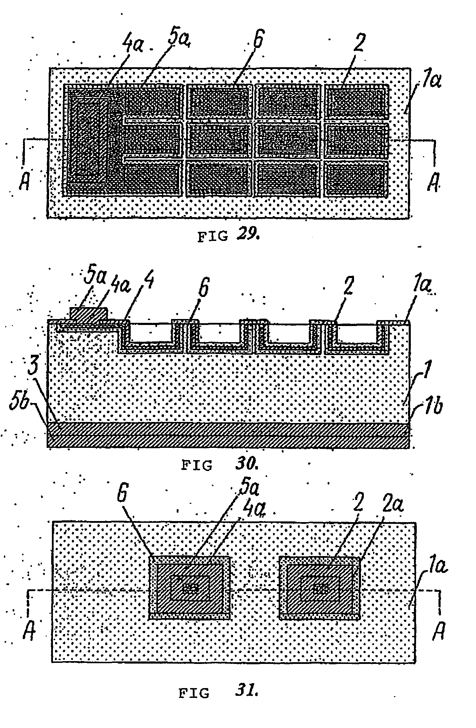

Figs. 29-30 show an embodiment of the combination grid double-layer converter with a collecting cell in the form of depressions.

For improving their efficiency, the strip-grid converters may be supplemented with the first and second conductivity type (or a combination thereof) deflecting cells (as further discussed below with reference to converters with deflecting cells), as well as field electrodes similarly to the above discussed converters.

### 1.1.2. Discrete diffusion multilayer converters

The converter open-circuit voltage may be achieved by increasing the contact potential difference at the expense of creating highly-doped $n^+p^+$ junctions in the collecting cells. At the same time, due to their discreteness, an additional doped layer does not form an optical barrier to the short-wave spectral domain.

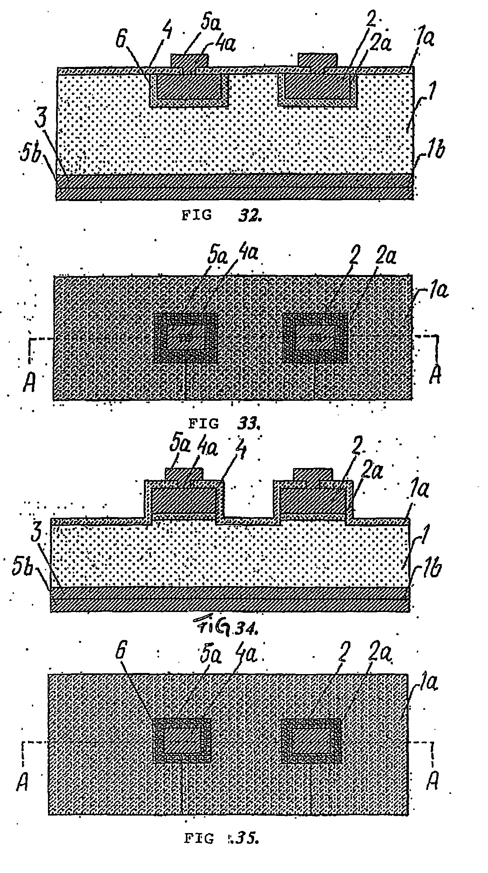

An example of the converter with $n^+p^+$ junctions is shown in Figs. 31-32 (planar configuration) and Figs. 33-34 (mesaplanar configuration), wherein the additional doped sublayer 6 is formed.

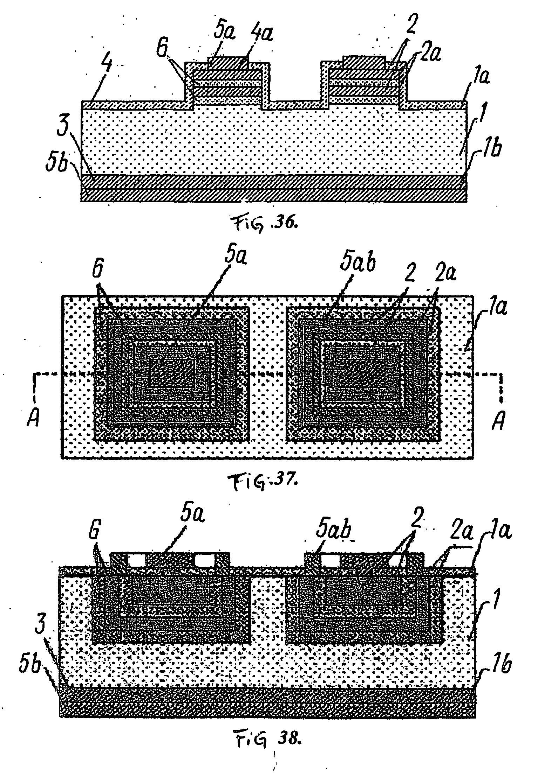

Figs. 33-34 show a double-layer diffusion converter; Figs. 35-36 show a multilayer diffusion converter. By successive doping, a sequence of layers is formed wherein each pair, when switched progressively (a potential multiplier is formed in the PEC structure), increases the open-circuit voltage approximately by the contact potential difference, and when switched in parallel, current is multiplied approximately by the number of layers in the stack. An example of the multilayer planar converter with a switching (connection) 5ab of the sublayer junctions is shown in Figs. 37-38.

Multilayer converters either with or without switching of junctions is implemented in the design of the previously described mesaplanar and combination converters.

1.1.3. Discrete diffusion converters using deflecting electrical fields

One of the methods for improving the power conversion efficiency of the converters is to create a directional motion of the MCC by forming additional built-in fields. To this end, doped domains with different (n$^+$ or p$^+$) conductivity types may be used, not coupled electrically with the collecting cells and forming additional built-in internal fields.

1.1.3.1. Converters using first conductivity type deflecting cells

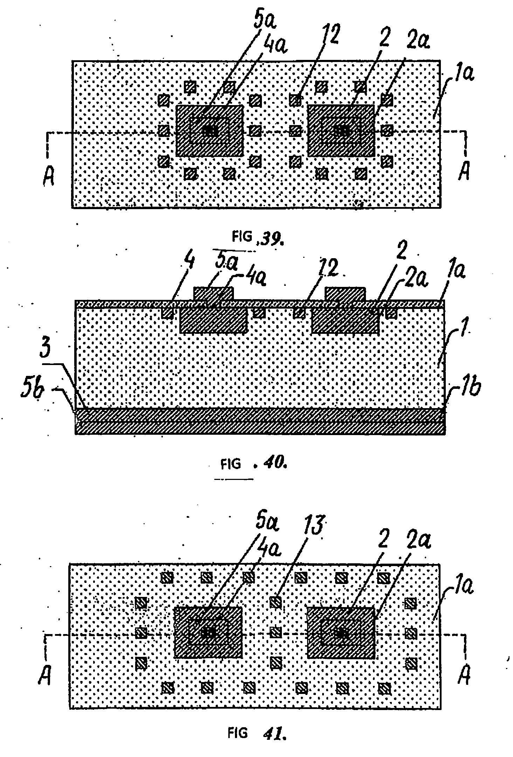

When local domains 12 of the same type as the first conductivity type (n-conductivity, Figs. 39-40) collecting cell 2 are formed in, for example, the p-conduetivity type substrate, local p-n junctions are obtained. The MCC formed on exposure to the EMR will be deflected under the influence of the SCR p-n junctions in the direction of the collecting cell. Single-type deflecting cells may also bee included in the SBSH of the mesaplanar and combination monolayer and multilayer converters. These cells may have various shapes and configurations.

1.1,3.2, Converters using second conductivity type deflecting cells

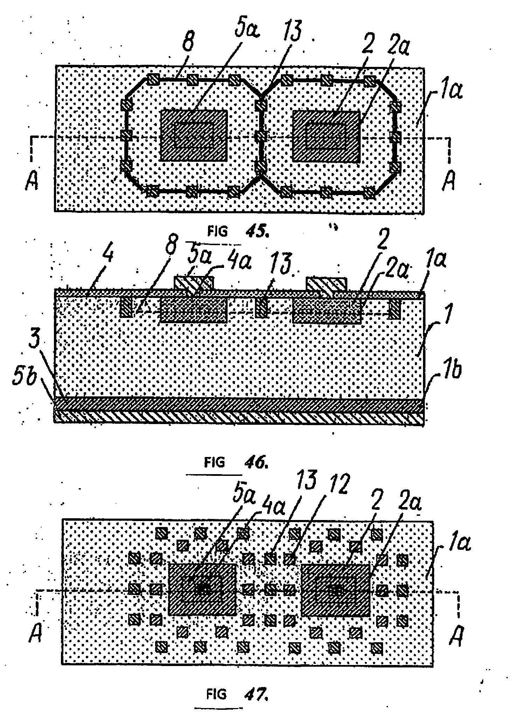

When local domains 13 of the same type as the first n-conductivity type (Figs. 41-44) collecting cell 2 are formed in, for example, the second p-conductivity type substrate, local doped domains are obtained acting similarly to the reverse side repulsive domains 3.
Second conductivity type deflecting cells may also be included in the SBSH of the mesaplanar and combination monolayer and multilayer converters. These cells may have various shapes and configurations. They may also be combined into a circuit by means of connection elements 8 (Figs. 45-46).

1,1.3.3. Converters using combination deflecting cells

Figs. 47-48 show an embodiment of the local combination deflecting cells consisting of the first and second conductivity type cells, Such combination forms a combination of the built-in fields which create the SBSH and contribute to an efficient separation and collection of the MCC in the converter.
Combination deflecting cells may also be included in the SBSH of the mesaplanar and combination monolayer and multilayer converters.
These cells may have various shapes and configurations. They may also be combined into a closed circuit.

1.1.4. Discrete diffusion converters using quantum traps

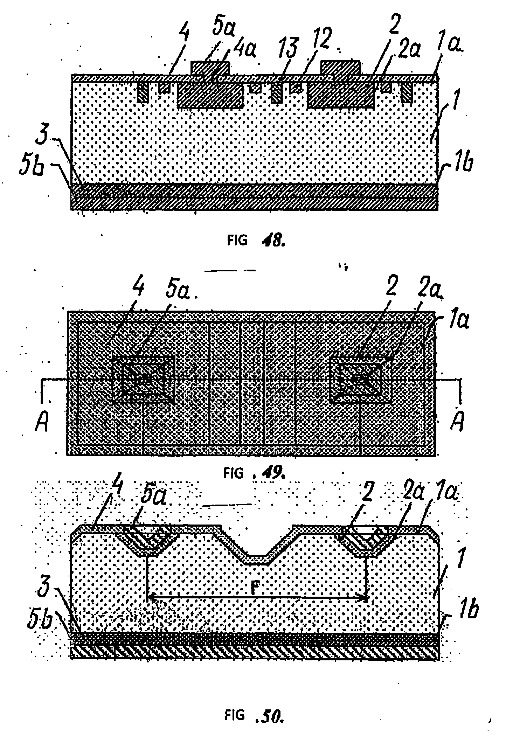

Figs. 49-56 show combination converters with deep pyramidal (any configuration is possible, for example, square-shaped as shown in Figs. 57-60) depressions (with the truncated pyramid vertex directed downwardly) wherein the p-n junctions 2a of the first conductivity type domains are brought out onto the internal lateral surface of the pyramidal textures. The current collecting electrodes 5a are disposed adjacently to the surfaces of these first conductivity type domains arranged throughout the trap depth to ensure thereby collection of current from the bottom of the converter substrate and elimination of the surface and bulk recombination. The current collecting electrodes may be made from an optically transparent or non-transparent conducting material.
Between the pyramidal depressions of the first conductivity type domains, at a distance of F, the pyramidal depressions of the second conductivity type domains are disposed. Therefore, the depressions on the converter front side comprise a kind of quantum traps which capture the quantum energy and convert it into the EMF.
The depressions are arranged on the FS in such a manner that the first conductivity type domains and the second conductivity type domain alternate at intervals or in increments of F between them. Due to such configuration, the depth and area of penetration of the high-energy short-wave part of the EMR spectrum into the semiconductor substrate is increased. At the same time, the quantum trap depth ensures that the short-wave quanta are captured within the converter bulk. The deeper the quantum traps, the more short-wave high-energy quanta are captured by the converter bulk and the more the number of the generated MCC and the PEC efficiency.

1.1.5. Converters using second conductivity type deflecting domains и third current collecting electrode

In addition to creating the built-in repulsive fields, the second conductivity type deflecting cell may act as a front side current collecting electrode as shown in Figs. 61-62. In this connection, the p$^+$ domain may have an arbitrary configuration and continuity. In this case, the third (or second front side) current collecting electrode contributes to an efficient collection of the non-equilibrium carriers formed by the short-wave spectrum part in the subsurface converter domain. Given a certain combination of fields of the interrelated deflecting cells, an potential opposite in sign emerges, which reaches 10 volts and more and by means of switching may be brought out onto the second front side electrode. Thereby, the open-circuit voltage and maximum power of the converter increases.
In this case, the second current collecting electrode on the front side contributes to an efficient collection of the MCC formed by the short-wave spectrum part in the subsurface converter domain.

1.1.6. Discrete diffusion converters using field cells

The converter field electrodes are intended for deflecting the MCC from the semiconductor surface where they may actively recombine, to the collecting cells.

Figs. 63-64 show a field electrode configured as an extending beyond the p-n junction part 10 of the metal electrode 5a to the collecting cell. Having the same potential as the cell 2, such electrode deflects the MCC from the surface to prevent thereby their recombination.

Figs. 65-66 show a similar field electrode 11 having a contact with the electrode 5a and made from a material transparent to the EMR, for example, polysilicon or ITO, whereby the converter shading domain reduces.

As shown in Figs. 67-68, the field electrode 11 is configured as a continuous transparent domain having an ohmic contact with the collecting domains and current collecting electrode 5a. In this case, the electrode also performs the functions of the current collecting electrode.

The field electrode may overlap both the first and the second conductivity types, and the combination deflecting cells (Figs. 69-70).

### 1.1.7. Discrete diffusion converters using field cells along the perimeter of collecting domains

In the examples of the converter given above, the first electrode contact the collecting cell in the central part thereof.

As shown in Figs. 71-72, the first electrode is arranged around the periphery (along the perimeter) of the first conductivity type collecting cell 2 to form a deflecting field electrode.

The first conductivity type collecting domain 2 itself may be non-continuous as shown in Figs. 73-74 and supplemented with single-type and/or different-type deflecting cells. Furthermore, such converter may also be configured as a multilayer structure.

The collecting cells 2 may have various configurations.

Figs. 75-76 show an embodiment of the exposed collecting cells 2 whose central parts are free from the $n^+$ layer and comprise a window for the short-wave radiation.

Figs. 77-78 show the embodiments of the strip and grid collecting cells 2.

### Example 2. Bunched discrete diffusion-drift converters. Front side

In the above discussed converters, only the diffuse component of current is used. By creating an external field with an additional electrode, the discrete converters make it possible to implement a more efficient drift component of current unlikely the converters with a continuous collecting layer, wherein the action of the drift electrode field is shielded by a highly-doped layer.

Figs. 79-80 show an example of the diffusion-drift converter. The drift electrode 11a is configured as an optically transparent conducting layer isolated from the converter front surface 1a by the dielectric layer 4 and from the current collecting conducting buses of the first electrode - by the dielectric layer 15. When an appropriate displacement current is applied to the electrode 11a, the electrical field not only defects the MCC from the surface but also imparts thereto an additional drift component of current.

Single-type (Figs. 81-82), different-type and combination (Figs. 83-84) deflecting cells creating the internal built-in fields may be used in the diffusion-drift converters.

The drift electrode may be separated into areas 11a and 11b not coupled electrically to each other in such a manner that each area is arranged above the deflecting cells of a certain conductivity type (Figs. 85-86).

By creating contacts to the deflecting cells 7, the second drift electrode 11b may function as a second front side current collecting electrode (Figs. 87-88).

Various configurations and numbers of the drift electrodes may be used, with a separate potential being applied to each for creating an accelerating field in the direction of the collecting cell. The drift electrodes may be included in all above discussed embodiments of the converters.

### Example 3. Bunched microlens diffusion-drift converters. Front side

In the above discussed converters, the system of bulk-surface heterogeneities was formed by localization of the collecting cells, introduction of the deflecting cells in the form of local doped areas, formation of the field and и drift electrodes.

A change in the MCC concentration gradient in the converter may be achieved by providing optical heterogeneities on the front side by means of creating shading zones nearby the collecting cells, surface texturing or locally etching the same as in the case of the previously discussed mesaplanar bulk (substantially increasing the converter exposed area) and combination converter designs.

In this embodiment, it is proposes to form optical heterogeneities using microlenses or other optical devices, for example, microprisms for concentrating or redirecting the EMR rays. Microlenses (microprisms) may be used in combination not only with any of the above discussed converter cells but also in the traditional converters; redirecting the optical path of the rays, they contribute to an increase in the EMR concentration in the semiconductor and to localization of the generation process even under a homogenous continuous collecting layer so that a single-junction converter becomes a bunched converter.

Fig. 89 shows an example of the diffusion converter with a focusing lens 21 arranged above the extended part of the first front side electrode 5a. In this case, a maximum of the MCC concentration falls on the radiation focusing domain. The intensity of the whole EMR spectrum in the focusing domain increases steeply, especially the intermediate and far infrared radiation domains. The microlens areas overlapping the metallization 5a serve to direct the concentrated high-energy rays (i.e., a bunch of rays or a bunch electromagnetic waves) to the absorption zone (schematically shown by arrows in Figs. 89-90) whereby the shading zone formed by metallization is reduced to zero.

Fig. 90 shows an example of the diffusion converter with the focusing lens 21 redirecting the path of rays in such a way that the MCC will be generated in close vicinity to the collecting electrode 2 whereby the diffusion length and, hence, the recombination losses are cut down.

Microlenses (microprisms) may be used in combination with any of the previously discussed converter cells.

In the converted design discussed above, a classic continuous embodiment of the second shaded electrode was implicitly assumed to be used. As an alternative, in order to Further reduce the bulk resistance, instead of the continuous shaded electrode according to the present invention an electrode in the form of fine grids or thin strips (combs) or fine strip-grid shapes is used, also having as junctions a single current node on the front side. An example of the current nodes is shown in Figs. 1a-16. An example of the strip-grid shape configuration is shown in Figs.77, 78. The cutouts on the shaded electrode may have any shape, for example, not only strip but also circular, polygonal or others.

Example 4, Double-sided bunched diffusion-drift converters, Rear side

In contrast to the above described designs, the embodiments of converters using cells on the front and rear sides will be described herein below. At the same time, in any of the following embodiments, the same techniques may be used as those used in all previous embodiments on the front side. The use of both (front and shaded) sides of the semiconductor substrate enables the diffusion and drift components of current to be used to the full extent and the MCC recombination to be completely eliminated both on the front surface and within the volume and on the reverse side of the converter whereby the PEC power conversion efficiency will be substantially improved in an unpredictable manner. Any structure and cells of the front side shown in Figs. 1-90 may be used as a basis for the double-sided converters. In Figs. 91-92 and hereinafter, a front side structure is used taken from Figs. 87-88. A feature of the double-sided converters is that depending on the design up to four opposed current nodes are formed therein at the expense of a parallel connection of the collecting-deflecting cells. In order to upgrade and diversify the PEC, any cells or front part of the structure or a combination thereof from Figs. 1-90 may be used and brought to the reverse side.

The converter shown in Figs. 91-92 is a modification from the front side of the converter of Fig. 88 but with the difference that instead of the continuous highly-doped deflecting $p^+$ layer 3, deflecting discrete $p^+$ areas 3 are disposed on the reverse side, electrically coupled with the electrode 5b be means of the point contact 16b. Between the continuous second electrode of the rear side and the deflecting $p^+$ areas, a dielectric intermediate layer 16 is disposed with depressions provided at the point of contacts with these deflecting domains. Such converter design allows the bulk and surface charge recombination on the reverse (shaded) side to be reduced. The continuous metallization of the shaded side 5b contributes to the radiation reflection back to the converter bulk whereby the sensitivity in the long-wave spectrum part is improved, especially in case of the bulk converters when at the expense of the total internal reflection from the front side the radiation returns back to the semiconductor bulk.

The combination of these effects makes it possible to change to superfine substrates.

Figs. 93-94 show a diffusion-drift converter with local (non-continuous) strip metallization of the rear side 17 making it possible to use the same as a double-sided converter. Non-continuous metallization may also be used in the converters with a continuous deflecting electrode. In this embodiment shown in Figs. 85-86 (sectional view and rear view), the continuous electrode 5b is replaced with the strip electrode 17 configured as narrow extended strips 17. The metallization 17 should not necessarily follow the electrode 3 configuration and may have any configuration including but not limited to strip, grid or comb. Between the strip electrodes 17 и deflecting areas, the dielectric intermediate layer 16 is disposed with partial depressions (openings) at the points of contact of the electrodes with the deflecting areas 3. Such design ensures a high efficiency in reducing the recombination of charges in the bulk and subsurface layer of the shaded side.

For an efficient collection of the NeCC, the rear current collecting cell 18 to which the fourth (or second shaded) current collecting electrode 20 is in contact through the window 19 in the dielectric 16 may be used in rear side domain. An example of such converter is illustrated in Figs. 95-96. The current collecting cells 18 and the deflecting domains 3 may have connection domains 18a and 3a. Metallization may be provided in the form of extended deflecting electrodes 20a and 17a.

In the embodiment shown in Figs. 97-98, collecting $n^+$ areas 18 are additionally provided on the converter reverse side to which the fourth (or second shaded) electrodes 20 ensuring current collection from the RS are adjacent through the contact 19 whereby the power conversion efficiency of the converter is still further improved.

In the embodiment shown in Figs. 89-90, extended second electrodes 17a and extended fourth (or second shaded) electrodes 20a are provided. The extended electrode further eliminates the recombination of charges in the vicinity of the n$^+$ p$^+$ zones. Furthermore, n$^+$ areas 22 are additionally provided on the rear side in this embodiment. The efficiency of such converter is further improved by an order of magnitude greater.

The embodiment show in Figs. 91-92 comprises a combination design wherein the deflecting p$^+$ cells 22p are further provided on the rear side.

In the embodiment shown in Figs. 99-100, the discrete deflecting p$^+$ areas 3 are connected into extended strips through the connection element 3a with the same conductivity as that of the deflecting areas 3 themselves. This converter design a still further enhanced reduction is achieved in recombination of charges in the bulk and subsurface layer of the converter shaded side.

Other combinations with the deflecting discrete or continuous p$^+$ or n$^+$ areas of the front and rear sides are possible, which also ensure high power conversion efficiency and are within the scope of the invention.

Example 5. Bunched diffusion-drift converters using
built-in radiation sources. Shaded side and front side.

The converters using the built-in sources have the above described exemplary converter designs presented in Figs. 1-100 with the difference that a layer or areas with the sources of additional radiation are built therein by any known method, in particular a radioactive radiation source (RRS) may be used.

The RRS may be, for example, applied onto the current collecting layer or the dielectric 15, 16 of the converter, for example, as shown in Fig.100. Radiation sources include low-level radioactive preparations currently used in medicine and biology. The converters with built-in radioactive radiation sources will operate for a long time and the working time of such converters is dependent on the amount of the built-in preparation. For example, the use of preparations based on strontium-90 with a half-life period of 27.7 years will make it possible to operate the converter freely for 100 years.

Example 6, Bunched converters using quadrature-axis
and direct-axis components of diffusion current

The currently available converters have the current collecting buses 5ac of up to 150-250 $\mu$m in width spaced apart at intervals or in increments of 2-3 mm. At the same time, the layer-by-layer concentration gradient along axis X is in practice constant so that the diffuse component of current is dependent on a change in the concentration along axis Y and on the domain 2 field (i.e., is dependent on the quadrature-axis component of diffusion current) and is directed along axis Y (Figs. 100a and 100b), The quadrature-axis component of diffusion current is proportionate to the illuminated surface area and its value is limited by this surface. Meanwhile, artificially creating and initiating the direct-axis component whose value may be far in excess of the quadrature-axis component of current, will further contribute to an increase in the converter total current.

To this end, in the embodiment shown in Figs. 100a and 100b, a current collecting system is used in the form of densely distributed narrow contacts 4a in the dielectric 4 and narrow current collecting metallized buses 5ac which combine N electrodes 5a of the front side into a single current node and are spaced apart at intervals or in increments of F $\leq$2f (where f is the NeCC diffusion length).

Under the buses forming the shading domains, no MCC generation or, considering a small edge diffraction, insignificant generation takes place, Thereby, at the borders of shading the converter 1 bulk with non-transparent (metal) electrode Sac, a high longitudinal charge concentration gradient is artificially created so that a direct-axis component of diffusion current emerges.

Therefore, X-axis direct component is added to Y-axis quadrature component of diffusion current. As a result, the total diffusion current is summed up so that a substantial increase in the PEC power and efficiency is achieved according to the present embodiment.

A system of shading domains not only creates a direct-axis component of current but also beneficially influences the converter internal resistance practically not affecting the total shading area.

In practice, in order to achieve a substantial improvement in the PEC efficiency without increasing the shading area so that its value remains as in the prior art, the following is done. For example, the 200-micron buses of the conventional converter spaced apart in increments of F are divided widthwise into m narrow buses spaced apart in increments of F/m comparable to the MCC diffusion length.

In case of continuous converters shown in Figs. 100a and 100b, this simple PEC optimization technique remove restrictions as to thickness and doping extent of the "dead" layer 2 and, hence, it may by infinitely thin since the charge carriers are collected substantially in the contact domain under metallization so that the lateral component of current flowing over the layer 2 reduces 1/m times.

The described technique is used not only in case of the converter illustrated in Figs. 100a-100b but practically in all exemplary PEC shown in Figs. 1-100, especially in the configurations where the distance between the collecting electrodes 2 and metallization is comparable to the NeCC diffusion length.

Example 7. Flat batteries and modules based on
bunched converters

Hexagonal configurations of cells and PEC arrangement
in battery

According to the prior art, the converter elemental cells are arranged on the silicon wafers in the form of complete cells with a circular configurations or so called pseudosquares, and then the complete cells are assembled into a flat battery or module or panel for further delivery to the user.

When complete SCs are formed on the semiconductor wafer, their losses due to cutting and subsequent arrangement and assembly in the battery are dependent on the configuration used for their arrangement. Therefore, it is proposed to arrange the inventive SC using an economically optimum and technically reasonable configuration as compared to the prior art, i.e. hexagonal or pseudohexagonal shape.

The prior art and CS configurations and arrangements proposed by the inventors will be analyzed now.

The occupation of a solar battery (SB) by solar cells (SC) is primarily dependent on the SC configurations. A maximum occupation of the SB (100%) is achieved using square (or rectangular) shape SC. However, such cells are formed on molten or ribbon polycrystalline silicon with a low efficiency of 9-12%. The SB based on single-crystalline silicon is with a high efficiency formed of the SC manufactured using a circular wafer; the following configurations are possible in this case with their respective positive (+) and negative (-) sides (Figs. 101-109 and Table 1):

1. Circle: minimum losses in silicon (+); low SB (-) area occupation with cells;

2. Square: maximum losses in silicon due to cutting-out (-); maximum battery occupation with cells (+);

3. Pseudosquare: maximum battery occupation with cells (+); losses due to cutting-out the SC from the wafer (-); gaps are left in the SB not occupied with the SC (-).

A combination of minimum silicon losses with maximum occupation is provided by the SC hexagonal shape:

4. Hexagon: minimum losses in silicon (+); maximum SC (+) battery occupation;

5. Pseudohexagon: minimum losses in silicon (+); maximum SC (+) battery occupation; gaps in the SB not occupied with the SC are less than in the pseudosquaree.

Figs. 101-109 show the solar cells arranged into a solar battery; Table 1 shows the estimate losses in the solar cell and solar battery area due to arranging the same into different configurations for the same SCs areas cut out from a wafer of 100 mm in diameter.

Fig. 101 shows a square. Fig. 102 shows a pseudosquare. Fig. 103 shows a hexagon. Fig. 104 shows a pseudohexagon. Fig. 105 shows a circular configuration of SC. Fig. 106 shows a pseudosquare configuration of SC. Fig. 107 shows a hexagonal configuration of SC. Fig. 108 shows a pseudohexagonal configuration af SC.

The solar battery occupation with solar cells (SC) is dependent on the SC configuration. The losses in the wafer area due to cutting out are shown in Table 1 and Fig. 109 wherein the geometrical losses are presented as a function of the area of solar cells with various configurations. Fig. 109 shows the losses in the wafer area due to cutting out of a pseudasquare - Si sq, pseudohexagon - Si hex; losses in the wafer surface area due to pseudosquare configuration - SCsq, pseudohexagonal configuration - SChex. As shown in this Figure, optimums losses for pseudoshapes are achieved at the intersection of curves Si - SB.

Example 8. Multistage batteries and modules base on transmission-type converters,

The use of ultrafine wafers allows the losses due to the bulk recombination to be reduced. However, not all incident energy is absorbed in this case, especially in the domains close to the semiconductor forbidden band width whereby the converter sensitivity in these domains is impaired. This can be avoided using a multistage arrangement of the so called transmission-type converters.

A transmission-type converter comprises any of the above discussed types of the inventive converters based on thin semiconducting wafers intended for a particular absorption maximum. A multistage converter is designed in such a way that at first the short-wavelength spectrum is absorbed and converted below the semiconductor forbidden band width and in each of the successive stages a longer wavelength spectrum.

In addition to providing the converting properties, each of the previous cells in such system comprises an optical filter for the next cell.

In the conventional multistage converters, a series connection of cells with different forbidden band widths is used, said cells having a common load resistance. With such arrangement, in order to modulate the conductivity of each of the cells of the stage, the total radiation spectrum is needed for which the stage is designed otherwise a high internal resistance of any of the non-modulated cells will increase the internal resistance of the entire stage so that its current will be limited.

This disadvantage is eliminated in the battery according to the invention. Unlikely the conventional multistage converters, the inventive batteries are manufactured by just mechanically laying-up the transmission-type converters into a plane-parallel stack. At the same time, the inventive battery or module and its assembly with a series connection of cells provides for the operation of each of the cells at its own load resistance $R_H$ (Fig. 109a). If, for example, no long-wavelength spectrum is available and the cell Eg 3 is inoperative, the potential at the resistance Rh 3 becomes close to zero and the currents in the external circuit is defined by the resistances Rh 2 and Rh 1. Besides, such approach allows the load resistances for each of the stages to be balanced.

In the event of a series connection of n identical sources with the EMF $E_1$ and the internal resistance $r_1$, the battery E EMF and its internal resistance r is n times more than that of the single source:

$$E = n \cdot E_1, \ r = n \cdot r_1.$$

In the event of a parallel connection of m identical sources with the EMF $E_1$ and the internal resistance $r_1$, the battery E EMF is equal to the single source EMF, the battery current I is n times more than that of the single source $I_1$ and its internal resistance r is n times less than that of the single source:

$$E = E_1, \ r = r_1/m.$$

Therefore, the stage cells are preferably combined in parallel from the viewpoint of reducing the battery internal resistance. However, even in case of a valid modulation of each the cells, the EMF in such pattern will be defined by the EMF of the least forbidden bandwidth cell, i.e., Eg 3. For this reason, the cells in such pattern should be voltage balanced by connecting the same in parallel into sections.

Cell areas and their number are selected in such a way that the voltages at each of the sections, defined not only by the forbidden bandwidth of the semiconductor in use but also by the incident radiation level, are equalized.

In the event of a parallel-series connection of identical current sources into a battery (Fig. 109b) consisting of m parallel sections in each of which n sources are connected in parallel, the battery E EMF and its internal resistance are determined by the formulas:

$$E = n \cdot E_1, \ r = r_1 \cdot n/m.$$

Besides, if any of the spectrum components is absent, the entire stage will be shunted by such section. Therefore, the sections are connected to the common circuit through the forward-biased diodes.

With such connection of cells, the proposed battery becomes insensitive to the composition of the incident radiation spectrum, and a parallel-series connection of the current sources allows a source with the required EMF and internal resistance to be obtained in this circuit. Apart from the technical benefic, the multistage battery and the use of thin semiconductor wafers makes it possible to achieve a substantial economic benefit at the expense of saving the substrate material of up to by an order of magnitude.

Figs. 119, 110-113, 114-116 and Tables 2-3 show the experimental evidence in support of the achieved technical effect of the invention.

As seen in Fig. 119, the PEC according to the invention are able to operate in a wide range of the incident EMR, from the IR to UV and upper. The conventional prior art devices are only able to operate in a wide range of 0.4 to 1,2 $\mu$m.

Components of the p-n junction total resistance Rp: active resistance R, capacitance C, and inductance L are materials structure-sensitive characteristics, therefore they are manifested stochastically (probabilistically). Since R, C, L are all stochastic values, any changes thereof in the material may be only detected by stochastic methods. Accordingly, the inventors used statistical approaches in order to prove the attainability of the technical effect. Each converter in the proposed invention in fact consists of a statistical sample of N cells representing p-n junctions.

Fig. 110 shows the experimental statistical measurement data showing the internal resistance R of the p-n junctions in the converters with silicon-based diode arrangements at the operating measuring frequency of f = 1 kHz. For reliability, fidelity and reproducibility of the experimental results, p-n junctions statistical samples consisting of at least 100 converter specimens were measured by the procedure previously proposed by one of the present inventors in (Kartashov E.M., Tsoi B., Shevelev V.V., The Structural and Statistical Kinetics of Polymer Destruction, Moscow, Khimia Publishers, 2002, 736 p.; Tsoi B., Kartashov E.M. and Shevelev V.V., THE STATISTICAL NATURE AND LIFETIME IN POLYMERS AND FIBERS, Utrecht-Boston, Brill Academic Publishers/VSP, 2004, 522 p.). Based on the measurement data of R, distribution curves in the form of integral functions of the distribution (or variational diagrams, which is the same) of these values by the numbers of sequence m were plotted according to the procedure described in detail in said works.

In Fig. 110 the following legend is used: 23 - distribution of the p-n junctions resistance values by the numbers of sequence m, plotted from the measurement data of a statistical sample of 100 identical specimens of silicon-based converters with one p-n junction N = 1, each having the surface area S of 300 sq. $\mu$m; 24 - distribution of the p-n junctions resistance values by the numbers of sequence m, plotted from the measurement data of a statistical sample of 100 identical specimens of silicon-based converters with 100 p-n junction N = 100, each having the surface area S of 300 sq. $\mu$m; 25 - distribution of the p-n junctions resistance values by the numbers of sequence m, plotted from the measurement data of a statistical sample of 100 identical specimens of silicon-based converters with one p-n junction N = 1, each having the surface area S of 30 sq. $\mu$m; 26 - distribution of the p-n junctions resistance values by the numbers of sequence m, plotted from the measurement data of a statistical sample of 100 identical specimens of silicon-based converters with 100 p-n junction N = 100, each having the surface area S of 30 sq. $\mu$m.

It can be seen in Fig, 100 that depending on the area S of the p-n junctions their internal resistance R has a different spread in experimental values. In the statistical sample of the large-size (S = 300 sq. μm) p-n junctions, the spread in resistance values R is substantially less (curve 23) than in the sample of the small-size (S = 30 sq. μm) p-n junctions (curve 25). The small-size p-n junctions give an enormous spread and dispersion on resistance values. In the statistical sample of the large (bulky) p-n junctions, no small resistance values, for example, close to zero are observed at all as they are just absent in this statistical sample. In the sample with the small-size p-n junctions, a large number of junctions with low resistance values close to zero are observed. In quantitative terms, the spread in resistance values for the small-size junctions is in the range of 0 to 0.2 Ohm and in a sample of the large-size p-n junctions the spread is in the range of 0.05 to 0.15 Ohm.

If a statistical sample of 100 specimens with N = 1 p-n junctions in each specimen is taken as shown by the curve 23 (for bulky junctions with S = 300 sq. μm) and these are combined into a single current node (bunch) by a parallel connection (such combination bunched converter will then have N = 100 p-n junctions coupled in into a single current node using a common electrode), according to the shunt law the total resistance of such bunch will have a value less than the least value (the least value in this statistical sample is 0.05 Ohm). When plotting an integral distribution curve for 100 of such identical bunches (converters) consisting of N =100 p-n junctions, all points will be aligned (curve 24) and practically no spread is observed in this case.

And now, if a statistical sample of 100 specimens with N = 1 p-n junctions in each specimen as shown by the curve 25 (for the junctions of a smaller size, i.e., S = 30 sq. μm) is combined by connecting in parallel into a single current node (bunch), (as in the previous case, such combination bunched converter will have N = 100 p-n junctions coupled into a single current node using a common electrode), according to the shunt law the total resistance of such bunch will also have a value less than the least value ((the least value in this statistical sample is 0.0 Ohm).). In other words, if the p-n junctions are of small sizes and in great numbers (for reliability at least N = 100), the converter's total internal resistance will be equal to zero. When plotting an integral distribution curves for 100 of such identical converters consisting of N = 100 p-n junctions, all points will be aligned with the zero point (curve 26). No experimental spread is observed in this case so that a converter with high-accuracy electrical parameters is obtained in this embodiment.

In both cases, after combining into a bunch (a parallel circuit with a single current node) the experimental spread is completely eliminated, the total resistance catastrophically drops to become stable and maintains at a constant level throughout the range of measurement values (see curves 25 and 26). At the same time, as shown in curves 23-26, the total resistance becomes less than the least value. However, in a statistical sample with the small-size p-n junctions, the total resistance is substantially less than in a sample with the large-size p-n junctions and reaches zero value therein. In general, the less the p-n junction size and the more the numeric value of N, the more the reduction on the total resistance and the more the value of the converter's generated current and power.

Therefore, it follows from the data shown in Fig. 110 that in the manufacture of the semiconductor converter according to the invention the p-n junctions are preferably made of substantially small sizes, single-type and identical while N should be large enough (ideally it should tend to an infinitesimally large value). At the same time, for achieving better the effect of the resistance reduction in the converters, semiconductor substrates with a thickness of less than 70 μm are preferably used.

In general, the obtained experimental statistical measurement data for the bunched converters (converters with a large number of junctions whose resistances are combined into a single current node) prove demonstratively the attainability of the technical effect according to the proposed invention. Furthermore, the inventors performed (in various operating frequency ranges) similar experimental statistical analysis of capacitance C, inductance L and quality factor Q of the single-junction and bunched converters.

The obtained experimental data prove the attainability of the technical effect according to the proposed invention and the feasibility of the converters according to the invention. Some this data is presented in Table 2.

Table 2 shows the value of R, C, L, Q for the converters with N = 4, 10 and 1000 of separate single-type p-n junctions at f = 1 kHz and 1 MHz.

In general, the experimental results show that in the statistical samples of N p-n junctions (i.e., bunched converters), the experimental spread is completely eliminated and the electrical parameters become stable and highly accurate. At the same time, a decrease in the values of not only resistance R but also inductances L and capacitances C (Fig. 110 and Table 2) of the converters is observed. A reduction in capacitance is due to the fact that as a result of a reduction in resistance a stray charge runs away to the external circuit rather than accumulating at the junction contacts. The mechanism of reducing inductance is similar to that of reducing resistance in the parallel circuit. At the same time, a reduction in the values of R, C, L leads to a substantial increase in the converter's quality factor Q.

Furthermore, if N and operating frequency f are simultaneously increased, the values of internal resistance R, capacitance C, inductance L become more stable and the reduction effect is enhanced. It should be also noted that the stability of electrical parameter values is also observed in the event of a temperature change (in the event both of a temperature drop to low values and increase to high values). Measurements were performed in the range of 173°K to 573°K.

Similar results were obtained for the inventive PEC manufactured industrially according to a conventional semiconductor technology.

A number of exemplary converters were manufactured. In the manufacture of the converter according to the embodiment of Figs.71-72, the size of p-n junctions was localized to 500 $\mu$m x 500 micron and N = 256 p-n junctions were arranged into a elemental cell of 8000 $\mu$m x 8000 $\mu$m. The first electrode in such converter extends along the perimeter of the p-n junctions which are combined into a single current node by means of sparse current conducting collecting buses. The second electrode is made continuous.

In the converters manufactured according to the embodiment of Fig. 6, the p-n junctions were localized still more. At the same time, 10 $\mu$m x 10 $\mu$m discrete p-n junctions with a cruciform configuration were used. The converter had an elemental cell of 24 mm x 22 mm with up to N = 100 000 p-n junctions disposed therein. The first electrode in this converter is made in the form of crosses under which discrete p-n junctions are arranged, combined in to a bunch, i.e., a single current node by the first electrode and the current collecting bus. The second electrode is made continuous. A comparison was made of PEC according to the invention to the control PEC with a continuous p-n junction, continuous front side (without continuity break-off) and conventional antireflection coatings from tantalum oxide. Short-circuit current and open-circuit voltage was measured in order to calculate maximum values of the converter power. Fig. 111 shows a typical current-voltage characteristic for the control and inventive converters in the red light. As shown, the upper curve 28 represents the inventive PEC and the lower curve 27 represents the control PEC.

As can been seen in Table 3 and Fig.111, the PEC according to the invention has a substantially higher short-circuit current and open-circuit voltage throughout the tested EMR range than the control PEC. At the same time, the converters according to the invention have a substantially extended range of convertible EMR frequencies. For example, in contrast to the inventive converters, the control PECs with one continuous p-n junction generate no EMR in the domains EMR below 220 nm (ultraviolet band) and above 1000 nm (infrared band). Therefore, the bunched discrete diffusion converters according to the invention can operate both in the conventional visible EMR band and in upper and lower bands.

In general, as seen in Table 3, in various EMR frequency bands, especially in the ultraviolet part, as a result of localizing the EMR conversion process by reducing the sizes of p-n junctions to 500 $\mu$m x 500 $\mu$m (in the arrangement of Fig. 71-72) and increasing N and the concentration of p-n junctions, the electrical parameters: open-circuit voltage, short-circuit current and power increase by an order of magnitude and more as compared to the conventional PEC with continuous p-n junctions. The converters with such design wherein the electrodes are arranged along the perimeter of the p-n junctions, generate photocurrent both in the visible band (from 1000 nm to 220 nm) and invisible band above the ultraviolet part of the EMR spectrum, i.e., in the x-ray and IR regions. As seen in Table, the technical characteristics of the control converters are substantially inferior in all tested ERM frequency bands. Fig. 112 shows the solar radiation spectrum AMO 0 (curve 29) and reduced spectral characteristics of the manufactured converters: 30 - for the control PEC with a continuous front side; 31 - for bunched diffusion converters according to the invention; 32 - for bunched diffusion-drift converters according to the invention. It can be seen that the PEC according to the invention are sensitive both in the visible and invisible light region, i.e., UV and IR domains of the solar radiation. At the same time, the diffusion-drift converters according to the invention have a still higher spectral sensitivity than the diffusion converters.

Furthermore, as seen in Table 3, the converters according to the invention are able to operate in the event of a temperature change of up to 573°K and higher. The short-circuit currents and open-circuit voltage measured in the converter according to the invention under exposure to the EMR and elevated temperature of up to 573°K and higher proved to maintain their value and stability. In the control specimens with continuous collecting domains and a single large continuous junction, the values of currents and voltages under these temperature drop to zero. It should be noted that according to the experimental data, the inventive converters generate photocurrent not only at frequencies below the intermediate IR band but also in the x-ray band and up to gamma range.

In support of the attainability of the claimed technical effects, specimens of bunched converters with quadrature-axis and direct-axis diffusive components of current were also manufactured. Specimens of PECs according to the embodiment of Figs. 3-4 (Example 1) and Figs. 100a, 100b (Example 6), as well as conventional control PECs with a continuous p-n junction were manufactured.

The measurement data for these PEC are illustrated in Fig. 113 showing short-circuit current Isc as a function of the control (curve 33) and experimental specimens (curves 34-36): 33 - exemplary conventional control specimen with a continuous p-n junction, a current collecting bus of 200 $\mu$m in width, a distance between current-collecting buses of 2000 $\mu$m and metallization shading coefficient of 8.4%; 34 - specimen with a continuous current collecting layer according to the embodiment of Fig. 100a and 100b with current collecting buses of 18 $\mu$m in width, a distance between current- collecting buses of 200 $\mu$m and metallization shading coefficient of 8.2%; 35 - specimen with cross-shaped current collecting layers 2 according to the embodiment of Fig. 3 completely covered by metallization as shown in Fig. 4 with current collecting buses of 18 $\mu$m in width, a distance between current-collecting buses of 200 $\mu$m and metallization shading coefficient of 18.0%; 36 - embodiment of Fig. 3 with partially exposed discrete cross-shaped cells. The shading coefficient amounts to 8.2%.

The area ratio of the collecting layers in the embodiments illustrated by the curves 33-34 and the embodiments illustrated by the curves 35-36 is 1 to 10.

The curve 33 in Fig. 113 demonstrates the short-circuit current saturation at 60 mA for the continuous specimen at the expense of a high internal resistance of the "dead" layer 2: minority carriers having formed within the converter bulk below the "dead" layer move towards this layer, are collected by the same and move further along this layer towards the electrode 5ac.

Given the concentration gradient dn/dy, the quadrature-axis component of diffusion current has density $j_Y$:

$$ j_Y = qD \; (dn/dy), $$

where q is an electron charge and D is a diffusion factor.

With the emergence of the concentration gradient dn/dx direct-axis component associated with the shading zones, direct-axis component of current emerges:

$$ J_X = qD \; (dn/dx), $$

and due to an abrupt concentration gradient, i.e., when (dn/dx) > (dn/dy), the density of the direct-axis component of current is more than the density of the quadrature-axis component: $j_X > j_Y$. The total current density is $j = j_X + j_Y$.

This is demonstrated by the curve showing short-circuit current as a function of the luminous flux intensity (curve 33), which lies along the current axis far below the curves 34-36.

It is also explained by that a high percentage of the forked NeCC recombines within the bulk not reaching the current collecting layer 2. If the distances between the electrodes are commensurable to the NeCC diffusion lengths, the carriers corresponding to the quadrature-axis component of diffusion current freely reach the current collecting electrodes so that the curves 34-36 lie along the current axis substantially higher.

The curves 34-36 demonstrate the effect of the direct-axis component of diffusion current, which in contrast to the quadrature-axis component of diffusion short-circuit current is not proportionate to the p-n junction area. As seen in Fig.113, the curves 34-36 defining the effect of the direct-axis component of diffusion current are plotted substantially higher along the current axis.

Therefore, the harmful action of saturation current Is is reduced, which is proportionate to the junction area, directed oppositely to photocurrent and reduces total current $I = I_\Phi$ - Is. This longitudinal current effect is also beneficial to the temperature dependencies of the converters 35 whose areas of p-n junctions are small against those of the converters 33-34: a drop in the open-circuit voltage when they get hot is substantially less than in the converters with continuous junctions, Therefore, the experimental results show that to achieve a maximum current collection effect it is required to create artificially a system of bulk-surface heterogeneities (SBSH) comprising in the general case not only alternating n⁺ and p⁺ domains but also a system of shaded areas on the PEC front side increasing the charge carrier concentration gradient. In general, the analysis of PEC manufactured according to Figs. 3-4, as well as Figs, 100a-100b shows that under exposure to a radiation quanta NeCC are formed everywhere throughout the substrate whether it be in the n-layer or p-layer. Therefore, a charge concentration gradient has to be created; charges have to be separated with the field of N (built-in) discrete p-n junctions and efficiently collected by the appropriate strip-grid electrode arrangement to ensure creation of the current node with the p-n junction resistances.

Legend in Figs, 114-116: Curve 37 - discrete bunched converter with an optimized size of junctions of 4 $\mu$m x 4 $\mu$m; reflection index: 45%; Curve 38 - high-performance converter with a continuous junction available from Sun Power; reflection index: 1- 2%; Curve 39 - high-performance converter with a continuous junction for in-space applications; reflection index: 8%.

Figs, 114-116 show the p-n junctions and first conductivity type domains whose size was optimized to 4 $\mu$m x 4 $\mu$m in section. Specimens were manufactured from single-crystalline electronic silicon under large-scale production conditions. For comparison, high-perfonnance solar cells by Sun Power and conventional cells for in-space application were tested. The following incident radiation absorption factor was obtained: SP-mono - 98%, Space - 92%, bunched cells according to the invention - 55%. The internal conversion factor of the cells was measure depending on the incident radiation power.

As can be seen, the internal conversion factor of all cells reduces as the incident power increases. The maximum reduction was observed in the high-performance continuous converters: from 15-20% (under normal conditions) to 3-5%. This reduction was nor so catastrophic in the bunched discrete cells: from 40% to 23%. A high internal conversion factor of the bunched cells according to the invention proves their high efficiency as compared to the prior art converters.

As can be seen in Figs. 115 - 116, the bunched discrete converters also exhibit a high efficiency when simultaneously exposed to the temperature and intensity of the luminous flux, When the incident power amounts to 3000 W/m² and the measured temperature is 70-80°C, the energy output of a discrete solar cell produces is over 800 W (curve 37), and the energy output of the high-performance Sun Power cells and cells for in-space applications is respectively four and two time less (see the curves 38 and 39 in Fig.116). Note that these result were obtained without an antireflection coating, It is anticipated that these values will be improved twice it reflection is eliminated in the discrete cells.

When a SSBH is created by a further localization of the p-n junctions and increase in N and concentration of junctions, as well as alternation of the $n^+$ И $P^+$ domains on the converter front side, a surprising phenomenon is manifested: a stepwise increase in potential. In Table 3 data is presented showing that the SSBH converter specimens with localized N = 100,000 discrete p-n junctions generate 7 V. It is by an order of magnitude greater than the value for silicon, which is justified in theory and practically obtained in the prior art. At the same time, they generate potential in the invisible band, i.e. intermediate IR (5,000 nm) and both visible and invisible UV range (220-300 nm). The potential for a conventional continuous converter with one junction N = 1 under these conditions and at IR and UV frequencies is equal to zero. These results prove the validity of the conclusions made above and the attainability of the technical effect in the present invention.

Finally, it should be noted that the above given examples were presented only for a better understanding the essence of the invention, as well as its benefits and by no means encompass all particular embodiments thereof. In view of the foregoing, it will be apparent to a person skilled in the semiconductor engineering that other specific embodiments are possible, in particular characterized by, for example, the materials used for the substrate, current conducting paths, etc., other than those expressly mentioned in the disclosure but well known and used in the relevant art for similar purposes, and also characterized by the number of p-n junctions not expressly mentioned in the disclosure but uniquely following from the essence of the invention. Or else, for example, the approaches uses herein may be used for manufacturing other semiconductor devices with a diode arrangement: diodes, photodiodes, light-emitting diodes, transistors, phototransistors, thyristors, semiconductor lasers and others. In addition to the embodiments discussed herein, the methods for improving efficiency mentioned in the disclosure may be used, such as creating various textures on the sensitive surface and a number of other methods, differing from those discussed and mentioned herein, for manufacturing both the converter as a whole and its separate elements,. Other particular embodiments of the invention may also be stipulated which are within the scope of protection being sought for and defined by the attached claims.

INDUSTRIAL APPLICABILITY

The inventive converters may be manufactured using a conventional semiconductor technology and conventional semiconductor substrate materials, and the assembly of converters into batteries (modules) may be accomplished by a skilled person based on the information provided herein. The inventive converters and batteries may be efficiently used in power engineering and other industrial fields, in particular as a source of electromotive force.

**Claims**

1. An electromagnetic radiation converter comprising a semiconductor substrate on the front side of which N ≥ 1 discrete local first conductivity type domains are formed, said substrate having a second conductivity type so that said first conductivity type domains form together with said substrate N > 1 p-n junctions combined into a current node, **characterized in that** isotype junctions are formed outside the first conductivity type domains on the front side of said substrate to create repulsive isotype barriers to the minority charge carriers

2. The electromagnetic radiation converter according to claim 1, **characterized in that** at least a part of the substrate front side is textured.

3. The electromagnetic radiation converter according to any of claims 1-2, **characterized in that** an antireflection layer is applied onto the substrate front side.

4. The converter according to any of claims 1-3, **characterized in that** local centers for absorbing the electromagnetic radiation and injecting the non-equilibrium charge carriers are embedded into the substrate to create concentration gradients of the non-equilibrium charge carriers.

5. The converter according to any of claims 1-4, **characterized in that** doped depressed isotype deflecting domains are formed on the substrate front side outside the first conductivity type domains to create a concentration gradient of the non-equilibrium charge carriers relative to the second conductivity type domain or domains.

6. The converter according to any of claims 1-5, **characterized in that** the first conductivity type domains are spaced apart at intervals commensurable to the diffusion length of the non-equilibrium charge carriers.

7. The converter according to any of claims 1-6, **characterized in that** the rear substrate side comprises second conductivity type doped depressed discrete collecting domains forming together with the substrate material local isotype junctions combined into a rear side opposite current node by means of local contacts and a rear side conducting electrode.

8. The converter according to any of claims 1-7, **characterized in that** the substrate c fear side comprises N > 1 first conductivity type discrete local collecting domains and N discrete p-n junctions combined into a second rear side current node by means of a second current collecting electrode.

9. The converter according to any of claims1-8, **characterized in that** on the substrate front side a dielectric layer is provided with windows at least in the areas ofN first conductivity type discrete local domains to ensure contact of the first electrode to said domains.

10. The converter according to any of claims 1-10, **characterized in that** N > 1, said N first conductivity type domains on the substrate front side being separate and single-type and form N separate and single-type p-n junctions.

11. The converter according to any of claims 1-10, **characterized in that** N = 1.

12. The converter according to claim 11, **characterized in that** the first conductivity type domain on the substrate front side comprises $K \geq 1$, where K is an integer number of the first conductivity type areas connected to each other by means of $M \geq 1$ first conductivity type connection elements.

13. The converter according to claim 12, **characterized in that** M = 1, i.e., said first conductivity type domain comprises one first conductivity type doped connection element in the form of one continuous rectangular strip.

14. The converter according to claim 12, **characterized in that** said first conductivity type domain comprises M > 1 first conductivity type doped connection parts in the form of separate single-type thin rectangular strips.

15. The converter according to claim 12, **characterized in that** said first conductivity type domain comprises M > 1 first conductivity type doped connection areas arranged to form a grid.

16. The converter according to any of claims 1-15, **characterized in that** the p-n junctions with the collecting domains adjacent thereto are brought out onto the lateral and front surfaces of the front side.

17. The converter according to any of claims 1-16, **characterized in that** a second conductivity type doped layer is disposed under each ofN first conductivity type domains on the substrate front side.

18. The converter according to any of claims 1-17, **characterized in that** a stack of G > 1l successively alternating second conductivity type И first conductivity type layers is disposed under each of said first conductivity type domains on the substrate front side.

19. The converter according to claim 18, **characterized in that** the first and second conductivity type domains in said stack are switched (connected) in series or in parallel.

20. The converter according to claim 19, **characterized in that** the collecting domains c conductivity of one conductivity type are connected by means of the doped connection elements of the same conductivity type.

21. The converter according to claim 20, **characterized in that** at least a part of said connection elements form closed circuits.

22. The converter according to any of claims 20-21, **characterized in that** all said connection elements form closed circuits.

23. The converter according to any of claims 1-22, **characterized in that** $X \geq 1$ additional doped deflecting domains are disposed on the substrate front side separately from said N first conductivity type collecting domains.

24. The converter according to claim 23, **characterized in that** each of said X doped deflecting domains has the second conductivity type.

25. The converter according to claim 23, **characterized in that** X deflecting domains include the domains both of the first and the second conductivity types.

26. The converter according to claim 23, **characterized in that** each of said X doped deflecting domains has the first conductivity type.

27. The converter according to any of claims 23-26, **characterized in that** said doped deflecting domains are discrete.

28. The converter according to any of claims 23-27, **characterized in that** at least a part of the doped deflecting domains of one conductivity type are combined into circuits by means of the connection areas of the same conductivity type.

29. The converter according to any of claims 23-27, **characterized in that** said X doped deflecting domains are configured as a continuous closed circuit (ring or belt).

**30.** The converter according to claim 28, **characterized in that** at least one of N first conductivity type collecting domains on the substrate front side is disposed within the circuit formed by the deflecting domains.

**31.** The converter according to claim 29, **characterized in that** at least one of N collecting domains is disposed within said continuous closed circuit.

**32.** The converter according to any of claims 23-31, **characterized in that** N first conductivity type collecting doped domains on the substrate front side and the doped deflecting domains are disposed in the alternating discrete quantum trapping depressions spaced from each other at $F \leq 2f$, where f is a diffusion length of the non-equilibrium charge carriers, said traps being formed on the substrate front side of the first conductivity type collecting domains arranged in some depressions and the deflecting domains - in other depressions along the depressions of the first conductivity type at a distance of F from the nearest depression.

**33.** The converter according to claim 32, **characterized in that** it comprises an additional third (or second front side) current collecting electrode connected to each of said X second conductivity type doped deflecting domains.

**34.** The converter according to claim 32, **characterized in that** it comprises an additional third (or second front side) current collecting electrode connected to at least one of said X second conductivity type doped deflecting domains.

**35.** The converter according to claim 9, **characterized in that** at least one deflecting field electrode is disposed on top of the dielectric layer.

**36.** The converter according to claim 35, **characterized in that** $X \geq 1$ additional doped deflecting domains are disposed on the substrate front side separately from said N first conductivity type collecting domains.

**37.** The converter according to claim 36, **characterized in that** at least one deflecting field electrode is disposed on top of the dielectric layer in the area of at least one of said X doped deflecting domains.

**38.** The converter according to claim 35 or 37, **characterized in that** the first collecting electrode connected to each of N first conductivity type domains is expanded and overlaps in plan each of the separately taken said first conductivity type domain to which it is connected, said first electrode being connected to the deflecting field electrode so that a single expanded collecting-deflecting electrode is formed.

**39.** The converter according to claim 38, **characterized in that** said extended collecting-deflecting electrode is made from an optically transparent (or semitransparent) conducting material (for example, Si*, TCO, ITO).

**40.** The converter according to claim 38, **characterized in that** said extended collecting-deflecting field electrode is made from an optically transparent (or semitransparent) conducting material (for example, Si*, TCO, ITO) continuous throughout the front side.

**41.** The converter according to claim 38, **characterized in that** first electrode extends along the perimeter of each of N current collection domains on the front side.

**42.** The converter according to claim 41, **characterized in that** the deflecting domains extend along the perimeter of the first electrode.

**43.** The converter according to any of claims 39-40, **characterized in that** a third electrode (or a first drift electrode on the front side) generating a drift field on application of a bias potential is formed outside the collecting-deflecting electrode along its perimeter.

**44.** The converter according to claim 43, **characterized in that** the first conductivity type deflecting domains are disposed under the drift electrode.

**45.** The converter according to claim 43, **characterized in that** between the first and the drift electrodes a field drift electrode (second drift electrode on the front side) is formed, disposed above the second conductivity type deflecting domains,

**46.** The converter according to claim 45, **characterized in that** the second drift electrode on the front side is electrically connected to the substrate.

**47.** The converter according to claim 13, **characterized in that** $\underline{Y \geq 1}$ thin electrodes combined into a B current node are arranged on the front side, with the interval between the electrodes commensurable to the diffusion length of the non-equilibrium charge carriers.

**48.** The converter according to any of claims 1-47, **characterized in that** the first conductivity type domains on the front side and the second conductivity type domains on the front side are coated with microlenses or microprisms.

**49.** The converter according to any of claims 1-48, **characterized in that** the reverse side of the second conductivity type substrate comprises $W \geq 1$ separate second conductivity type deflecting-collecting doped domains combined into a current node by means of the continuous second electrode.

**50.** The converter according to claim 49, **characterized in that** said separate W ≥ 1 doped deflecting and collecting domains are single-type.

**51.** The converter according to claim 49, **characterized in that** the reverse side comprises V ≥ 1 first conductivity type doped deflecting and collecting domains each combined into a current node by a fourth electrode.

**52.** The converter according to claim 51, **characterized in that** the reverse side comprises additional first conductivity type discrete deflecting domains disposed around the periphery of the deflecting-collecting domains of the second and first conductivity types.

**53.** The converter according to claim 51, **characterized in that** the reverse side comprises the additional second conductivity type discrete deflecting domains disposed between said first conductivity type discrete deflecting domains.

**54.** The converter according to any of claims 1-53, **characterized in that** it is arranged on the semiconductor substrate of a thickness commensurable to or less than the diffusion length of the non-equilibrium charge carriers.

**55.** The converter according to any of claims 1-54, **characterized in that** Z domains with a source of the additional electromagnetic radiation, for example, strontium-90 are arranged on the front side or rear side of the semiconductor substrate,

**56.** A battery comprising J > 1, where J is an integer number of converters according to any of claims 1-55, having a outer edge of a polygonal shaped and connected to each other into a series and parallel electric circuit.

**57.** The battery according to claim 56, **characterized in that** the outer edge of the converters has a hexagonal configuration.

**58.** The battery comprising J > 1, where J is an integer number of converters according to any of claims 1-55, having an outer edge of a pseudohexagonal shape and connected to each other into a series and parallel electric circuit.

**59.** The battery comprising J > 1, where J is an integer number of thin transmission type converters according to any of claims 1-55, arranged in a stack И connected to each other into a series and parallel electric circuit, said converters being stacked such that the upper layer or stage converts the short-wave spectral range of the incident radiation, and each successive lower stage or layer in the stack converts a longer wave spectrum.

FIG  *1a.*

FIG . *1.*

FIG  *2.*

FIG *3.*

FIG *4.*

FIG *5.*

FIG 6.

FIG 7.

FIG 8.

FIG 9.

FIG. 10.

FIG 11.

FIG. *12.*

FIG. *13.*

FIG. *14.*

FIG. *15.*

FIG *16.*

FIG *17.*

FIG *18.*

FIG *19.*

FIG *20*

FIG *21.*

FIG **22.**

FIG **23.**

FIG **24.**

FIG 25.

FIG 26.

FIG 27.

FIG 28.

FIG *29.*

FIG *30.*

FIG *31.*

FIG **32.**

FIG **33.**

FIG.**34.**

FIG **:35.**

FiG .36.

FiG .37.

FiG 38.

EP 2 323 170 A1

FIG .39.

FIG . 40.

FIG 41.

48

FIG .*42.*

FIG _*43.*

FIG . *44.*

FIG **45.**

FIG **46.**

FIG **47.**

FIG **48.**

FIG **49.**

FIG **.50.**

FIG .51.

FIG . 52.

FIG .53.

FIG . 54.

FiG 55.

FiG 56.

FiG.57.

Fig 58.

53

FiG 59.

FiG 60.

FiG. 61.

FiG 62.

FiG 63.

FiG 64.

F.G 65.

FIG . 66.

FIG .67.

FIG . 68..

FiG 69.

FiG 70.

FiG 71.

FiG. 72

FIG 73.

FIG 74.

FIG 75.

FIG *76.*

FIG *77.*

FIG *78.*

FIG 79.

FIG 80.

FIG 81.

FIG.82.

FIG 83

FIG 84.

FIG. 85.

FIG 86.

FIG .87.

FIG 88.

FIG 89.

FIG 90.

FIG *91.*

FIG *92.*

FIG *93.*

FIG 94.

FIG 95.

FIG 96.

FIG *97.*

FIG *98.*

FIG *99.*

FIG.*100.*

FIG *100a.*

FIG *100b.*

FiG 101   FiG 102   FiG 103.   FiG 104.

FiG 105.

FiG 106.

FiG 107.

FiG 108.

%апотерь

вписанный в круг гекс

вписанный в круг квадрат

Si кв
СБкв
Si гкс
СБгкс

круг

5000   5500   6000   6500   7000   7500   8000

площадь СЭ в кв мкм

FiG 109.

EP 2 323 170 A1

FIG .109 a

FIG .109b.

69

FIG. 110.

FIG. 111.

I / Imax

FIG. 112

Isc , mA

FIG. 113

FIG. *114*

FIG. *115*

FIG. 116

FIG. 117

FIG .118

FIG .119

FIG .120.

## INTERNATIONAL SEARCH REPORT

| | International application No. |
| --- | --- |
| | PCT/RU 2008/000314 |

| A. | CLASSIFICATION OF SUBJECT MATTER |
| --- | --- |

H01L 31/04 (2009.01)

According to International Patent Classification (IPC) or to both national classification and IPC

| B. | FIELDS SEARCHED |
| --- | --- |

Minimum documentation searched (classification system followed by classification symbols)

Documentation searched other than minimum documentation to the extent that such documents are included in the fields searched
H01L 31/00, 31/04, 31/042, 31/06, 31/065, 31/068, 31/072, 31/078

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | RU 2006120073 A (TSOI BRONYA) 27.12.2007, the claims | 1-55 |
| A | RU 2005106097 A (TSOI BRONYA) 10.08.2006, the claims | 1-55 |
| A | RU 2003121615 A (FIZICHESKY INSTITUT IM. P.N. LEBEDEVA ROSSYSKOI AKADEMII NAUK) 10.01.2005, the claims | 1-55 |
| A | JP 605353531 A (SHARP KK) 25.02.1994, the abstract | 1-55 |
| A | RU 2087053 C1 (GOSUDARSTVENNOE NAUCHNO-PROIZVODSTVENNOE PREDPRIYATIE "KVANT") 10.08.1997, p. 4-7, fig. 4, 5, 7, 8 | 56-58 |
| A | US 4089705 A (THE UNITED STATES OF AMERICA AS REPRESENTED BY THE ADMINISTRATOR OF THE NATIONAL AERONAUTICS AND SPACE  ADMINISTRATION) 16.05.1978, fig. 3, fig. 5, col. 2, 3 | 56-58 |

./..

| ☒ Further documents are listed in the continuation of Box C. | ☐ See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 26 January 2009 (26.01.2009) | 05 February 2009 (05.02.2009) |
| Name and mailing address of the ISA/ RU | Authorized officer |
| Facsimile No. | Telephone No. |

Form PCT/ISA/210 (second sheet) (April 2005)

**INTERNATIONAL SEARCH REPORT**

| International application No. |
| --- |
| PCT/RU 2008/000314 |

C (Continuation).     DOCUMENTS CONSIDERED TO BE RELEVANT

| Category* | Citation of document, with indication, where appropriate, of the relevant passages | Relevant to claim No. |
| --- | --- | --- |
| A | RU 2127009 C1 (VSEROSSYSKY NAUCHNO-ISSLEDOVATELSKY INSTITUT ELEKTRIFIKATSII SELSKOGO KHOZYAISTVA) 27.02.1999, the abstract, fig. 1 | 59 |
| A | SU 288163 A (D.S. STREBKOV et al.) 05.11.1971, the claims | 59 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3206350 B
- RU 2139601 C1
- DE 10127382 A1
- US 6998288 B1
- RU 2273969
- RU 2284593

### Non-patent literature cited in the description

- **Alferov Zh.I. ; Andreev V.M. ; Rumyantsev V.D.** development Trends and Prospects of Solar Power Engineering. *Semiconductor Physics and Technology,* 2004, vol. 38 (8), 937-948
- **Meitin M.** *Photovoltaics: Materials, Technologies, Prospects // Electronics: Science, Technology, Business,* 2000, 40-46
- **Konstantinov P.B. ; Kontsevoy Yu.A. ; Maksimov Yu.A.** Silicon Solar Cells. MIREA Publishers, 2005, 70
- **Meitin M.** *Phatovoltaics; Materials, Technologies, Prospects // Electronics: Science, Technology, Business,* 2000, 40-46
- **Reivi K.** Defects and Dopants in Semiconducting Silicon. Mir Publishers, 1984, 470
- **Zaveryuikhin B.N. ; Zaveryuikhina N.N. ; Tursunkulov O.M.** Changes in the Reflection Factor of Radiation from the Semiconductor Surface within the Spectral Range of $\lambda$ = 0.2-20 $\mu$m under the Influence of Ultrasonic Waves. *Letters to the Journal of Applied Physics,* 2002, vol. 28 (18), 1-12
- **Green M.A et al.** 25% Efficient Low-Resistivity Si Concentrator Solar Cells. *IEE Electron Device Letters,* 1986, 583-585
- **Goodrich J. ; Chaple-Sokol. ; Allendore G. ; Frank R.** The etched multiple vertical junction silicon photovoltaic cell. *Solar Cells,* 1982, vol. 6 (1), 87-101
- **Aberie A.G. ; Altermatt P.P. ; Heizer G ; Robinson S.J.** Limiting loss mechanisms in 23% efficient silicon solar cells. *J. Appl. Phys.,* 1995, vol. 77 (7), 3491
- **Alferov Zh.I ; Andreev V.M. ; Rumyantsev V.D.** development Trends and Prospects of Solar Power Engineering. *Semiconductor Physics and Technology,* 2004, vol. 38 (8), 937-948
- **Untila G.G. ; Kost T.N. ; Zaks M.B. et al.** A New Type of High-Performance Double-Sided Silicon Solar Cells with Front-Side buses and a Wire Grid. *Semiconductor Physics and Technology,* 2005, vol. 39 (11), 1393-1398
- **Meitin M.** *Photovoltaics: Materials, Technologies, Prospects // Electronics: Science, Technology, Business,* 2000, vol. 6, 40-46
- **Alferov Zh.I ; Andreev V.M. ; Rumyantsev V.D.** Development Trends and Prospects of Solar Power Engineering. *Semiconductor Physics and Technology,* 2004, vol. 38 (8), 937-948
- **Meitin M.** *Photovoltaics: Materials, Technologies, Prospects // Electronics: Science, Technology, Business,* 2000, vol. 6, 40-46
- **Kartashov E.M. ; Tsoi B. ; Shevelev V.V.** The Structural and Statistical Kinetics of Polymer Destruction. Khimia Publishers, 2002, 736
- **Tsoi B. ; Kartashov E.M. ; Shevelev V.V.** THE STATISTICAL NATURE AND LIFETIME IN POLYMERS AND FIBERS. Brill Academic Publishers/VSP, 2004, 522